(19) **Europäisches Patentamt European Patent Office Office européen des brevets**

(11) **EP 1 610 136 B1**

(12) **EUROPEAN PATENT SPECIFICATION**

(45) Date of publication and mention of the grant of the patent:
**11.07.2007 Bulletin 2007/28**

(21) Application number: **04724396.9**

(22) Date of filing: **30.03.2004**

(51) Int Cl.:
*G01R 31/3183* (2006.01)   *G06F 11/26* (2006.01)

(86) International application number:
**PCT/JP2004/004527**

(87) International publication number:
**WO 2004/090562 (21.10.2004 Gazette 2004/43)**

(54) **TEST EMULATOR**

TESTEMULATIONSEINRICHTUNG

DISPOSITIF D'EMULATION D'ESSAI

(84) Designated Contracting States:
**DE GB IT**

(30) Priority: **31.03.2003 US 403817**
**31.03.2003 US 404002**
**16.02.2004 WOPCT/JP2004/001648**
**16.02.2004 WOPCT/JP2004/001649**

(43) Date of publication of application:
**28.12.2005 Bulletin 2005/52**

(60) Divisional application:
**06077162.3 / 1 767 955**

(73) Proprietor: **ADVANTEST CORPORATION**
**Nerima-ku,**
**Tokyo 179-0071 (JP)**

(72) Inventors:
 • **HIGASHI, Shinsaku,**
 **c/o ADVANTEST CORPORATION**
 **Nerima-ku Tokyo 1790071 (JP)**
 • **ICHIYOSHI, Seiji,**
 **c/o ADVANTEST CORPORATION**
 **Nerima-ku Tokyo 1790071 (JP)**
 • **PRAMANICK, Ankan,**
 **c/o ADVANTEST CORPORATION**
 **Nerima-ku Tokyo 1790071 (JP)**
 • **ELSTON, Mark,**
 **c/o ADVANTEST CORPORATION**
 **Nerima-ku Tokyo 1790071 (JP)**
 • **CHEN, Leon,**
 **c/o ADVANTEST CORPORATION**
 **Nerima-ku Tokyo 1790071 (JP)**

 • **SAUER, Robert,**
 **c/o ADVANTEST CORPORATION**
 **Nerima-ku Tokyo 1790071 (JP)**
 • **KRISHNASWAMY, Ramachandran,**
 **c/o ADVANTEST CORP.**
 **Nerima-ku Tokyo 1790071 (JP)**
 • **SINGH, Harsanjeet,**
 **c/o ADVANTEST CORPORATION**
 **Nerima-ku Tokyo 1790071 (JP)**
 • **ADACHI, Toshiaki,**
 **ADVANTEST CORPORATION**
 **Nerima-ku Tokyo 1790071 (JP)**
 • **TAHARA, Yoshihumi,**
 **ADVANTEST CORPORATION**
 **Nerima-ku Tokyo 1790071 (JP)**

(74) Representative: **Pfenning, Meinig & Partner GbR**
**Patent- und Rechtsanwälte**
**Theresienhöhe 13**
**80339 München (DE)**

(56) References cited:
**JP-A- 6 160 482**      **US-A1- 2001 016 922**

 • **XIA J Q ET AL: "DYNAMIC TEST EMULATION FOR EDA-BASED MIXED-SIGNAL TEST DEVELOPMENT AUTOMATION" PROCEEDINGS OF THE INTERNATIONAL TEST CONFERENCE (ITC). WASHINGTON, OCT. 21 - 25, 1995, NEW YORK, IEEE, US, 21 October 1995 (1995-10-21), pages 761-770, XP000552879 ISBN: 0-7803-2992-9**

**Description**

BACKGROUND OF THE INVENTION

Field of the Invention

The present invention relates to a test emulator, a test module emulator, and a record medium storing program therein. More particularly, the present invention relates to a test emulator, a test module emulator, and a record medium storing program therein for emulating test apparatuses including a plurality of exchangeable test modules for supplying a test signal to DUTs respectively, and verifying a test environment without using real things such as a DUT or a test module.

Description of Related Art

Conventionally, technologies are disclosed in Japanese patent application publications No. 10-320229, No. 2000-267881, No. 2001-51025, No:2001-134457, and No. 2002-333469, as means for verifying test environment without using real things such as a DUT or a test apparatus.
The Japanese patent application publications No. 10-320229 discloses: each emulator unit for emulating function of each hardware unit of a semiconductor test apparatus; a device emulator for emulating function of DUT; means for collecting data required for execution of a test program from each of the emulator units based on a test program; and an emulator including a device test emulator for generating a test signal in a device emulator based on the collected data, comparing result signals from the device emulator, and storing the result therein.
The Japanese patent application publication No.2000-267881 discloses a semiconductor simulating apparatus for accurately simulating voltage and current which change depending on internal resistance of the DUT.
The Japanese patent application publications No.2001-51025 discloses a program debugging apparatus for a semiconductor test including: tester emulation means for emulating operation of the semiconductor test apparatus; hardware description language simulating means for simulating the DUT based on the hardware description language; and debugging means for debugging the program for the semiconductor test based on the simulating result of the DUT.
The Japanese patent application publications No. 2001-134457 discloses a program debugging apparatus for a semiconductor test for composing data points corresponding to each pin at high speed when emulating operation of the semiconductor test apparatus.
The Japanese patent application publications No. 2002-333469 discloses a program debugging apparatus for a semiconductor test for verifying program for the semiconductor test being composed for a semiconductor device including an analogue output terminal.
XIA J Q ET AL: "DYNAMIC TEST EMULATION FOR EDA-BASED MIXED-SIGNAL TEST DEVELOPMENT AUTOMATION" PROCEEDINGS OF THE INTERNATIONAL TEST CONFERENCE (ITC). WASHINGTON, OCT. 21 - 25,1995, NEW YORK, IEEE, US, 21 October 1995, pages 761-770, ISBN: 0-7803-2992-9, discloses the analysis and development of an Electronic Design Automation (EDA)-based Test Development Automation (TDA) system. to debug a test design and emulate an associated test program simultaneously in the TDA system, mixed-signal simulation is performed on test schematics. A communication channel is established between the test system program emulator and the CAE mixed-signal simulation environment. By modelling the test environment and the DUT, the mixed-signal simulation engine acts as a virtual tester. When a test program executes and is emulated, it sets up the virtual instruments (models) based on the event records generated from the test system program emulator. It sources the test patterns and waveforms, measures the device responses by running simulations on test design schematics, and sends the simulation results back to the test system program emulator for post-processing.

SUMMARY OF THE INVENTION

It is premised that the emulators of the test apparatuses described above are used for the test apparatus having a proprietary architecture basically developed by a test apparatus vendor. On the other hand, in test apparatuses in the future, a method for constructing the test apparatus by combining modules developed by various vendors, which is realized by an open architecture, is expected. Therefore, It is desirable to offer an emulator for appropriately emulating the test apparatus constructed by the various modules.
Therefore, it is an object of the present invention to provide a test emulator and a record medium storing program therein which can solve the foregoing problem. The above and other objects can be achieved by combinations described in the independent claims. The dependent claims define further advantageous and exemplary combinations of the present invention.
Therefore, according to the first aspect of the present invention, there is provided a test emulator for emulating a test apparatus including a plurality of test modules for supplying a test signal to devices under test respectively. The test emulator includes: a plurality of test module emulation sections for emulating the plurality of test modules generating the test signal based on different cycles; a control emulation section for emulating a control apparatus for controlling the test of the devices under test; a synchronous emulation section for generating test signal generating timings, at which each of the plurality of test module emulation sections is to generate the test signal in simulation corresponding to cycle time of the test module emulation section, based on instructions from the control emulation section; a timing alignment section for aligning the plurality of test signal generating timings generated by the synchronous emulation section in order of time, and outputting them one by one; and a schedule section for causing the test module emulation section corresponding to one of the test signal generating timings output by the timing alignment section to generate the test signal in simulation in the cycle time corresponding to the test signal generating timing.

The test emulator may further include a device under test simulating section for simulating operation of a device under test based on the test signal generated in simulation.

The synchronous emulation section may further generate interruption collection timings for collecting interruption to the control apparatus generated in simulation by each of the plurality of test module emulation sections during the generation of the test signal in the cycle time corresponding to the test signal generating timings, the timing alignment section may align the plurality of test signal generating timings and the plurality of interruption collection timings in order of time, and outputs them one by one, and the schedule section may cause the test module emulation section corresponding to the interruption collection timing to notify the control emulation section of the interruption generated in simulation in the cycle time at which the test module emulation section generates the test signal just before the interruption collection timing, in case that the timing alignment section outputs one of the interruption collection timings.

Each of the plurality of test module emulation sections may generate change timing of the test signal in the cycle time at the generation of the test signal in the cycle time corresponding to the test signal generating timing, and the test emulator may further include a DUT connection section for acquiring the plurality of change timings generated by the plurality of test module emulation sections, and for changing the test signal in simulation one by one in order of time based on the plurality of change timings.

The DUT connection section supplies the plurality of change timings acquired from the plurality of test module emulation sections to the timing alignment section, the timing alignment section may align the plurality of change timings, the plurality of test signal generating timings, and the plurality of interruption collection timings in order of time, and outputs them one by one, and the schedule section may cause the DUT connection section to change the test signal in simulation at the change timing, in case that the timing alignment section outputs one of the change timings.

Each of the plurality of the test module emulation sections may notify the synchronous emulation section of the cycle end timing at which the cycle time ends during the generation of the test signal in the cycle time corresponding to the test signal generating timing, and the synchronous emulation section may generate the test signal generating timings at which the test module emulation section generates the test signal in simulation corresponding to next cycle time based on the cycle end timing notified from each of the plurality of test module emulation sections.

The schedule section may cause the interruption generated in simulation by the test module emulation section corresponding to the test signal generating timing to be notified to the control emulation section during the generation of the test signal in the cycle time just before the test signal generating timing, in case that the timing alignment section outputs the test signal generating timing corresponding to the next cycle time.

Each of the plurality of test module emulation sections may be realized by operating test module emulation program corresponding to the test module emulation section by a computer, and the test module emulation program may include: a plurality of hardware emulation functions, being provided corresponding to a plurality of commands received by the test module from the control apparatus respectively, for emulating operation of the test module corresponding to the command; and a control function used in order for the schedule section to cause the test emulator to generate the test signal in the cycle time corresponding to the test signal generating timing.

According to the second aspect of the present invention, there is provided a recording medium storing therein a program for causing a computer to function as a test emulator according to the first aspect of the invention.

The summary of the invention does not necessarily describe all necessary features of the present invention. The present invention may also be a sub-combination of the features described above.

BRIEF DESCRIPTION OF THE DRAWINGS

Fig. 1 is a block diagram showing a configuration of a test apparatus 10 according to an embodiment of the present invention.
Fig. 2 is a block diagram showing a functional configuration of a test emulator 190 according to an embodiment of the present invention.

Fig. 3 is a block diagram exemplary showing a hardware configuration of a computer 20 according to an embodiment of the present invention.

Fig. 4 is a block diagram showing a functional configuration of a test module emulation section 270 according to an embodiment of the present invention.

Fig. 5 shows an example of a class hierarchical structure 500 according to an embodiment of the present invention.

Fig. 6 is a flow chart showing a test signal generating processing flow of the test emulator 190 according to an embodiment of the present invention.

Fig. 7 is a drawing exemplary showing the test signal simulated by the test emulator 190 according to an embodiment of the present invention.

Fig. 8 illustrates software architecture according to an embodiment of the present invention.

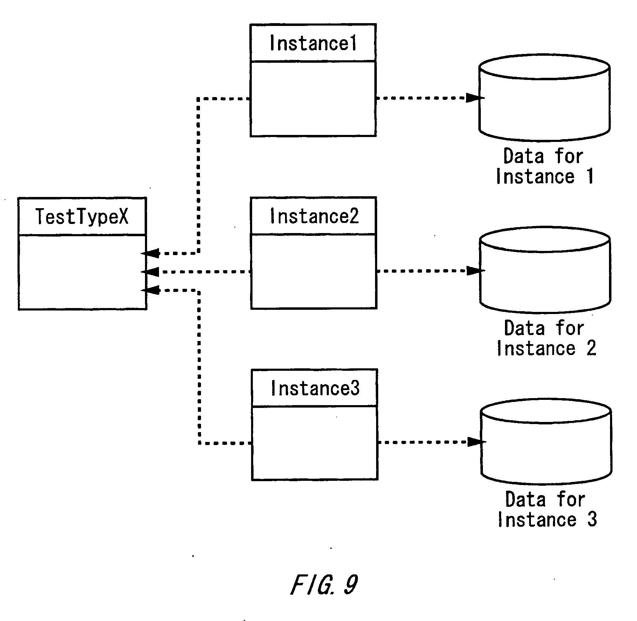

Fig. 9 illustrates the use of test classes according to an embodiment of the invention.

Fig. 10 is a Unified Modelling Language (UML) diagram illustrating the interaction of a tester system and different vendor-supplied module resources according to an embodiment of the invention.

Fig. 11 illustrates an embodiment of site controller objects for managing a user's test as maintained by a site controller.

Fig. 12 illustrates an embodiment of an object surrogate at the system controller side that represents the site controller object shown in Figure 11.

Fig. 13 illustrates a test environment according to an embodiment of the invention.

Fig. 14 illustrates an example of a simulation configuration file according to an embodiment of the present invention.

Fig. 15 illustrates another example of the simulation configuration file according to an embodiment of the present invention.

Fig. 16 illustrates an example of an offline configuration file according to an embodiment of the present invention.

Fig. 17 illustrates another example of the offline configuration file according to an embodiment of the present invention.

Fig. 18 illustrates an example of a class hierarchical structure 5200 according to an embodiment of the present invention.

Fig. 19 illustrates a specification diagram of a channel object according to an embodiment of the present invention.

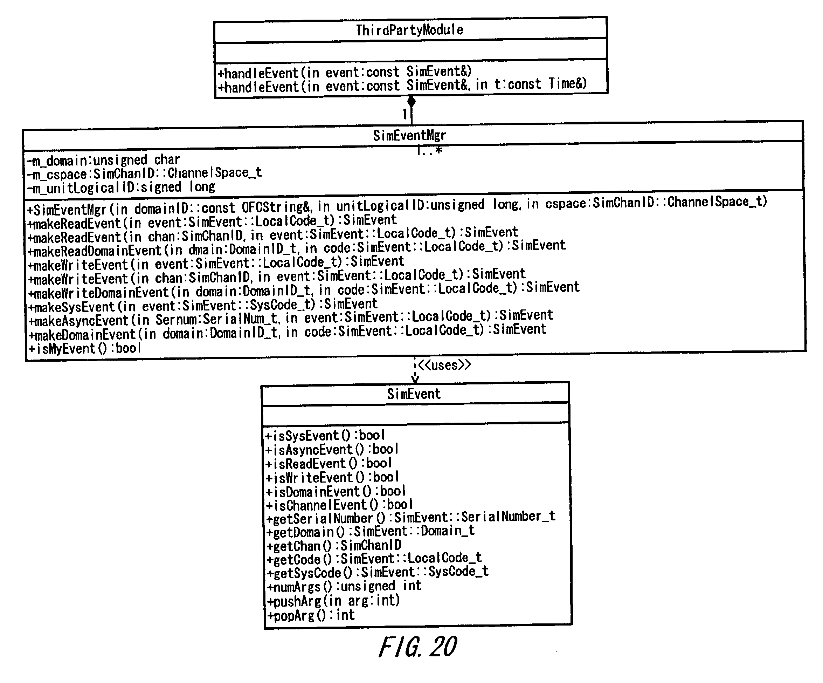

Fig. 20 illustrates a specification diagram of an event object according to an embodiment of the present invention.

Fig. 21 illustrates an example of a base class of the digital module according to an embodiment of the present invention.

Fig. 22 illustrates an example of class declaration of the digital driver module according to an embodiment of the present invention.

Fig. 23 illustrates an example of a handleEvent method of the digital driver module according to an embodiment of the present invention.

Fig. 24 illustrates class declaration of the digital strobe module according to an embodiment of the present invention.

Fig. 25 illustrates an example of a handleEvent method of the digital strobe module according to an embodiment of the present invention.

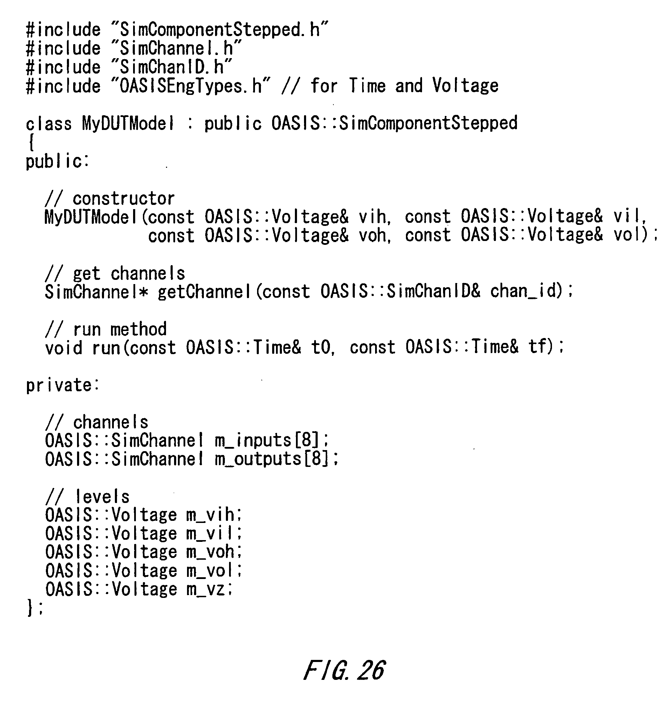

Fig. 26 illustrates an example of a class definition of a DUT model according to an embodiment of the present invention.

Fig. 27 illustrates an example of a run method of the DUT model according to an embodiment of the present invention.

Figs. 28A and 28B illustrate positioning of a system bus access library 6014 in real environment 6000 and emulation environment 6050.

## DETAILED DESCRIPTION OF THE INVENTION

The invention will now be described based on the preferred embodiments, which do not intend to limit the scope of the present invention, but exemplify the invention. All of the features and the combinations thereof described in the embodiment are not necessarily essential to the invention.

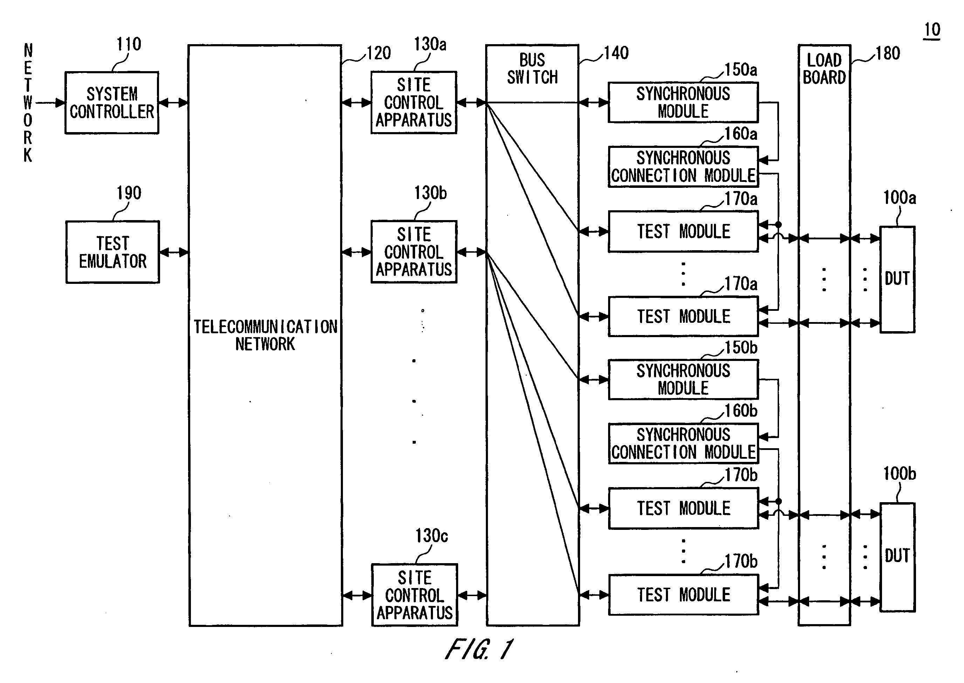

Fig. 1 is a block diagram showing a configuration of a test apparatus 10 according to an embodiment of the present invention. The test apparatus 10 generates a test signal, supplies it to a DUT 100 (Device Under Test), and judges acceptability of the DUT 100 based on whether a result signal, which is output from the DUT 100 as a result of the DUT 100 being operated based on the test signal, coincides with an expected value. The test apparatus 10 according to the present embodiment is realized by an open architecture, and various kinds of modules based on the open architecture are used as a test module 170 and the like for supplying the test signal to the DUT 100. Moreover, the test apparatus 10 includes a test emulator 190 for emulating a real test of the DUT 1000, and the test emulator 190 provides an emulation environment for appropriately changing a configuration in response to the change of the test module 170 and the like used for the real test, and for appropriately emulating the real test of the DUT 1000.

The test apparatus 10 includes a system controller 110, a telecommunication network 120, site controllers 130a-130c, a bus switch 140, synchronous modules 150a-150b, synchronous connection modules 160a-160b, the test modules 170a-170b, a load board 180, and the test emulator 190. The test apparatus 10 connects with the DUTs 100a-100b.

The system controller 110 receives and stores test control program, test program, test data and the like, which is used for the test of the DUTs 100a-100b by the test apparatus 10, through an external network or the like. The telecommunication network 120 connects the system controller 110, the site controllers 130a-130c, and the test emulator 190, and relays communication between them.

The site controllers 130a-130c are examples of the control apparatus according to the present invention, and control the test of the DUTs 100. Here, each of the plurality of site controllers 130 controls the test of one of the DUTs 100 respectively. For example, in Fig. 1, the site controller 130a controls the test of the DUT 100a, and the site controller 130b controls the test of the DUT 100b. Alternatively, the plurality of site controllers 130 control the test of the plurality of DUTs 100 respectively.

More specifically, the site controller 130 acquires the test control program from the system controller 110 through the telecommunication network 120 and executes it. Next, based on the test control program, the site controller 130 acquires the test program and the test data used for the test of the DUT 100 from the system controller 110, and stores them in a module, such as the synchronous modules 150 or one or a plurality of the test module 170, which is used for the test of the DUT 100, through the bus switch 140. Next, the site controller 130 instructs the start of the test to the synchronous module 150 through the bus switch 140 based on the test program and the test data. Then, the site controller 130 receives an interruption, which indicates that the test is completed, from, for example, the synchronous module 150, and causes each of the modules to perform the next test based on the test result.

The bus switch 140 connects each of the plurality of site controllers 130 to the synchronous modules 150 and one or a plurality of the test modules 170 which are controlled by the site controller 130, and relays the communication between them. Here, a predetermined site controller 130 sets up the bus switch 140 in order to connect each of the plurality of site controllers 130 with the synchronous module 150 and one or a plurality of the test modules 170 used by the site controller 130 for the test of the DUT 100, based on the instruction of a user of the test apparatus 10, the test control program, etc. For example, in Fig. 1, the site controller 130a is set up so that it connects with the synchronous module 150a and the plurality of test modules 170a, thereby the DUT 100a is tested. Moreover, the site controller 130b is set up so that it connects with the synchronous module 150b and the plurality of test modules 170b, thereby the DUT 100b is tested.

Here, since configuration and operation of the site controller 130b for testing the DUT 100b using the synchronous module 150b, the synchronous connection modules 160b and one or a plurality of the test module 170b are substantially the same as configuration and operation of the site controller 130a for testing the DUT 100a using the synchronous module 150a, the synchronous connection modules 160a and one or a plurality of the test module 170a, the configuration and the operation of the site controller 130a for testing the DUT 100a will be mainly described hereinafter unless there is no difference.

The synchronous module 150a generates a test signal generating timing, at which the plurality of test modules 170 used for the test of the DUT 100a are to generate the test signal, based on the instruction of the site controller 130a. Moreover, the synchronous module 150a receives the test result from one or a plurality of the test modules 170a through the synchronous connection module 160a, and causes one or a plurality of the test module 170a to perform sequence of the test program according to the acceptability of the test result.

The synchronous connection module 160a notifies the test module 170a of the test signal generating timing generated by the synchronous module 150a, where the test module 170a is to be operated corresponding to the test signal generating timing. Then, the synchronous connection module 160a causes each of one or a plurality of the test modules 170a to operate at a predetermined timing. Moreover, the synchronous connection module 160a receives the test result from one or a plurality of the test modules 170a, and transmits it to the synchronous module 150a.

The plurality of test modules 170a connect with a part of a plurality of terminals of the 100a respectively, and tests the DUT 100a based on the test program and the test data stored in the site controller 130a. During the test of the DUT 100a, test module 170a generates the test signal from the test data based on the sequence defined by the test program, and supplies the test signal to the terminals of the DUT 100a connected to the test modules 170a. Next, test module 170a acquires the result signal, which is output as a result of the DUT 100a being operated based on the test signal, and the result signal is compared with an expected value. Then, the test module 170a transmits the comparison result of the result signal and the expected value to the synchronous connection module 160a as the test result. Here, the plurality of test modules 170a generate the test signal based on different cycles in order to change the cycle of the test signal dynamically based on the test program and the test data.

Moreover, the test module 170a generates an interruption to the site controller 130a, when the processing of the test program is completed, or when an abnormality occurs during the execution of the test program. This interruption is notified to the site controller 130a corresponding to the test module 170a through the bus switch 140, and interruption processing is performed by the processor of the site controller 130a.

The plurality of DUTs 100 are mounted on the load board 180, by which the plurality of test modules 170 and the corresponding terminals of the DUTs 100 are connected.

The test emulator 190 emulates the test apparatus 10 based on the test control program, the test program, and the test data stored in the system controller 110. Then, the test emulator 190 simulates the test of the DUT 100 using the simulation model of the DUT 100. In the present embodiment, the test emulator 190 simulates the operation of the site controller 130, the synchronous module 150 and the synchronous connection modules 160 and one or a plurality of the test modules 170 controlled by the site controller 130, and the DUT 100 which is to be tested by the corresponding site controller 130. By using the test emulator 190, the user of the test apparatus 10 starts the verification of the test control program, the test program, and/or the test data prior to the preparation of the DUT 100, the synchronous module 150, the synchronous connection module 160, the test module 170, etc. Moreover, by providing the plurality of test emulators 190, the test control program, the test program, and/or the test data are developed, without each of the plurality of users occupying the expensive real test environment.

As stated above, the test apparatus 10 is realized by an open architecture and various kinds of modules, which fulfil the specification of the open architecture, are utilized. Then, the test apparatus 10 is used by inserting the modules, such as the synchronous module 150, the synchronous connection module 160, and the test module 170, into arbitrary connection slots of the bus switch 140. At this time, the user of the test apparatus 10 etc. changes topology of the bus switch 140 through the site controller 130a for example, causes the plurality of modules used for the test of the DUT 100 to connect with the site controller 130 for controlling the test of the DUT 100. Thereby, the user of the test apparatus 10 selects a suitable module according to the number of the terminals, the arrangement of the terminals, the kind of the terminals, or the kind of the test for each of the plurality of the DUTs 100, and mounts the module on the test apparatus 10.

Alternatively, as a substitution for the above-mentioned example, the synchronous connection module 160a and the synchronous connection module 160b are realized by a synchronous connection section provided for all of the test modules 170 used for the test apparatus 10. In this case, the user of the test apparatus 10 etc. selects a suitable module according to the property of the plurality of DUTs 100 by changing the topology of the synchronous connection section and the test module 170 with the change of the topology of the bus switch 140.

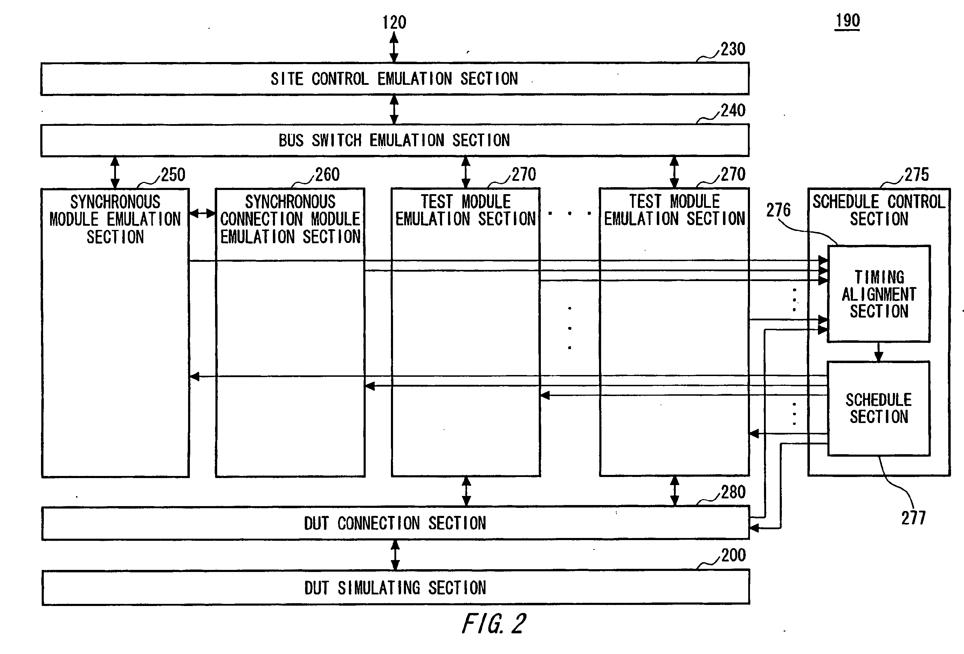

Fig. 2 is a block diagram showing a functional configuration of the test emulator 190 according to the embodiment of the present invention. The test emulator 190 includes a site control emulation section 230, a bus switch emulation section 240, a synchronous module emulation section 250, a synchronous connection module emulation section 260, one or a plurality of test module emulation sections 270, a DUT connection section 280, a DUT simulating section 200, and a schedule control section 275. Hereinafter, a case where the test emulator 190 emulates the test of the DUT 100a by the site controller 130a will be explained.

The site control emulation section 230 emulates the site controller 130a illustrated in Fig. 1. That is, the site control emulation section 230 acquires the test control program from the system controller 110 through the telecommunication network 120 and executes it. Next, the site control emulation section 230 acquires the test program and the test data, which are used for the test of the DUT 100a based on the test control program, from the system controller 110, and stores them in module emulation sections such as the synchronous module emulation section 250 or one or a plurality of the test module emulation sections 270 through the bus switch emulation section 240.

Here, the site control emulation section 230 issues simulation commands, such as read-out access and write-in access from/to a storage area in the module, to the bus switch emulation section 240, where real commands are to be issued by the site controller 130a to the synchronous modules 150a and one or a plurality of the test modules 170a. The site control emulation section 230 stores the test program and the test data in the synchronous module emulation sections 250, one or a plurality of the test module emulation sections 270, etc. through the bus switch emulation section 240 by issuing the write-in access of the test program and the test data in simulation to the bus switch emulation section 240.

Moreover, the site control emulation section 230 receives the interruption simulated by the synchronous module emulation section 250 and the test module emulation section 270 through the bus switch emulation section 240, and simulates the interruption processing of the site controller 130a.

The bus switch emulation section 240 emulates the bus switch 140 illustrated in Fig. 1, and relays the communication between the site control emulation section 230, and the synchronous module emulation sections 250 and one or a plurality of the test module emulation sections 270.

The synchronous module emulation section 250 emulates the synchronous module 150 illustrated in Fig. 1, and generates the test signal generating timing, at which each of the plurality of test module emulation sections 270 is to generate the test signal in simulation corresponding to the cycle time of the test module emulation section 270, based on the instructions from the site control emulation section 230. Next, the synchronous module emulation section 250 receives cycle end timing, which is the end timing of the cycle time, from the test module emulation section 270 which generates the test signal. Then, according to the cycle end timing, the synchronous module emulation section 250 generates: a test signal generating timing at which the test module emulation section 270 is to generate the next test signal; a test result collection timing for collecting the test results from the test module emulation section 270; a cycle termination timing for causing the test module emulation section 270 to terminate the processing of the cycle time; and an interruption collection timing for collecting the interruption to the site control emulation section 230 from the test module emulation section 270. Here, the interruption to the site control emulation section 230 from the test module emulation section 270 is the simulated interruption generated by each of the plurality of test module emulation sections 270 for the site controller 130a during the generation of the test signal in the cycle time corresponding to the test signal generating timing.

The synchronous connection module emulation section 260 emulates the synchronous connection module 160 illustrated in Fig. 1, and notifies the schedule control section 275 of the test signal generating timing generated by the synchronous module emulation section 250 in simulation, the test result collection timing and the cycle termination timing and the interruption collection timing which are generated by the synchronous module emulation section 250 for the emulation. Moreover, the synchronous connection module emulation section 260 receives the test result from one or a plurality of the test module emulation sections 270, and transmits it to the synchronous module emulation section 250.

The test module emulation section 270 receives instruction of a cycle start from the synchronous module emulation section 250 which received instructions of a test signal generation, and generates the test signal in simulation in the cycle time corresponding to the test signal generating timing based on the test program and the test data stored in the site control emulation section 230. More specifically, the test module emulation section 270 generates a change timing of the test signal in simulation in the cycle time during the generation of the test signal in the cycle time corresponding to the test signal generating timing. Alternatively, the test module emulation section 270 generates change timings corresponding to a cycle time as a change timing of the test signal, where the number of the change timings is defined by specification of the test module 170 corresponding to the test module emulation section 270. Moreover, the test module emulation section 270 acquires the output signal output as a result of the DUT simulating section 200 being operated in simulation based on the test signal, and compares the result with the expected value defined based on the test program and the test data. Then, the test module emulation section 270 transmits the comparison result of the result signal and the expected value to the synchronous module emulation section 250 through the synchronous connection module emulation section 260 as the test result.

Moreover, in response to instruction of the interruption from the schedule section 277, the test module emulation section 270 notifies the site control emulation section 230 through the bus switch emulation section 240 of the interruption generated in simulation in the cycle time during which the last test signal before receiving the instruction of the interruption is generated.

The DUT connection section 280 acquires the plurality of change timings generated by the plurality of test module emulation sections 270, and changes the test signal in simulation in order of time based on the plurality of change timings.

The DUT simulating section 200 simulates operation of the DUT 100 described by hardware description languages, such as Verilog-HDL or VHDL, based on the test signal acquired from the DUT connection section 280. Then, the DUT simulating section 200 generates a result signal by the simulation, which is output as a result of the DUT 100 being operated based on the test signal, and supply it to the test module emulation section 270 through the DUT connection section 280.

The schedule control section 275 controls the schedule which operates each of the module emulation sections based on various kinds of timings generated by the plurality of module emulation sections in the simulated test of the DUT 100 by the synchronous module emulation section 250, the synchronous connection module emulation section 260, the plurality of test module emulation sections 270, and the DUT connection section 280. The schedule control section 275 includes a timing alignment section 276 and a schedule section 277.

The timing alignment section 276 aligns the plurality of test signal generating timings, the plurality of interruption collection timings, the plurality of cycle termination timings and the plurality of test result collection timings, which are generated by the synchronous module emulation section 250, and the plurality of change timings that are generated by one or a plurality of the test module emulation sections 270 and are supplied by the DUT connection section 280, in order of time. Then, the timing alignment section 276 outputs these aligned timings to the schedule section 277 one by one. The schedule section 277 notifies the module emulation section and the DUT connection section 280 corresponding to the timings of each of the timings output from the timing alignment section 276 one by one. Then, the schedule section 277 causes the module emulation section or the DUT connection section 280 to perform the operation corresponding to the timings. The operation of the schedule section 277 according to the kind of the timing output from the timing alignment section 276 will be explained hereinafter.

(1) In case that the timing alignment section 276 outputs test signal generating timing

The schedule section 277 notifies the synchronous module emulation section 250 of the test signal generating timing, and instructs the generation of the test signal by the test module emulation section 270 corresponding to the test signal generating timing through the synchronous module emulation section 250. Thereby, the schedule section 277 causes the test module emulation section 270 corresponding to the test signal generating timing to generate the test signal in simulation in the cycle time corresponding to the test signal generating timing through the synchronous module emulation section 250.

(2) In case that the timing alignment section 276 outputs the interruption collection timing

The schedule section 277 instructs the generation of the interruption to the test module emulation section 270 which is designated corresponding to the interruption collection timing. Thereby, the schedule section 277 causes the test module emulation section 270 to notify the site control emulation section 230 through the bus switch emulation section 240 of the interruption generated in simulation in the cycle time during which the test signal is generated just before the interruption collection timing.

(3) In case that the timing alignment section 276 outputs the cycle termination timing

The schedule section 277 notifies the test module emulation section 270 corresponding to the cycle termination timing that the cycle end timing has come.

(4) In case that the timing alignment section 276 outputs the test result collection timing

The schedule section 277 notifies the test module emulation section 270 corresponding to the test result collection timing that the test result collection timing has come. In response, the test module emulation section 270 notifies the synchronous module emulation section 250 through the synchronous connection module emulation section 260 of the comparison result of the result signal and the expected value in the cycle time.

(5) In case that the timing alignment section 276 outputs the change timing

The DUT connection section 280 supplies the plurality of change timing acquired from the plurality of test module emulation sections 270 to the timing alignment section 276. In response, the timing alignment section 276 aligns the plurality of change timings and other various timings altogether in order of time.

If the timing alignment section 276 outputs the change timing, the schedule section 277 notifies the DUT connection section 280 that the change timing has come, in order to change the test signal in simulation at the change timing. In response, the DUT connection section 280 changes the test signal in simulation at the change timing.

Here, the test module emulation section 270 notifies the schedule control section 275 of result signal acquisition timing, which is a timing of the acquisition of the result signal. Then, the timing alignment section 276 aligns the result signal acquisition timing and the other various timings in order of time. In this case, when the timing alignment section 276 outputs the result signal acquisition timing, the schedule section 277 causes the DUT connection section 280 to supply the result signal to the test module emulation section 270 which is to acquire the result signal at the result signal acquisition timing.

Moreover, the DUT connection section 280 acquires the plurality of change timings generated by the plurality of test module emulation sections 270, and supplies them to the DUT simulating section 200, without aligning them in order of time. In this case, the DUT simulating section 200 aligns the plurality of supplied change timings in order of time, and performs the simulation of the DUT 100 based on a plurality of aligned change timings.

According to the test emulator 190 described above, by providing the synchronous module emulation section 250, the synchronous connection module emulation section 260 and one or a plurality of the test module emulation sections 270 respectively corresponding to the synchronous module 150, the synchronous connection modules 160 and one or a plurality of the test modules 170 of the real system of the test apparatus 10, the module emulation sections can be easily replaced as other module emulation sections. Thereby, in case that one module is replaced as another modules in the real system of the test apparatus 10, in the test emulator 190, a module emulation section corresponding to the module is replaced by a module emulation section corresponding to the other module. Then substantially the same test environment as the real system of the test apparatus 10 is provided on the test emulator 190.

Alternatively, as a substitution for the above-mentioned example, the site control emulation section 230, the bus switch emulation section 240, the synchronous module emulation section 250, the test module emulation section 270, the schedule control section 275, the DUT connection section 280, and the DUT simulating section 200 are realized by a distributed system including a plurality of computers.

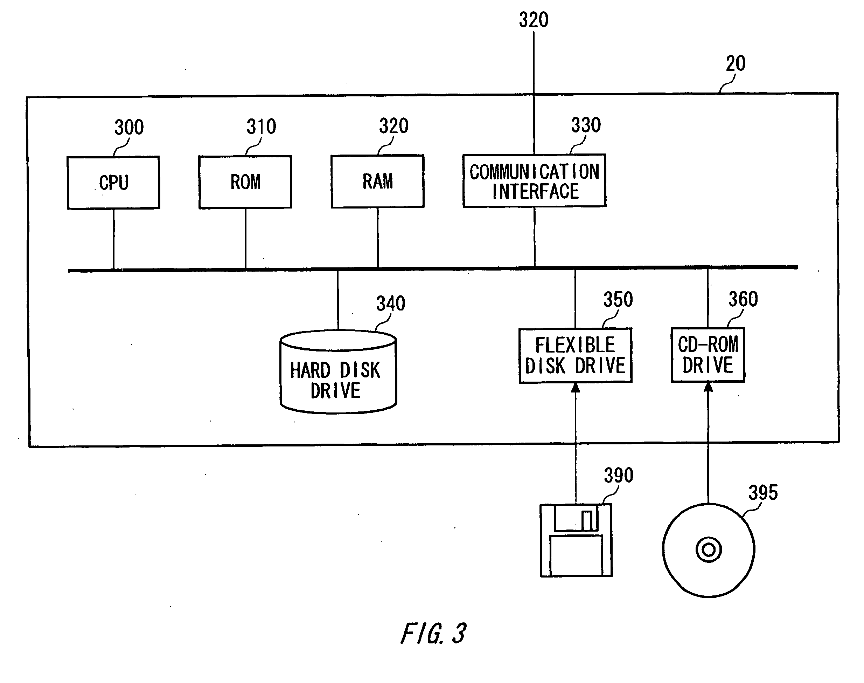

Fig. 3 is a block diagram exemplary showing a hardware configuration of the test emulator 190 according to the present embodiment of the invention. The test emulator 190 according to the present embodiment is realized by a computer 20 which includes CPU 300, ROM 310, RAM 320, a communication interface 330, a hard disk drive 340, a flexible disk drive 350, and a CD-ROM drive 360.

The CPU 300 operates based on the program stored in the ROM 310 and the RAM 320, and controls each part. The ROM 310 stores boot program which the CPU 300 executes during start up of a computer 20, program depending on the hardware of the computer 20 and the like. The RAM 320 stores program which the CPU 300 executes, data which the CPU 300 uses. The communication interface 330 communicates with other equipments through a telecommunication network. The hard disk drive 340 stores the program and the data which the computer 20 uses, and supplies them to the CPU 300 through the RAM 320. The flexible disk drive 350 reads program or data in a flexible disk 390, and provides them to the RAM 320. The CD-ROM drive 360 reads program or data in a CD-ROM 395, and provides them to the RAM 320.

The program provided to the CPU 300 through the RAM 320 is stored in a record medium, such as the flexible disk 390, the CD-ROM 395, or an IC card, which is provided by a user. The program is read from the record medium, installed in the computer 20 through the RAM 320, and executed by the computer 20.

The program modules, which are installed and executed in/by the computer 20 and causes the computer 20 to function as the test emulator 190, includes a DUT simulating module, a site control emulation module, a bus switch emulation module, a synchronous module emulation module, a synchronous connection module emulation module, a test module emulation module, a schedule control module, a timing alignment module, a schedule module, and a DUT connection module. The programs or the modules causes the computer 20 to function as the DUT simulating section 200, the site control emulation section 230, the bus switch emulation section 240, the synchronous module emulation section 250, the synchronous connection module emulation section 260, the test module emulation section 270, the schedule control section 275, the timing alignment section 276, the schedule section 277, and the DUT connection section 280 respectively.

Alternatively, the programs or the modules described above are stored in an external record medium. It is possible to use an optical record medium such as DVD or PD, a magneto-optical record medium such as Minidisk, a tape medium, a magnetic record medium or a semiconductor memory such as an IC card as a record medium instead of the flexible disk 390 and the CD-ROM 395. Moreover, a storage device, such as a hard disk or RAM in a server system on a dedicated telecommunication network or the Internet, is used as a record medium and the program may be provided to the computer 20 via the telecommunication network.

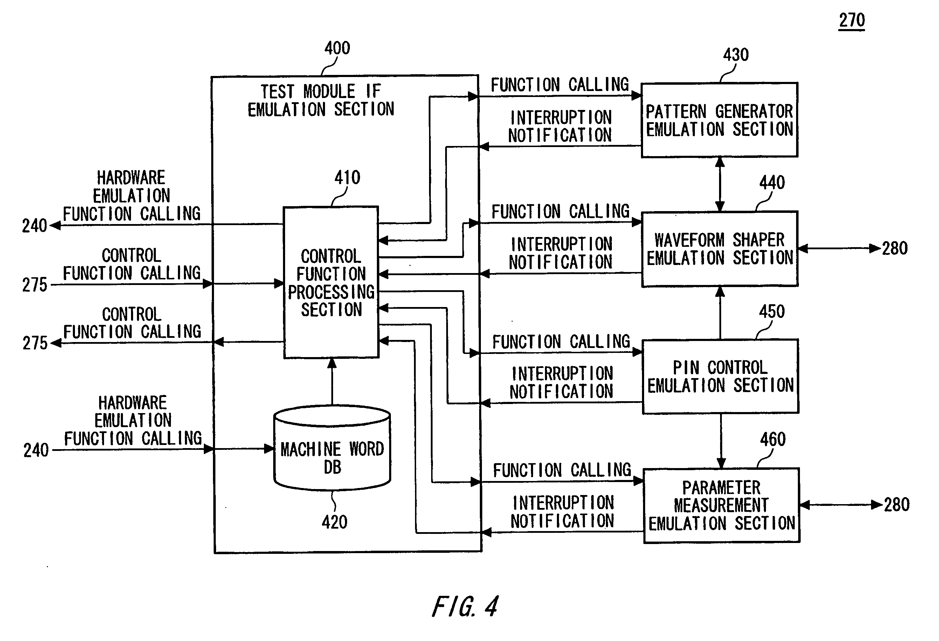

Fig. 4 is a block diagram showing a functional configuration of the test module emulation section 270 according to the embodiment of the present invention. In Fig. 4, the test module emulation section 270 is realized by operating the test module emulation program or test module emulation module corresponding to the test module emulation section 270 by the computer 20.

The test module emulation section 270 includes a plurality of hardware emulation functions provided corresponding to each of the plurality of commands received by the test module 170 through the bus switch 140 from the site controller 130, and a control function called in order to notify the test module emulation section 270 of various kinds of timings. The test module emulation section 270 operates in response to the call to these functions from the bus switch emulation section 240 and the schedule control section 275. Here, the control function is used in order for the schedule control section 275 to order the generation of the test signal in simulation in the cycle time corresponding to the test signal generating timing, and to order to notify the site control emulation section 230 of the interruption generated in simulation in the cycle time when the test module emulation section 270 generates the test signal just before the interruption collection timing.

The test module emulation section 270 includes a test module IF emulation section 400 (test module interface emulation section), a pattern generator emulation section 430, a waveform shaper emulation section 440, a pin control emulation section 450, and a parameter measurement emulation section 460. The test module IF emulation section 400 is started-up when the hardware emulation function is called from the bus switch emulation section 240, and when the control function is called from the schedule control section 275. The test module IF emulation section 400 controls the operation of the test module emulation section 270 corresponding to these function calling. The test module IF emulation section 400 includes a machine word DB 420 and a control function processing section 410.

The machine word DB 420 emulates a storage area stored in the storage area provided in the test module 170. When the machine word DB 420 receives a command from the site control emulation section 230 in simulation through the bus switch emulation section 240 by the calling of the hardware emulation function, it accesses the storage area in the machine word DB 420 corresponding to the command.

More specifically, the test module IF emulation section 400 according to the present embodiment stores a plurality of hardware emulation functions for emulating the operation of the test module emulation section 270 corresponding to a plurality of commands, such as read-out access and write-in access, respectively. When the read-out access is received from the site control emulation section 230 through the bus switch emulation section 240, the test module IF emulation section 400 replies the data in the machine word DB 420 corresponding to the storage area for the read-out access, to the site control emulation section 230 through the bus switch emulation section 240. Moreover, when the machine word DB 420 receives the write-in access, it stores the data to be written in the storage area of the machine word DB 420 corresponding to the storage area for the write-in access. For example, when the machine word DB 420 receives the write-in access of the test program or the test data from the site control emulation section 230 through the bus switch emulation section 240, it stores the test programs or the test data in the storage area of the machine word DB 420 corresponding to the write-in access.

When the control function processing section 410 receives the control function call from the schedule control section 275, the control function processing section 410 causes the pattern generator emulation section 430, the waveform shaper emulation section 440, the pin control emulation section 450, and the parameter measurement emulation section 460 to emulate the operation of the test module 170 according to the control function in response to the instruction of the control function. More specifically, when the schedule control section 275 instructs the generation of the test signal using the control function in the cycle time corresponding to the test signal generating timing, the control function processing section 410 reads a part of the program and a part of the data among the test program and the test data stored in the machine word DB 420, where the part of the program and the data are to be processed by the test module emulation section 270 during the cycle time. Then, the control function processing section 410 causes the pattern generator emulation section 430, the waveform shaper emulation section 440, the pin control emulation section 450, and the parameter measurement emulation section 460 to perform the processing corresponding to the part of the program and the part of the data.

The pattern generator emulation section 430 emulates the pattern generator of the test module 170. That is, the pattern generator emulation section 430 receives the test program and the test data stored in the machine word DB 420 from the control function processing section 410 by the function call, for example. Then the instruction, which indicates that the test signal is to be generated for a certain cycle time, is received from the schedule control section 275 by the function call through the control function processing section 410, and the test signal, which is to be generated in the cycle time, is generated in simulation.

Moreover, the pattern generator emulation section 430 acquires the result signal through the DUT connection section 280 and the waveform shaper emulation section 440, which is output in simulation as a result of the DUT simulating section 200 being operated based on the test signal, and the result signal is compared with the expected value.

The waveform shaper emulation section 440 emulates the waveform shaper of the test module 170. That is, the waveform shaper emulation section 440 shapes the waveform of the test signal in simulation in response to the test signal from the pattern generator emulation section 430. Then the waveform is output to the DUT connection section 280.

The pin control emulation section 450 emulates the pin control section of the test module 170. That is, the pin control emulation section 450 sets parameters, such as operating voltage, for each terminal from which the test signal is output in simulation by the waveform shaper emulation section 440 and/or the parameter measurement emulation section 460 based on the test program.

The parameter measurement emulation section 460 emulates the parameter measurement section of the test module 170. That is, for example, the parameter measurement emulation section 460 receives an instruction of a direct current test (DC parametric test) from the schedule control section 275 through the control function processing section 410 by the function call, and generates the test signal in simulation, which is to be generated in the cycle time of the direct current test. Moreover, the parameter measurement emulation section 460 acquires the result signal, which is output in simulation as a result of the DUT simulating section 200 being operated based on the test signal in the direct current test.

Moreover, in case that the test module emulation section 270 generates the test signal in the cycle time corresponding to the test signal generating timing, the control function processing section 410 notifies the synchronous module emulation section 250 of the cycle end timing at which the cycle, which corresponds to the test signal generating timing, ends.

As stated above, the control function processing section 410 notifies the synchronous module emulation section 250 through the schedule control section 275 of the cycle end timing at which the cycle ends in the generation of the test signal in the cycle time corresponding to the test signal generating timing. Thereby, the control function processing section 410 causes the synchronous module emulation section 250 to further generate the test signal generating timing at which the test module emulation section 270 is to generate the test signal in simulation for the next time based on the cycle end timing.

Moreover, when the control function processing section 410 receives the instruction of the interruption generation from the schedule control section 275, the control function processing section 410 transmits the instruction of the interruption generation to the pattern generator emulation section 430, the waveform shaper emulation section 440, and the pin control emulation section 450 by the function call, for example. The pattern generator emulation section 430, the waveform shaper emulation section 440, and the pin control emulation section 450, which receive the instruction of the interruption generation, notify the control function processing section 410 of the interruption generated in simulation in the cycle time just before the interruption collection timing among the cycle times during which the test module emulation section 270 generates the test signal. When the interruption is notified, the control function processing section 410 notifies the site control emulation section 230 of the interruption through the bus switch emulation section 240 by calling the hardware emulation function for the notification of the interruption included in the bus switch emulation section 240, for example.

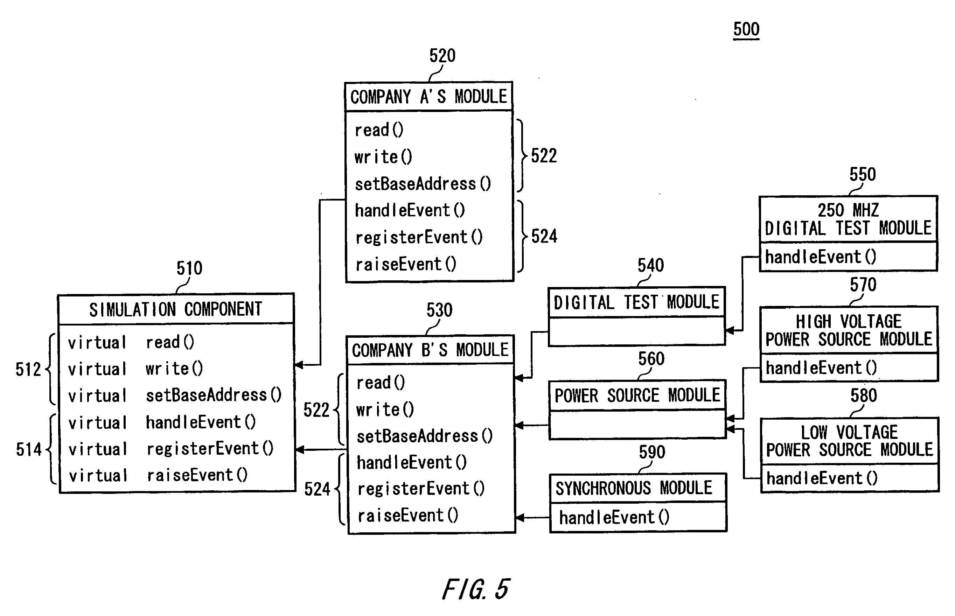

Fig. 5 shows an example of a class hierarchical structure 500 according to the embodiment of the present invention. In the present embodiment, module emulation program, which realizes the module emulation sections such as the synchronous module emulation section 250, the synchronous connection module emulation section 260, and the test module emulation section 270, is created using class functions, which are frameworks of the module emulation program defined in order to realize the open architecture of the test apparatus 10 in simulation.

The simulation component class 510 is a class which defines rules for calling a plurality of parameters, return values and etc. of method functions, which are to be included in the module emulation program, with a virtual method function. The simulation component class 510 includes a plurality of virtual hardware emulation functions 512 and a plurality of virtual control functions 514.

Here, read() is a method function for emulating the operation of the module corresponding to the read-out access which is called when the site control emulation section 230 issues the read-out access command in simulation. write() is a method function for emulating operation of the module corresponding to the write-in access which is called when the site control emulation section 230 issues the write-in access command in simulation. setBaseAddress() is a method function which is called when the site control emulation section 230 issues in simulation the base address setting command, which is issued by the site controller 130 when the base address of the storage area of the test module 170 is set up.

registerEvent() is a method function which is called when the synchronous connection module emulation section 260, the test module emulation section 270, and the DUT connection section 280, which receive the notices from the synchronous module emulation section 250, notify the timing alignment section 276 of the interruption collection timing, the change timing, the result signal acquisition timing, etc. and register the timings to the timing alignment section 276. handleEvent() is a method function which is called by the schedule control section 275, in order to cause the synchronous module emulation section 250, the synchronous connection module emulation section 260, the test module emulation section 270, and the DUT connection section 280 to perform the processing in response to the timings when the test signal generating timing, the interruption collection timing, the change timing, the result signal acquisition timing, etc. have come. raiseEvent() is a method function which is called when the synchronous module emulation section 250, the synchronous connection module emulation section 260, the test module emulation section 270, and the DUT connection section 280 notify the schedule control section 275 of an event which is to be processed asynchronously without regard to the timings.

A Company A's module class 520 and a Company B's module class 530 are classes derived from the simulation component class 510, i.e., module emulation programs, which are supplied by manufacturers of the modules for example, for emulating common function included in the modules of the manufacturers in common. The Company A's module class 520 and the Company B's module class 530 include a plurality of real hardware emulation functions 522 and a plurality of real control functions 524 respectively. Each of the plurality of real hardware emulation functions 522 and the plurality of real control functions 524 are module emulation programs which are described corresponding to the plurality of virtual hardware emulation functions 512 and the plurality of virtual control functions 514 respectively, and describe the contents of the processing of the real method functions (non-virtual method functions) corresponding to the virtual method functions.

The Company A's module class 520 and the Company B's module class 530 include classes which are further derived. For example, in Fig. 5, the Company B's module class 530 is further derived in a digital test module class 540, a power source module class 560, and a synchronous module class 590.

The digital test module class 540 is a class of test module emulation program for emulating the test module 170 for performing the functional test of the DUT 100. The digital test module class 540 is further derived in a 250 MHz digital test module class 550 for emulating the test module 170 which performs the functional test of the DUT 100 at a frequency of 250 MHz. The power source module class 560 is a class of module emulation program for emulating the module for supplying electric power to the DUT 100. The power source module class 560 is further derived in a high voltage power source module class 570 for emulating the module which supplies high voltage power to the DUT 100, and the low voltage power source module class 580 for emulating the module which supplies low voltage power to the DUT 100. The synchronous module class 590 is a class of module emulation program for emulating the synchronous module 150.

Each of the 250 MHz digital test module class 550, the high voltage power source module class 570, the low voltage power source module class 580, and the synchronous module class 590 includes real method function handleEvent() for emulating the original function of each of the modules, which is used by replacing (overriding) the handleEvent() in the Company B's module class 530.

Each of the synchronous module emulation section 250, the synchronous connection module emulation section 260, one or a plurality of the test module emulation sections 270 etc. included in the test emulator 190 is realized as one instance of the classes of the module emulation programs included in the class hierarchical structure 500.

As described above, each of the synchronous module emulation section 250, the synchronous connection module emulation section 260, the module emulation section of test module emulation section 270 etc., which is included in the test emulator 190, is realized by the module emulation program corresponding to one of the classes included in the class hierarchical structure 500 for example. A user of the test emulator 190 builds substantially the same test environment as the real system of the test apparatus 10 in the test emulator 190 by generating the instance of the module emulation program from the combination of the classes corresponding to the combination of the modules which are to be mounted in the real system of the test apparatus 10. Moreover, in case of creating a new class corresponding to a new module, man-hour for creating module emulation program is reduced by creating a new class as an inherited class of one of the existing classes.

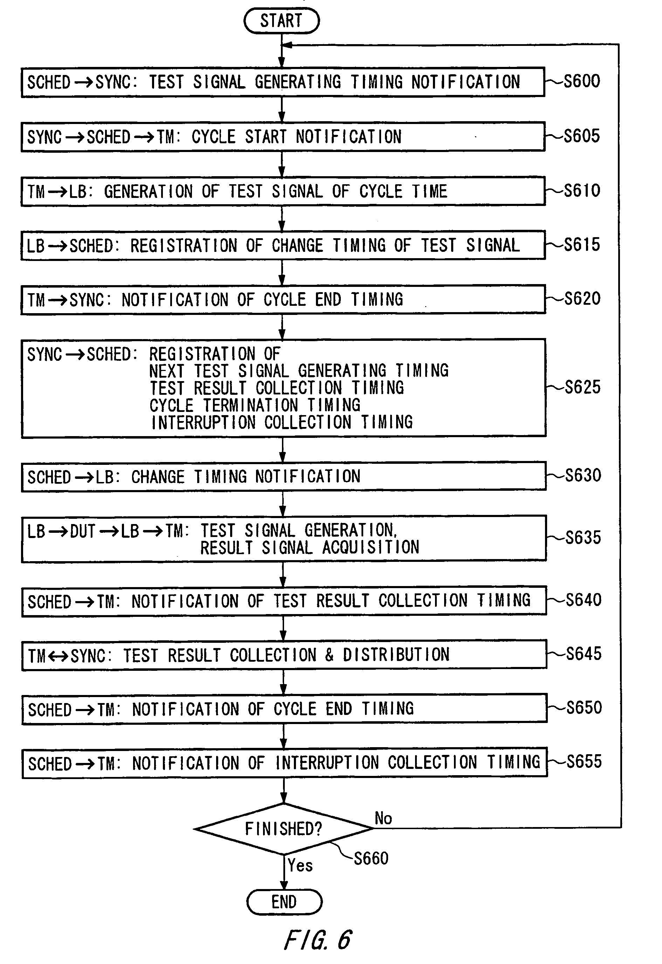

Fig. 6 shows a test signal generating processing flow of the test emulator 190 according to the embodiment of the present invention, which is proceeded by the test module emulation section 270.

When the site control emulation section 230 instructs the start of the test to the synchronous module emulation section 250 where the test program and the test data are stored in the synchronous module emulation section 250, the synchronous connection module emulation section 260 and one or a plurality of the test module emulation sections 270, the test emulator 190 proceeds the test in simulation according to a procedure described below.

First, in case that the timing alignment section 276 outputs the test signal generating timing, the schedule section 277 of the schedule control section 275 (shown as SCHED in the figure) calls the handleEvent() function of the synchronous module emulation section 250 (shown as SYNC in the figure), and notifies that the test signal generating timing has come (S600). Thereby, the schedule control section 275 causes the test module emulation section 270 corresponding to the test signal generating timing to generate the test signal in simulation in the cycle time corresponding to the test signal generating timing through the synchronous module emulation section 250. Here, the schedule control section 275 notifies the synchronous module emulation section 250 of the test signal generating timing by including the event identifier, which identifies that the test signal generating timing of the corresponding test module emulation section 270 has come, in a parameter of the handleEvent() function.

Next, the synchronous module emulation section 250 notifies the test module emulation section 270 (shown as TM in the figure), which is to generates the test signal in simulation in the test signal generating timing, of the cycle start which is the instructions for starting the processing of the cycle time and generating the test signal (S605). Here, the synchronous module emulation section 250 notifies the test module emulation section 270 of the cycle start through the schedule control section 275 asynchronous to the timings which are aligned by the timing alignment section 276 in order of time by including the event identifier, which instructs the cycle start, in the parameter of a raiseEvent() function, and calling the schedule control section 275.

Next, the test module emulation section 270 generates the test signal in simulation in the corresponding cycle time in response to the notice of the cycle start (S610). That is, in S600, when the schedule control section 275 notifies the synchronous module emulation section 250 of the test signal generating timing so as to generate the test signal in simulation in the cycle time corresponding to test signal generating timing, and when the synchronous module emulation section 250, which receives the notice, notifies the test module emulation section 270 of the cycle start through the schedule control section 275, the test module emulation section 270 generates the test signal in simulation in the cycle time. Here, the test module emulation section 270 generates the change timing of the test signal in simulation in the cycle time during the generation of the test signal in the cycle time.

Next, the DUT connection section 280 (shown as LB in the figure) notifies the timing alignment section 276 of the change timing in response to the change timing of the test signal from the test module emulation section 270, and registers it (S615).

Next, the test module emulation section 270 notifies the synchronous module emulation section 250 of the timing for end of the cycle (S620). Here, the test module emulation section 270 generates the test signal by the pattern generator emulation section 430 based on the designation by the test program and the test data, changing each cycle time dynamically. For this reason, the control function processing section 410 in the test module IF emulation section 400 of the test module emulation section 270 acquires the termination timing of each of the cycles from the pattern generator emulation section 430, and notifies the synchronous module emulation section 250 of the end timing, and causes the synchronous module emulation section 250 to generate the next test signal generating timing accurately.

Next, based on the cycle end timing notified from the test module emulation section 270 in S620, the synchronous module emulation section 250 generates the test signal generating timing at which the test module emulation section 270 is to generate the test signal in simulation corresponding to the next cycle time, notifies the timing alignment section 276 of the timing and registers it (S625). Moreover, the synchronous module emulation section 250 further generates a test result collection timing for collecting the test results from the test module emulation section 270, a cycle termination timing for terminating the cycle time of the test module emulation section 270, and the interruption collection timing for collecting the interruption which is generated by the test module emulation section 270 in simulation during the generation of the test signal in the cycle time. Then the synchronous module emulation section 250 notifies the timing alignment section 276 of the timings and registers them (S625). Here, the synchronous module emulation section 250 registers the timings into the timing alignment section 276 by calling the registerEvent() function in the schedule control section 275.

In addition, the synchronous module emulation section 250 generates substantially the same timing as the cycle end timing received from the test module emulation section 270 as the test signal generating timing, the test result collection timing, the cycle termination timing, and the interruption collection timing for the next time in the test module emulation section 270.

Next, when the timing alignment section 276 outputs the change timing which is registered in S615, the schedule section 277 notifies the DUT connection section 280 that the change timing has come so as to change the test signal in simulation at the timing (S630).

Next, when the change timing is notified from the schedule section 277, the DUT connection section 280 generates the test signal by changing the test signal in simulation at the change timing, and supplies it to the DUT simulating section 200 (S635). The DUT simulating section 200 simulates the operation of the DUT 100 based on the test signal acquired from the DUT connection section 280. Then, the DUT simulating section 200 generates the result signal in simulation output as a result of the DUT 100 being operated based on the test signal, and supplies it to the test module emulation section 270 through the DUT connection section 280. The test module emulation section 270 compares the result signal with the expected value, and acquires a comparison result.

Next, when the timing alignment section 276 outputs the test result collection timing registered in S625, the schedule section 277 notifies the test module emulation section 270 that the test result collection timing has come so as to collect acceptability of the result based on the result signal supplied from the DUT simulating section 200 to the test module emulation section 270 (S640). When the test result collection timing is notified, the test module emulation section 270 notifies the synchronous module emulation section 250 through the synchronous connection module emulation section 260 of the comparison result of the result signal and the expected value in the cycle time. The synchronous module emulation section 250 judges the acceptability (pass or fail) of the test result based on the comparison result collected from each of the test module emulation sections 270, and notifies each of the test module emulation section 270 of the acceptability of a test result (S645). Based on the acceptability of this test result, the test program and the test data, which are supplied to the plurality of test module emulation sections 270, are described so as to change the sequence of the test performed after the cycle time.

Next, when the timing alignment section 276 outputs the cycle termination timing in S625, the schedule section 277 notifies the test module emulation section 270 that that the termination timing of the cycle has come (S650).

Next, when the timing alignment section 276 outputs the interruption collection timing registered in S625, the schedule section 277 notifies the test module emulation section 270 that the interruption collection timing has come (S655). When the interruption collection timing is notified, the test module emulation section 270 notifies in simulation the site control emulation section 230 through the bus switch emulation section 240 of the interruption, which is generated in simulation in the cycle time at which the test module emulation section 270 generates the test signal just before the interruption collection timing.

The test emulator 190 repeats the processing explained in the above-mentioned steps 5600-S655 until the test is finished (S660).

In addition, when the test is done by the plurality of test module emulation sections 270, the schedule control section 275 aligns the timings of each of the operations of the test module emulation sections 270 in order of time, and makes the schedule. For this reason, S600, S630, S640, S650, and S655 about the plurality of test module emulation sections 270 are performed in order of time.

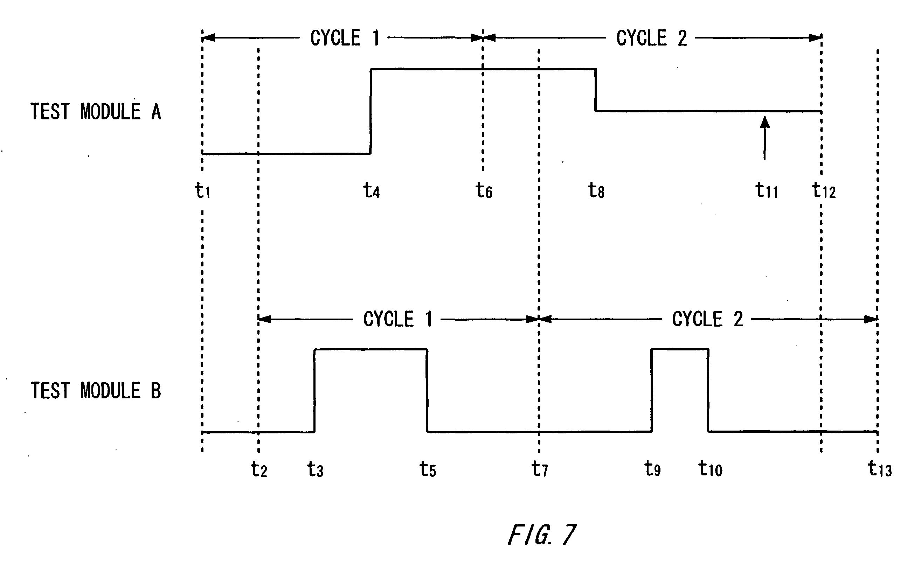

Fig. 7 is a drawing exemplary showing the test signal generated in simulation by the test emulator 190 according to the embodiment of the present invention. In this drawing, the test emulator 190 includes a test module emulation section 270a for emulating a test module A, and a test module emulation section 270b for emulating a test module B, as the test module emulation section 270.

Before time t1, the test signal generating timing t1 of the test module emulation section 270a, and the test signal generating timing t2 of the test module emulation section 270b are registered into the timing alignment section 276. Since the timings are to be output in order of time, the test signal generating timing t1 is output at first. In response to the result, the schedule section 277 notifies the synchronous module emulation section 250 that the test signal generating timing t1 has come, while the time is set forward to t1.

When the test signal generating timing t1 is notified, the synchronous module emulation section 250 notifies the test module emulation section 270a corresponding to the test signal generating timing t1 through the synchronous connection module emulation section 260 and the test module emulation section 270 of the start of the cycle. In response, test module emulation section 270a generates the test signal in simulation in the cycle time indicated to be a cycle 1 in the figure. Here, test module emulation section 270a notifies the DUT connection section 280 that the test signal changes to H level at the change timing t4 in the cycle time. In response, the DUT connection section 280 registers the change timing t4 into the timing alignment section 276.

Next, after the generation of the test signal in the cycle 1 is finished, the test module emulation section 270a notifies the synchronous module emulation section 250 of the cycle end timing t6 of the cycle 1. In response, the synchronous module emulation section 250 generates the test signal generating timing t6, the test result collection timing t6-$\Delta$, the cycle termination timing t6-$\Delta$, and the interruption collection timing t6-$\Delta$ for the next time based on the cycle end timing t6, and registers them into the timing alignment section 276. Here, t6-$\Delta$ a time just before the next test signal generating timing t6.

Next, the timing alignment section 276 aligns the registered timings in order of time, and outputs the test signal generating timing t2. In response, the schedule section 277 sets time forward to t2 and notifies the synchronous module emulation section 250 that the test signal generating timing t2 has come. '

When the test signal generating timing t2 is notified, the synchronous module emulation section 250 notifies the test module emulation section 270b corresponding to the test signal generating timing t2 through the schedule control section 275 of the cycle start. In response, test module emulation section 270b generates the test signal of test module emulation section 270b in simulation in the cycle 1. As a result, test module emulation section 270b generates change timings of the test signal t3 and t5, and the DUT connection section 280 registers the change timings into the timing alignment section 276.

Next, test module emulation section 270b notifies the synchronous module emulation section 250 of the cycle end timing t7 of the cycle 1 after the generation of the test signal in a cycle 1 is finished. In response, based on the cycle end timing t7, the synchronous module emulation section 250 generates the test signal generating timing t7, the test result collection timing t7-Δ, the cycle termination timing t7-Δ, and the interruption collection timing t7-Δ for the next time, and registers them into the timing alignment section 276.

Next, the timing alignment section 276 aligns the registered timings in order of time, and outputs the change timings t3, t4, and t5 one by one. According to each of the change timings, the schedule section 277 notifies the DUT connection section 280 of the change timings. As a result, the DUT connection section 280 changes the test signal in simulation during the change timing, and it is supplied to the DUT simulating section 200.

Next, the timing alignment section 276 outputs the test result collection timing t6-Δ. In response, the schedule section 277 sets the time forward to t6-Δ and notifies the test module emulation section 270a of the test result collection timing t6-Δ. As a result, collection and distribution of the test result are performed between the test module emulation section 270a and the synchronous module emulation section 250.

Next, the timing alignment section 276 outputs the cycle termination timing t6-Δ. In response, the schedule section 277 notifies the test module emulation section 270a of the end of the cycle 1.

Next, the timing alignment section 276 outputs the interruption collection timing t6-Δ. In response, the schedule section 277 notifies test module emulation section 270a of the outputs interruption collection timing t6-Δ. As a result, the test module emulation section 270a notifies the site control emulation section 230 of the interruption generated in simulation in the cycle 1.

Next, the timing alignment section 276 outputs the test signal generating timing t6. In response, the schedule section 277 sets the time forward to t6 and notifies the synchronous module emulation section 250 that the test signal generating timing t6 has come. Henceforth, the test emulator 190 generates the change timing t8, the result signal acquisition timing t1 indicating the timing at which the result signal is to be acquired, the test signal generating timing t12, the test result collection timing t12-Δ, cycle termination timing t12-Δ, and the interruption collection timing t12 for the next time in the similar manner to the time t1. Then, the test emulator 190 registers these timings into the timing alignment section 276 in the similar manner to the time t1.

Next, the timing alignment section 276 aligns the registered timings in order of time, and outputs the test signal generating timing t7. In response, the schedule section 277 sets the time forward to the t7 and notifies the synchronous module emulation section 250 that the test signal generating timing t7 has come. Henceforth, the test emulator 190 generates the change timings t9 and t10, the test signal generating timing t13, the test result collection timing t13-Δ, the cycle termination timing t13-Δ, and the interruption collection timing t13 for the next time in the similar manner to the time t2. Then, the test emulator 190 registers these timings into the timing alignment section 276 in the similar manner to the time t2.

As described above, according to the test emulator 190 of the present embodiment, the schedule control section 275 aligns various kinds of timings, such as the test signal generating timing, the test signal change timing, the test result collection timing, the result signal acquisition timing, and the interruption collection timing in order of time, so that the scheduling is carried out. For this reason, the test emulator 190 appropriately emulates the operation of the test apparatus 10 in case that the plurality of test modules 170 based on the different cycles are mounted.

Alternatively, in the present embodiment, although the synchronous connection module emulation section 260 registers the test result collection timing, the cycle termination timing, and the interruption collection timing into the timing alignment section 276 in case that the cycle end timing is received from the test module 170, The following method is substituted for the above-mentioned method.

In S625 illustrated in Fig. 6, based on cycle end timing, the synchronous module emulation section 250 generates the test signal generating timing at which the test module emulation section 270 is to generate the test signal in simulation corresponding to the cycle time, and notifies the timing alignment section 276 of the timing and registers the timing into the timing alignment section 276. On the other hand at this time, the synchronous module emulation section 250 does not generate the test result collection timing, the cycle termination timing, and the interruption collection timing, and does not register them into the timing alignment section 276.

As a result, after the processing in the steps S630 and S635 is done, the test emulator 190 proceeds to the step S600 skipping the steps S640, S650, and S655. Moreover, in case that the timing alignment section 276 outputs the test signal generating timing corresponding to the next cycle time in S600, the schedule section 277 notifies the synchronous module emulation section 250 that the test signal generating timing has come. In response, the synchronous module emulation section 250 instructs the collection of the test result, the notice of the cycle end, and the collection of the interruption to the test module emulation section 270 corresponding to the test signal generating timing before the generation of the test signal generating of the next cycle time.

According to the above-mentioned processing, the schedule control section 275 causes the synchronous module emulation section 250, the synchronous connection module emulation section 260, test module emulation section 270 etc., to perform the processing described in S640, S645, S650, and S655 before the generation of the test signal of the next cycle time. More specifically, the schedule control section 275 causes the synchronous module emulation section 250 and the synchronous connection module emulation section 260 to collect and distribute the acceptability of the test result based on the result signal supplied to the test module emulation section 270 during the generation of the test signal in the cycle time just before the test signal generating timing, and to notify the site control emulation section 230 of the interruption generated in simulation by the test module emulation section 270.

Although the present invention has been described by way of an exemplary embodiment, it should be understood that those skilled in the art might make many changes and substitutions. It is obvious from the definition of the appended claims that embodiments with such modifications also belong to the scope of the present invention.

For example, the real test of the DUT 100 by the synchronous module 150, the synchronous connection module 160, the test module 170 and the like, and a simulation test of the DUT 100 by the synchronous module emulation section 250, the synchronous connection module emulation section 260, the test module emulation section 270, the DUT simulating section 200 and the like, are provided to a user of the test apparatus 10, which is executable by an identical test control program and/or the identical test program. Alternatively, the test mode of the test apparatus can be switched between the real test and the simulation test manually by the user.

That is for example, the site controller 130 inputs instructions of selection between the real and simulation test of the DUT 100 as an option of a test start command or the like. Then, when the instructions orders to perform the real test of DUT 100, the system controller 110 or the site controller 130 supplies a test program for the test of the DUT 100 to one or a plurality of test modules 170 through the bus switch 140, and causes the test module 170 to test the DUT 100. On the other hand, when the instructions orders to perform the simulation test of the DUT 100, the site controller 130 supplies a test program to the test module emulation section 270 realized by software on the test emulator 190 or the site controller 130 or the like, and causes the test module emulation section 270 or the like to simulate the test of the DUT 100.

In the embodiments described above, the site controller 130 may execute communication software (communication library) which performs communication processing between the control units and the test modules 170 so that the real test environment and the simulation test environment may be accessible. In this case, the test control program executed by the site controller 130 performs the real test by using the identical access functions (read/write function etc.) provided by the communication software, and by accessing the synchronous module 150, the synchronous connection module 160, test module 170 and the like. Similarly, the test control program executed by the site controller 130 performs the simulation test by using the identical access functions provided by the communication software, and by accessing the synchronous module emulation section 250, the synchronous connection module emulation section 260, the test module emulation section 270 and the like. Here, the communication software described above, in cooperation with the site controller 130, may select the destination of the test program between the test module 170 or the like and the test module emulation section 270 or the like based on the instructions about which of the real test environment or the simulation test environment is to be selected. An example of such implementation is described further below in supplementary information C.2.4.3.

Moreover for example, the test module emulation section 270 described previously may include a configuration described below. First, each test module emulation section 270 receives signal for test signal generating timing scheduled by the schedule section 277 in the schedule control section 275 by function call. Then, each test module emulation section 270 outputs variation of voltage of the test signal in the cycle time corresponding to the test signal generating timing by calling voltage setting methods (set methods) of the output channel object which emulates the output channel multiple times. Then, after the output of the variation of voltage of the test signal corresponding to the cycle time is finished, the test module emulation section 270 notifies the schedule section 277 and the like that the output of the variation of voltage of the test signal corresponding to the cycle time has been finished by calling the end methods of the output channel object. An example of such implementation is described further below in supplementary information B.3.3 and the like.

Then, the schedule section 277 calculates a period during which all the test module emulation sections 270 finishes the output of the variation of the voltage of the test signal based on the end methods notified from each of the plurality of test module emulation sections 270, and makes demands on the DUT simulating section 200 for the simulation of the operation of the DUT 100 during the period. In response, the DUT connection unit 280 acquires the test signal during the period, and simulates the operation of the devices under test based on the test signal. As stated above, after the end methods are called, the output channel object forbids varying the voltage in the period during which the output of the variation of the voltage of the test signal is finished, the variation of the voltage being notified by the end methods. Thereby, the inconsistency of the simulation result which has been already simulated can be prevented. An example of such implementation is described further below in supplementary information B.3.4 and the like.

Described blow is the supplementary information on various kinds of examples and specifications for realizing the test apparatus 10 and the test emulator 190 according to the present embodiment.

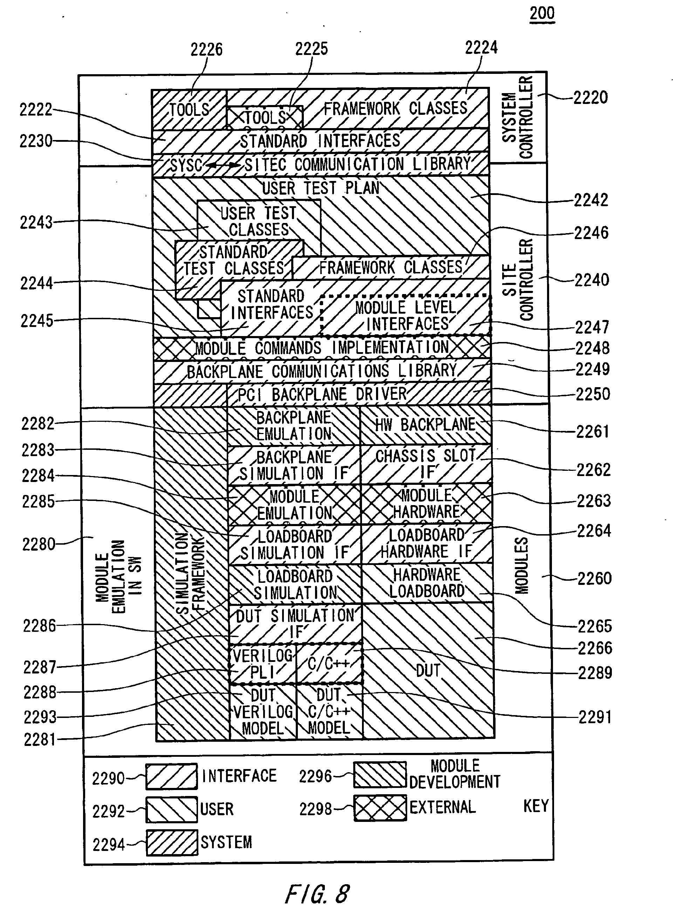

Supplementary information A: An Example of software architecture Fig. 8 illustrates software architecture 2200 according to an embodiment of the present invention. The software architecture 2200 represents a distributed operating system, having elements for the system controller 2200, at least one site controller 2240, and at least one module 2260 in correspondence to related hardware system elements 110, 130, 150, 160 and 170. In addition to the module 2260, the architecture 2200 includes a corresponding SW (software) module emulation 2280.

As an exemplary choice, the development environment for this platform can be based on Microsoft Windows. The use of this architecture has side benefits in program and support portability (e.g., a field service engineer could connect a laptop which runs the tester operating system to perform advanced diagnostics). However, for large compute-intensive operations (such as test pattern compiles), the relevant software can be made as an independent entity capable of running independently to allow job scheduling across distributed platforms. Related software tools for batch jobs are thus capable of running on multiple platform types.

As an exemplary choice, ANSI/ISO standard C++ can be taken as the native language for the software. Of course, there are a multitude of options available (to provide a layer over the nominal C++ interfaces) that allows a third party to integrate into the system with an alternative language of its own choice.

Fig. 8 illustrates a shading of elements according to their organization by nominal source (or collective development as a sub-system) including the tester operating system interfaces 2290, user components 2292 (e.g., supplied by a user for test purposes), system components 2294 (e.g., supplied as software infrastructure for basic connectivity and communication), module development components 2296 (e.g., supplied by a module developer), and external components 2298 (e.g., supplied by external sources other than module developers).

From the perspective of source-based organization, the tester operating system (TOS) interface 2290 include: System Controller to Site Controller interfaces 2222; framework classes 2224; Site Controller to Module interfaces 2245; framework classes 2246, predetermined module-level interfaces 2247, backplane communications library 2249, chassis slot IF (Interface) 2262, loadboard hardware IF 2264, backplane simulation IF 2283, loadboard simulation IF 2285, DUT simulation IF 2287, Verilog PLI (programming language interface) 2288 for DUT's Verilog model and C/C++ language support 2289 for DUT's C/C++ model.

User components 2292 include: a user test plan 2242, user test classes 2243, hardware loadboard 2265, and DUT 2266, a DUT Verilog model 2293 and a DUT C/C++ model 2291.

System components 2294 include: system tools 2226, communications library 2230, test classes 2244, a backplane driver 2250, HW backplane 2261 including the bus switch 140, simulation framework 2281, backplane emulation 2282, and loadboard simulation 2286.

Module-development components 2296 include: module commands implementation 2248, module hardware 2263, and module emulation 2284.

External components 2298 include external tools 2225.

The system controller 2200, which is software operated on the test sites 2110 illustrated in Fig. 1, includes interfaces 2222 to site controller, framework classes 2224, system tools 2226, external tools 2225, and a communications library 2230. The System Controller software is the primary point of interaction for the user. It provides the gateway to the Site Controllers of the embodiment, and synchronization of the Site Controllers in a multi-site/DUT environment as described in U.S. application no. 60/449,622 by the same assignee. User applications and tools, graphical user interface (GUI)-based or otherwise, run on the System Controller. The System Controller also may act as the repository for all Test Plan related information, including Test Plans, test patterns and test parameter files. A test parameter file contains parameterization data for a Test class in the object oriented environment of an embodiment of the embodiment.

Third party developers can provide tools in addition to (or as replacements for) the standard system tools 2226. The standard interfaces 2222 on the System controller 2200 include interfaces that the tools use to access the tester and test objects. The Tools (applications) 2225, 2226 allow interactive and batch control of the test and tester objects. The tools include applications for providing automation capabilities (through, for example, the use of SECS/TSEM, etc.)

The Communications library 2230 residing on the system controller 2200 provides the mechanism to communicate with the Site Controllers 2240 in a manner that is transparent to user applications and test programs.

The Interfaces 2222 resident in memory associated with the System controller 2200 provide open interfaces to the framework objects that execute on the System Controller. Included are interfaces allowing the Site Controller-based module software to access and retrieve pattern data. Also included are interfaces that applications and tools use to access the tester and test objects, as well as scripting interfaces, which provide the ability to access and manipulate the tester and test components through a scripting engine. This allows a common mechanism for interactive, batch and remote applications to perform their functions.

The Framework Classes 2224 associated with the System controller 2200 provide a mechanism to interact with these above-mentioned objects, providing a reference implementation of a standard interface. For example, the site controller 2240 of the embodiment provides a functional test object. The system controller framework classes may provide a corresponding functional test proxy as a remote system controller-based surrogate of the functional test object. The standard functional test interface is thus made available to the tools on the system controller 2200. The system, module-development and interface components 294, 296 and 290, respectively, may be considered an operating system distributed between the system controller and the site controllers. The framework classes effectively provide an operating system interface associated with the host system controller. They also constitute the software elements that provide the gateway to the Site Controllers, and provide synchronization of the Site Controllers in a multi-site/DUT environment. This layer thus provides an object model in an embodiment of the invention that is suitable for manipulating and accessing Site Controllers without needing to deal directly with the Communications layer.

The site controller 2240, which is software operated on the site controllers 130 illustrated in Fig. 1, hosts a user test plan 2242, user test classes 2243, standard test classes 2244, standard interfaces 2245, site controller framework classes 2246, module high level command interfaces (i.e., predetermined module-level interfaces) 2247, module commands implementation 2248, backplane communications library 2249, and a backplane driver 2250. Preferably most of the testing functionality is handled by the site controllers 2104/2240, thus allowing independent operation of the test sites 2110.

A Test plan 2242 is written by the user. The plan may be written directly in a standard computer language such as C++, or described in a higher level test programming language to produce C++ code, which can then be compiled into the executable test program.

The test plan creates test objects by using the Framework Classes 2246 and/or standard or user supplied Test Classes 2244 associated with the site controllers, configures the hardware using the Standard Interfaces 2245, and defines the test plan flow. It also provides any additional logic required during execution of the test plan. The test plan supports some basic services and provides an interface to the services of underlying objects, such as debug services (e.g., break-pointing), and access to underlying framework and standard classes.

The Framework classes 2246 associated with the site controllers are a set of classes and methods that implement common test-related operations. The site controller-level framework includes, for example, classes for power supply and pin electronics sequencing, setting level and timing conditions, obtaining measurements, and controlling test flow. The framework also provides methods for runtime services and debugging. The framework objects may work through implementing the standard interfaces. For example, the implementation of the TesterPin framework class is standardized to implement a general tester pin interface that test classes may use to interact with hardware module pins.

Certain framework objects may be implemented to work with the help of the module-level interfaces 2247 to communicate with the modules. The site controller framework classes effectively act as a local operating system interface supporting each site controller.

In general more than ninety percent of the program code is data for the device test, and the remaining ten percent of the code realizes the test methodology. The device test data is DUT-dependent (e.g., power supply conditions, signal voltage conditions, timing conditions, etc.). The test code consists of methods to load the specified device conditions on to ATE hardware, and also those needed to realize user-specified objectives (such as datalogging). The framework of an embodiment of the invention provides a hardware-independent test and tester object model that allows the user to perform the task of DUT test programming.

To increase the reusability of test code, such code may be made independent of any device-specific data (e.g., pin name, stimulus data, etc.), or device-test-specific data (e.g., conditions for DC units, measurement pins, number of target pins, name of pattern file, addresses of pattern programs). If code for a test were compiled with data of these types, the reusability of the test code would decrease. Therefore, according to an embodiment of the invention, any device-specific data or device-test-specific data may be made available to the test code externally, as inputs during code execution time.

In an embodiment of the invention, a Test Class, which is an implementation of a standard test interface, denoted here as ITest, realizes the separation of test data and code (and hence, the reusability of code) for a particular type of test. Such a test class may be regarded as a "template" for separate instances of itself, which differ from each other only on the basis of device-specific and/or device-test-specific data. Test classes are specified in the test plan file. Each Test class typically implements a specific type of device test or setup for device test. For example, an embodiment of the invention may provide a specific implementation of the ITest interface, for example, FunctionalTest, as the base class for all functional tests for DUTs. It provides the basic functionality of setting test conditions, executing patterns, and determining the status of the test based on the presence of failed strobes. Other types of implementations may include AC and DC test classes, denoted here as ACParametricTests and DCParametricTests.

All test types may provide default implementations of some virtual methods (e.g., init(), preExec(), and postExec ()). These methods become the test engineer's entry points for overriding default behaviour and setting any test-specific parameters. However, custom test classes can also be used in test plans.

Test classes allow the user to configure class behaviour by providing parameters that are used to specify the options for a particular instance of that test. For example, a FunctionalTest may take parameters PList and TestConditions, to specify the Pattern List to execute, and the Level and Timing conditions for the test, respectively. Specifying different values for these parameters (through the use of different "Test" blocks in a test plan description file) allows the user to create different instances of a Functional Test. Figure 4 illustrates how different test instances may be derived from a single test class. A Template Library may be employed as the general-purpose library of generic algorithms and data structures. This library may be visible to a user of the tester, so that the user may, for example, modify the implementation of a test class to create a user-defined test class.

As to user-developed test classes, an embodiment of the system supports integration of such test classes into the framework in that all test classes derive from a single test interface, e.g., ITest, so that the framework can manipulate them in the same way as the standard set of system test classes. Users are free to incorporate additional functionality into their test classes, with the understanding that they have to use custom code in their test programs to take advantage of these additional facilities.

Each test site 2110 including the site controller 130, the synchronous module 150, the synchronous connection module 160 and the test module 170 is dedicated to testing one or more DUTs 100, and functions through a configurable collection of test modules such as the test module 170. Each test module is an entity that performs a particular test task. For example, a test module could be a DUT power supply, a pin card, an analogue card, etc. This modular approach provides a high degree of flexibility and configurability.

The Module Commands Implementation classes 2248 may be provided by module hardware vendors, and implement either the module-level interfaces for hardware modules, or provide module-specific implementations of standard interfaces, depending on the commands implementation method chosen by a vendor. The external interfaces of these classes are defined by pre-determined module level interface requirements, and backplane communication library requirements. This layer also provides for extension of the standard set of test commands, allowing the addition of methods (functions) and data elements.

The Backplane Communications Library 2249 provides the interface for standard communications across the backplane, thereby providing the functions necessary to communicate with the modules connected to the test site. This allows vendor-specific module software to use a Backplane Driver 2250 to communicate with the corresponding hardware modules. The backplane communications protocol may use a packet based format.

Tester Pin objects represent physical tester channels and derive from a tester pin interface, denoted here as ITesterPin. The software development kit (SDK) of an embodiment of the invention provides a default implementation of ITesterPin, which may be called TesterPin, which is implemented in terms of a predetermined module-level interface, IChannel. Vendors are free to make use of TesterPin if they can implement their module's functionality in terms of IChannel; otherwise, they must provide an implementation of ITesterPin to work with their module.

The standard module interface, denoted here as IModule, provided by the tester system of the embodiment generically represents a vendor's hardware module. Vendor-supplied module-specific software for the system may be provided in the form of executables such as dynamic link libraries (DLLs). Software for each module-type from a vendor may be encapsulated in a single DLL. Each such software module is responsible for providing vendor-specific implementations for the module interface commands, which comprise the API for module software development.

There are two aspects of the module interface commands: first, they serve as the interface for users to communicate (indirectly) with a particular hardware module in the system, and second, they provide the interfaces that third-party developers can take advantage of to integrate their own modules into the site controller level framework. Thus, the module interface commands provided by the framework are divided into two types:

The first, and most obvious, are those "commands" exposed to the user through the framework interfaces. Thus, a tester pin interface (ITesterPin) provides methods to get and set level and timing values, while a power supply interface (IPowerSupply) provides methods for powering up and powering down, for example.

In addition, the framework provides the special category of the predetermined module-level interfaces, which can be used to communicate with the modules. These are the interfaces used by framework classes (i.e., "standard" implementations of framework interfaces) to communicate with vendor modules.

However, the use of the second aspect, the module-level interfaces, is optional. The advantage of doing so is that vendors may then take advantage of the implementations of classes such as ITesterPin and IPowerSupply, etc. while focusing on the content of specific messages sent to their hardware by implementing the module-level interfaces. If these interfaces are inappropriate to the vendor, however, they may choose to provide their custom implementations of the framework interfaces (e.g., vendor implementations of ITesterPin, IPowerSupply, etc.). These would then provide the custom functionality that is appropriate for their hardware.

The integration of module-specific vendor software can thus be accomplished through two different means: custom implementation of relevant framework classes and interfaces, or custom implementation of the special category of module level interfaces.

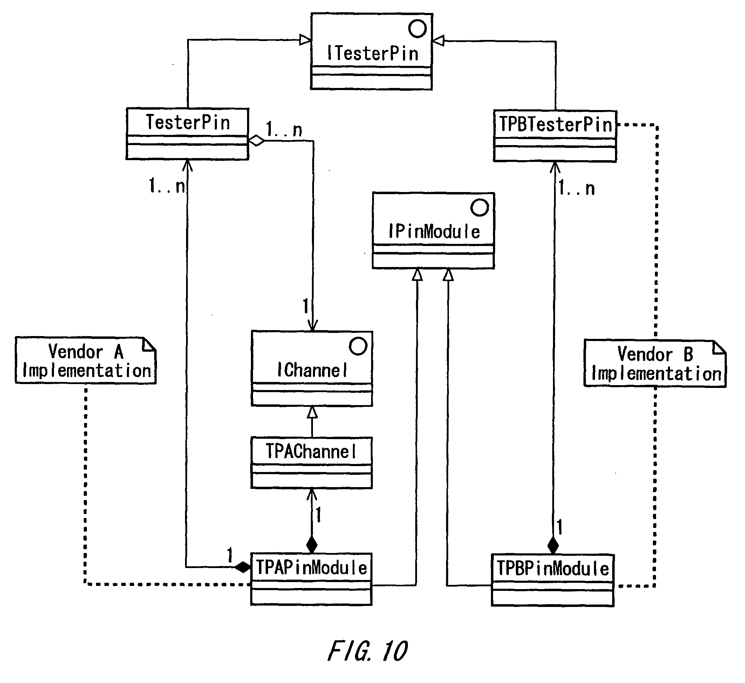

An example application of both methods is next presented with the aid of Fig. 10, which is a Universal Modelling Language (UML) class diagram depicting the interaction of the tester system of an embodiment of the invention and vendor-supplied modules.

A vendor of a new digital module, Third Party A (TPA), provides a software module to communicate with its hardware module. This software module will implement the standard interface, IModule. Let this module object be called TPAPinModule. The vendor TPA is able to make use of the standard system implementation of the ITesterPin interface, denoted here as TesterPin, by implementing the relevant predetermined module-level interface - in this case, IChannel - in its module. This is made possible by the fact that TesterPin uses standard predetermined module-level interfaces, such as IChannel, to communicate with modules. Therefore, TPAPinModule provides pins by simply creating and exposing TesterPin objects.

Now consider a different vendor, Third Party B (TPB), who decides that the IChannel interface does not work well with its hardware. Therefore, TPB needs to provide not only its own IModule implementation (TPBPinModule), but also an implementation of the ITesterPin interface, TPBTesterPin.

This approach gives third party developers a great deal of flexibility in choosing how to develop their hardware and supporting software. While they are required to implement the IModule interface, they may choose to implement module level interfaces or implement objects like TesterPins, as they see fit.

In fact, vendors may choose to implement TesterPins in order to provide extensions that are not supported in the ITesterPin interface. The framework will provide users a mechanism for retrieving a specific interface or implementation pointer to an object. This means that when user code has an ITesterPin pointer, the framework will be able to determine if it is pointing to, say, a TPBTesterPin object if it needs to. (Note that this feature may be provided via standard C++ Run Time Type Identification (RTTI).) In other words, when the test plan calls on the ITesterPin interface, the interface may, in turn, directly invoke the vendor's tester pin implementation of the TesterPin class, which incorporates module-specific information (e.g., addresses of registers to be set to provide a particular DUT stimulus).

In summary, while the framework code will always use the ITesterPin interface, users are free to make use of specific features and extensions provided by module vendors as needed. In other words, a module vendor can, for example, add methods (functions) to the standard system implementation of the class. The tradeoff for the user is that taking advantage of specific vendor extensions makes the test code less useable with other vendors' modules.

At the modular level, the test apparatus 10 nominally has two modes of operation. In an online mode of operation, module elements 2260 (e.g., hardware elements), which include the bus switch 140, the synchronous module 150, the synchronous connection module 160, the test module 170, the load board 180 and the DUT 100, are used, and in an offline mode of operation module emulation in software 2280, which includes the bus switch emulation section 240, the synchronous module emulation section 250, the synchronous connection module emulation section 260, the test module emulation section 270, the schedule control section 275, the DUT connection section 280, and the DUT simulating section 200, is used.

For the online mode of operation, the module element 2260 includes HW (hardware) backplane 2261 including the bus switch 140 illustrated in Fig. 1, chassis slot IF (Interface) 2262, module hardware 2263 including the synchronous module 150, the synchronous connection module 160, the test module 170 and the like, loadboard hardware IF 2264, hardware loadboard 2265 which corresponds to the load board 180, and DUT 2266 which corresponds to the DUT 100 illustrated in Fig. 10.

For the offline mode of operation, the module emulation in software 2280 includes a simulation framework 2281 including the schedule control section 275 illustrated in Fig. 2, backplane emulation 2282 including the bus switch emulation section 240, backplane simulation IF 2283, module emulation 2284 including the synchronous module emulation section 250, the synchronous connection module emulation section 260, the test module emulation section 270 and the like, loadboard simulation IF 2285, loadboard simulation 2286 including the DUT connection section 280, and DUT simulation IF 2287. Two models are shown for DUT simulation. A model using Verilog includes the Verilog PLI (Programming Language Interface) 2288 and a DUT Verilog model 2293. A model using C/C++ includes C/C++ language support 2289 and a DUT C/C++ model 2291. Note that the simulation can be performed on any computer, e.g., a PC.

In the online mode, the Module vendors provide physical hardware components to support testing, such as digital tester channels, DUT power supplies, or DC measurement units. The modules interface to the HW backplane 2261 through the chassis slot IF 2262.

For offline work, a PC-based or other environment that runs the equivalent of the System Controller would, additionally, undertake all the responsibilities of providing the Site Controller-level framework and runtime environment for the lower layers of software, as well as emulating hardware.

The backplane emulation 2282 provides a software surrogate for the physical backplane 2261. This communicates with the (vendor-supplied) module emulation software 2284 through the backplane simulation interface 2283.

The module emulation software 2284 is preferably provided by the module vendor, and is typically closely tied with a particular vendor implementation of a module 2263. Thus, the module emulation software will typically differ in the details across modules supplied by different vendors. In this case, the module simulation allows the vendor to expose hardware functionality through a software model (e.g., the module emulation software 2284), send stimulation signals to the simulated loadboard 2286, and receive and process DUT response signals from the simulated loadboard 2286, which is connected to DUT modelling software 2291, 2293 through the DUT simulation IF 2287. In some cases, vendors may find it advantageous to provide a simple functional simulation of the module and bypass emulation of the module firmware. The module emulation software compares the response of the simulated DUT to the simulated-module stimulation signals with a known good DUT response. Based on this comparison, the software determines whether the test being executed by the module meets its goal of testing the DUT as desired, and helps the user to debug the module prior to using it on an IC (physical DUT) on the online physical tester.

The loadboard simulation interface 2285 serves as the conduit for signals to and from the module emulation layer and the simulated loadboard 2286. The loadboard simulation component 2286 supports device socket mapping and signal propagation to and from the DUT simulation IF 2287.

The DUT simulation may be a native code (i.e., C/C++) simulation 2291, or a Verilog Programming Language Interface (PLI) to a functional model of the target device under test 2293. The model interfaces with the simulated loadboard through the DUT simulation interface 2287.

Note that the overall control of these layers is provided by the simulation framework 2281. The simulation framework measures the simulated DUT response to known stimulation signals. The method of system emulation is disclosed in U.S. application no. 10/403,817.

Communication and Control

Communication and control are carried out through management of related software objects. Preferably, a communications mechanism is hidden behind an object model on the system controller. This object model provides a proxy to the classes and objects found on the site controller and thereby provides a convenient programming model for application development (e.g., IC device testing). This allows application developers (e.g., users of the ATE system) to avoid unnecessary details related to the specifics of communications between the application and the Site/System controllers.

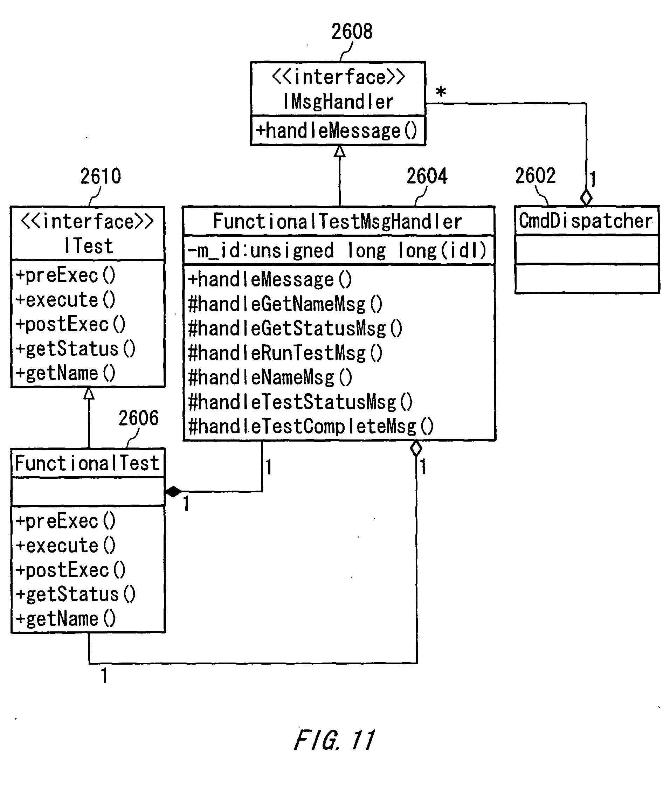

Fig. 11 illustrates a specific embodiment of a site controller object as maintained in site controller software 2240 of the site controller 130. The site controller object includes CmdDispatcher 2602, FunctionalTestMsgHandler 2604 and FunctionalTest 2606. Interfaces include IMsgHandler 2608 and ITest 2610.

The site controller software 2240 preferably contains all of the functional classes that an application may need for access. These classes may, for example, include Tests, Modules, Pins, etc. Since the user's tests and software tools typically reside on different computers, messages will be sent from the tools on the System Controller to a server on the Site Controller. This server will call a method on a Command Dispatch object.

The Command Dispatch object (CmdDispatcher) 2602 maintains a map of message handler objects, which implement the IMsgHandler interface 2608. Fig. 11 illustrates a specific implementation of IMsgHandler, Functional-TestMsgHandler 2604. Messages received by the CmdDispatcher object 2602 contain an identifier of the object to be communicated with. This identifier is found in an internal map, which resolves to the specific implementation, in this case the FunctionalTestMsgHandler object 2604 shown.

In this example, IMsgHandler 2608 consists of a single method, handleMessageO. This method is preferably implemented as a single implementation class. In the case shown, the FunctionalTestMsgHandler 2604 will forward the message on to one of six methods depending on the exact nature of the incoming message. The header of the incoming message contains a message id which allows the message handler to decide how to interpret and where to forward the message.

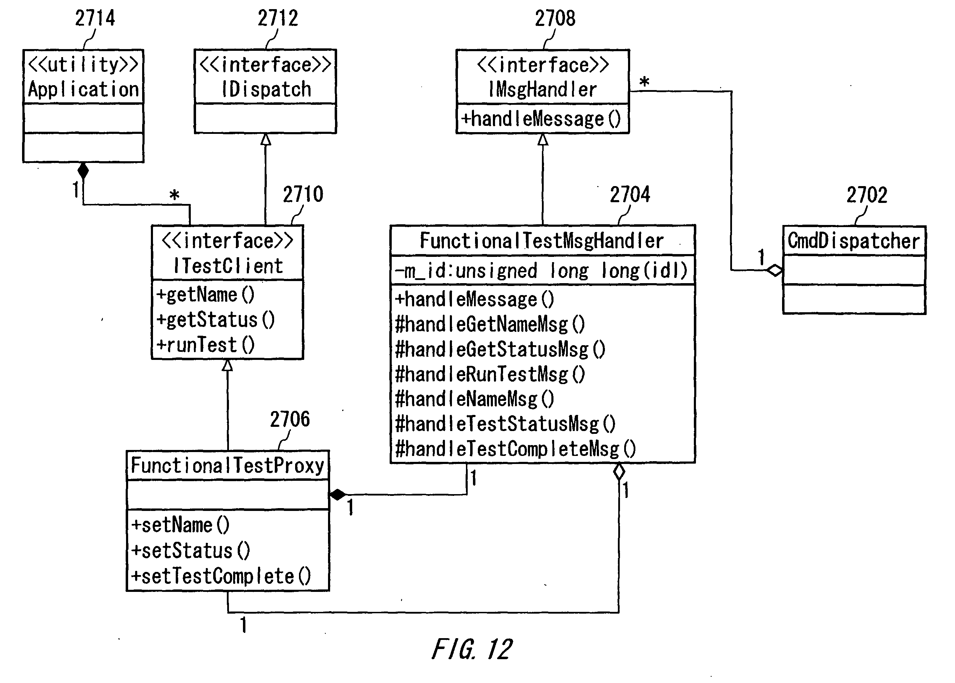

The corresponding communications environment at the system controller 110 relates to the tools 2225, 2226 section of the system controller software 2220. Fig. 12 illustrates an embodiment of a tool object (or system controller object) maintained on the system controller 110 in system controller software 2220 in correspondence to the site controller object shown in Fig. 11. The tool object includes an object CmdDispatcher 2702, FunctionalTestMsgHandler 2704 and Functional TestProxy 2706. Interfaces include IMsgHandler 2708, ITestClient 2710, and IDispatch 2712. Also included is a utility Application 2714.

For this example, the classes CmdDispatcher 2702, IMsgHandler 2708, and FunctionalTestMsgHandler 2704 are the same as in Fig. 11. However, instantiations of FunctionalTest 2606 (or any other site-controller class) are not used. Instead, the tool object has proxy classes for communication with each object on the site controller 130. Therefore, for example, the tool object includes the class FunctionalTestProxy 2706 in the place of FunctionalTest 2606. Similarly, ITestClient 2710 in the tool object is not the same as ITest 2610 in site controller object. In general, applications running on the site controller 130 will not use the exact interfaces as provided on the site controller 130. In this case, three methods of ITest 2610 (namely preExec(), execute(), and postexec()), are replaced with a single method in ITestClient 2710 (namely runTest()). In addition, ITestClient 2710 is a preferably dual interface; that is, it inherits from IDispatch 2712, which is implemented as a Microsoft Component Object Model (COM). It provides an interface that enables a scripting engine to access the object implementing that interface. This allows the system to be scriptable on the Microsoft Windows platform.

As an example for operation of the embodiments shown in Figs. 11-12, an application running on the system controller 110 (e.g., in one of the tools sections 2226, 2228) may communicate with a site controller 130 where a test plan 2242 includes one or more FunctionalTest objects 2606. During initialization of the test plan 2242 on the site controller 130, a corresponding test-plan object is loaded onto the site controller 130, which constructs a TestPlanMessageHandler object and registers it with the CmdDispatcher object 2602. This assigns a unique ID to the message handler. Similar operations occur with other TestPlan objects that make up the test plan 2242.

The application (e.g., in tools 2226, 2228) on the system controller 110 initializes the communication library 2230, connects to the site controller 130 via a communication channel, and gets an ID for the TestPlan object. The library constructs a TestPlanProxy object and initializes it with this ID. During initialization this proxy object determines how many Tests it contains and their types and IDs. It loads the appropriate DLLs for each type (in this case only one type) and constructs the proxy objects for them, initializing them with their ID values.

The Test Proxy objects, in turn, also initialize. To do this they construct appropriate messages to get their names (using their ID values) and send them to a communication server at the site controller 130, which passes the message on to the CmdDispatcher 2602. This object looks up the destination IDs in its internal map and forwards the message on to the handleMessage() methods of the FunctionalTestMsgHandler objects 604. For example, if the message was a request to obtain test names, these objects get their respective test's names and reply to the application's Test Proxy objects with the appropriate name strings.

After initialization has completed, the application has remote access to a TestPlan object and through it, both Test objects. The user may now presses for example, a "Run Test Plan" button on the application. As a result, the application calls the RunTestPlan() method on the Test Plan Proxy object. This method constructs a RunTestPlan message with the destination ID of the Test Plan object and calls the sendMessage() function on the RPC proxy, which sends the message to the Site Controller.

The communication server on the site controller 104 calls the handlemessage() method on the CmdDispatcher object 2602 passing it the ID of the Test Plan object. The CmdDispatcher object 2602 looks up this ID in its internal map, finding the message handler for the TestPlan object and calls the handleMessage() method on this object, which, in turn, calls the RunTestPlan() method on the TestPlan object. In a similar manner, the application can get the names and last run status of the Test objects.

Method for Using the Communication Library

The following is an example use of the communications library 2230.

The communication library 2230 is preferably a static library. An application can use this communication library through a CommLibrary.h file. An application that needs to export the communication library classes should have the preprocessor definitions COMMLIBRARY_EXPORTS, COMMLIBRARY_FORCE_LINKAGE defined in addition to including the above include file. An application that imports the communication library need not define any preprocessor definitions. When the communication library is used as server, the application has to call the following static function of CcmdDispatcher: InitializeServerunsigned long portNo).

The portNo is the portNo on which the server should be listening. The command dispatcher corresponding to the server can be retrieved by calling the static function: getServerCmdDispatcher on the CCmdDispatcher class.

When the communication library is used as client the application should call the static function "InitializeClientconst(const OFCString serverAddress, unsigned long serverPortNo, CcmdDispatcher **pCmdDispatcher, OFCString serverId)".

The serverAddress and ServerPortNo to which the client has to connect. This function initializes the command dispatcher pointer for the client and serverId to which it has connected. Also at a later point of time the client can retrieve the command dispatcher corresponding to the serverId by calling the static function getClientCmdDispatcher.

When the communication library is being compiled, the build has been excluded on the files ClientInterface.idl and ServerInterface.idl. The preferred embodiment applies the already generated stub and proxy files for these interface definition files to link the proxy and stub implementation files into the same library. Hence, the server and client can be instantiated in the same address space. The following changes in the interface definition files and stub files are preferably made to make the communication library work as server and client in the same address space.

Changes in Interface Definition Files

The following namespace declaration is preferably added in each of the interface definition files. This is to avoid the name collision between the proxy implementation functions and our own implementation of the interface functions. The following namespace declaration is added in the serverInterface.idl.

The functions in the stub implementation file is changed to call our own implementation functions for the functions that are declared in the interfaces i.e. we have a different named function corresponding to each of the functions that are declared in the interfaces.

In order to avoid the conflict in function call, it is preferable to prefix the implementation functions names with "COMM_" string. So the code in the stub functions is changed to call "COMM_functionName" instead of "functionName".

For this method to work, all the functional classes that exist, should also have their corresponding message handler object and Proxy classes. All message handler objects should derive from IMsgHandler class provided by the communication library. IMsgHandler class is an abstract class. It is preferably the responsibility of the implementer of the message handler to provide a definition for the handleMessage, setObjectId, handleError. All the message types should start from one (we reserve zero for handleError). The functional class preferably have their corresponding message handler as their member variable. In the constructor of the functional class, the functional class should get itself registered with the message handler by calling a function provided by its message handler. Next the message handler object should be registered with the command dispatcher by calling addMsgHandler function on the command dispatcher with the message handler as the parameter. The addMsgHandler function will assign an ID to the message handler and the functional class. The destructor of the functional class should call the removeMsgHandler function on the command dispatcher by sending the function class identifer as parameter. Proxy classes should also follow the same procedure of registration as explained for the functional classes.

System Configurations and Testing

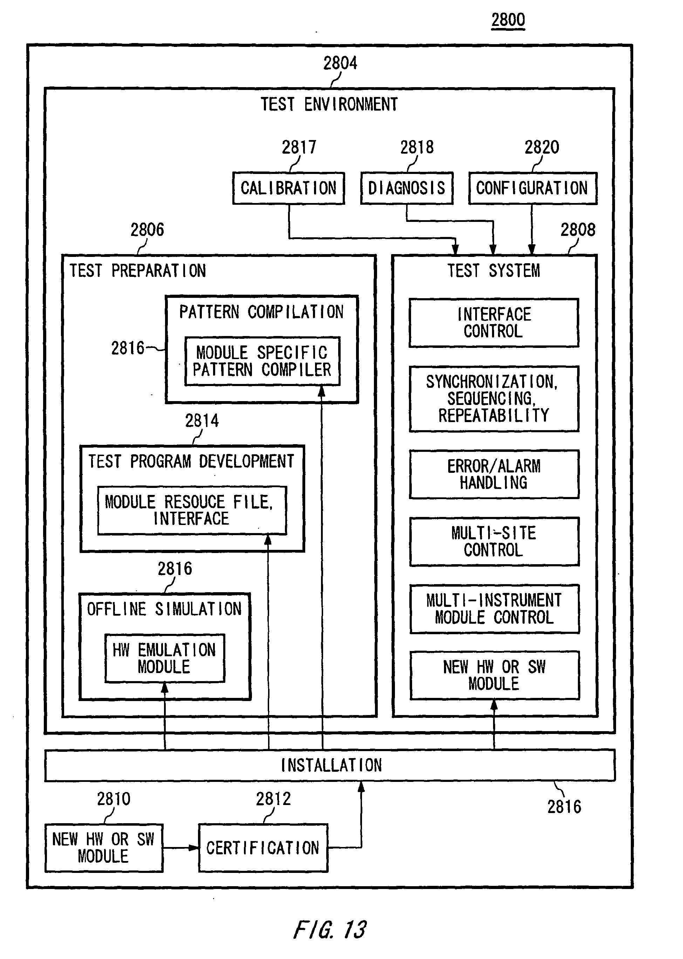

Fig. 13 illustrates a nominal testing sequence 2800 according to an embodiment of the present invention. The testing sequence 2800 includes installation 2815 of modules in a test environment 804 that encompasses test preparation 2806 and system testing 2808. Initially a new module (hardware or software or a combination thereof) 2810 is certified 2812 (by some external procedure possibly based on vendor quality control). Installation 2815 first requires test preparation 2806 including installation of hardware module emulation for offline simulation 2809, installation of module resource files and interfaces for test program development 2814 and installation of module specific pattern compiler for pattern compilation 2816. Next system testing 2808 is carried out with inputs from calibration 2817, diagnostics 2818, and configuration. System testing 2808 then is carried out for the new module including: (1) interface control, (2) synchronization, sequencing and repeatability, (3) error/alarm handling, (4) multi-site control, and (5) multi-instrument module control.

Supplementary Information B: an example of specification of a framework of the system software of the DUT 100.

B.1 Introduction

This specification is a guide for user and developer which describes a framework of system software of the DUT 100 focusing on the emulation environment (offline environment) by the distributed system of the test emulator 190 or the system controller 110, and the site controller 130.

B.2 User's Guide

This chapter is a user's guide which describes the framework of the system software of a test apparatus 10.

B.2.1 SimTester

"SimTester (simulated test apparatus)" is an application program causing the computer 20 to act as the test emulator 190 illustrated in Fig. 2. SimTester loads all module and DUT DLLs and responds to commands from the system software and emulates the test apparatus, where the system software is runtime software to simulate pattern load and execution.

When SimTester is brought up, it loads the Simulation Configuration File. This results in the loading of all Module Emulation DLLs which cause the test emulator 190 as the synchronous module emulation section 250, the synchronous connection module emulation section 260, and the test module emulation section 270. After loading the DLLs, SimTester waits for a connection from the system controller 110. The system controller 110 connects to SimTester when a test plan is loaded. Part of the information in the test plan is the name of the Offline Configuration File. Before the system controller 110 actually loads the test plan data, it sends the Offline Configuration File to SimTester so that it can complete its initialization. A successful load of the Offline Configuration File means that SimTester has loaded the DUT models and has attached them to the module emulator such as the test module emulation section 270 as the DUT connection section 280 and the DUT simulating section 200. At this point the simulation is ready for pattern loading and after that pattern execution.

When a test plan is unloaded, SimTester is signalled to unload the DUT models and wait for a new Offline Configuration File.

B.2.2 Configuration Files

SimTester uses 2 configuration files. The first is the simulation configuration file. This file specifies what tester modules will be available during the simulation. The second file is the offline configuration file. This file specifies what DUT models will be loaded and how they are connected to the tester.

B.2.2.1 Simulation Configuration Files

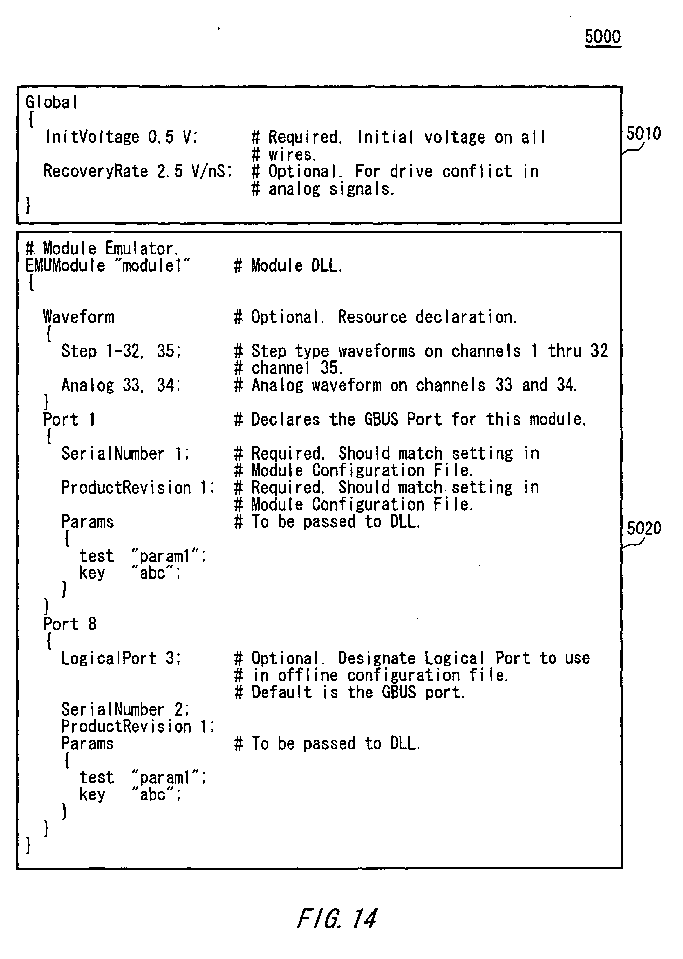

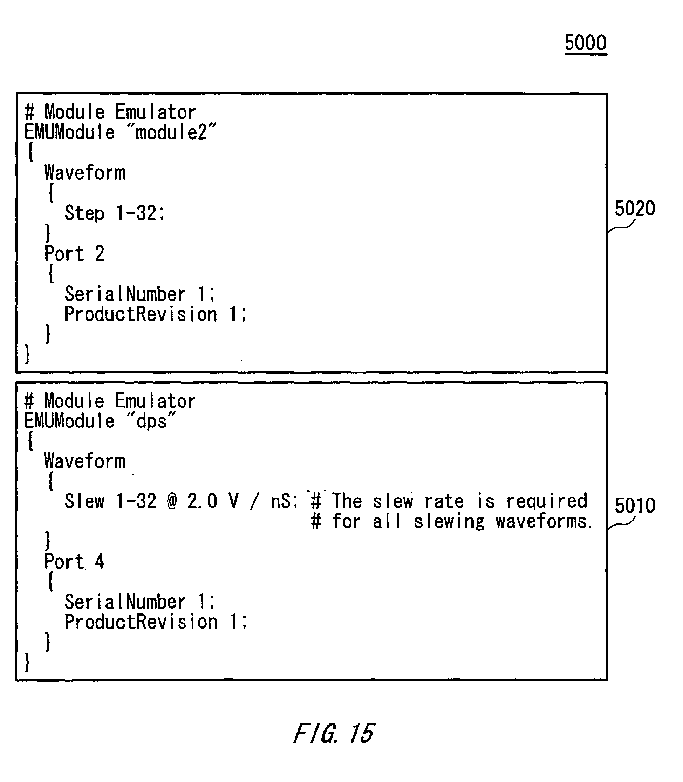

Figs. 14-15 are examples of a simulation configuration file. The file is broken up into hierarchical blocks.

The global section 5010 performs global setting. The InitVoltage parameter is the initial voltage on all the wires in the simulation at the start. Subsequent patterns start with the state left on the wire by the previous pattern.

The RecoveryRate parameter is an optional parameter used to resolve two analogue signals driving against once another. More specifically, the parameter indicates voltage variation per a predetermined time used to determine how long it takes a voltage to achieve its steady state level when this case arises.

The module emulation section 5020 specifies module DLL, and sets up the module DLL.

The Waveform Section declares what types of waveform models are used for each module resource. The waveform model, such as step waveform, slew waveform, analogue waveform or the like, is specified for each channel connecting with a terminal of the DUT

A port section declares instance of the module emulator which causes the test emulator 190 to acts as the synchronous module emulation section 250, the synchronous connection module emulation section 260, the module emulation section 270 and/or the like.

The LogicalPort parameter is provided such that when a module inserted in a channel is replaced to another channel due to the fail of the channel, the LogicalPort parameter keeps about the replacement.

The Params section in the module emulation section 5020 keeps the parameter to be passed to the module DLL.

B.2.2.2 Offline Configuration File

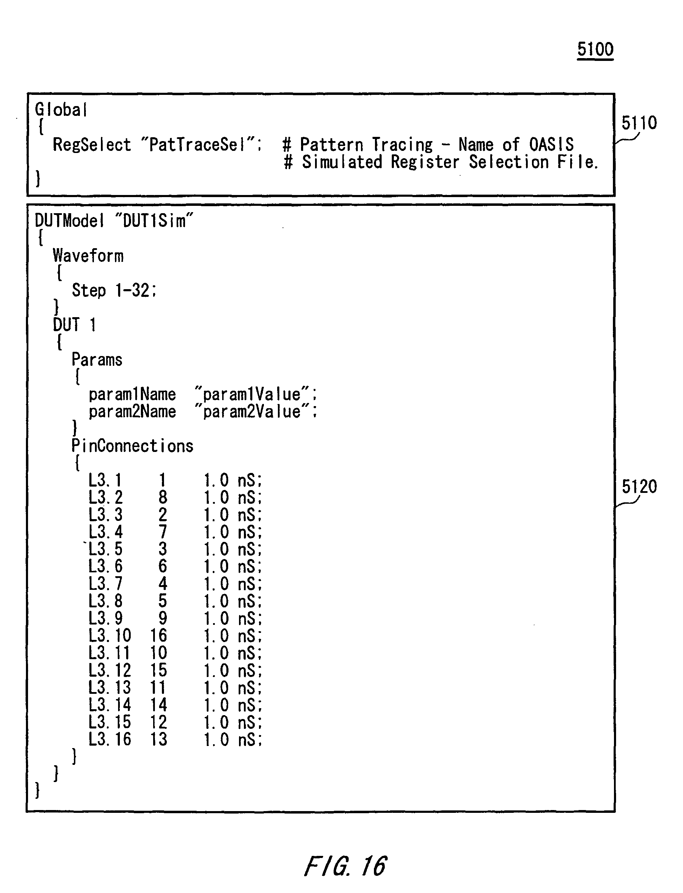

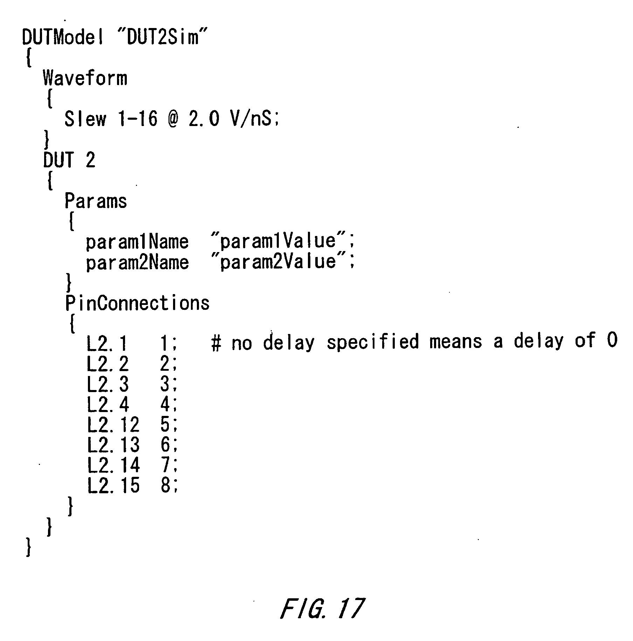

Figs. 16-17 are examples of offline configuration files. The global section 5110 performs an overall setup. RegSelect specifies a file which selects the register to be traced for pattern tracing.

Waveform parameter sets up a waveform model for every terminals of each DUT. DUT block mainly includes Params Block and PinConnections Block.

The PinConnections Block specifies connection between resource of the test apparatus and a terminal of the DUT. For example, "L3.11 10 1.0ns" indicates that Resource 11 of LogicalPort 3 is connected to DUT pin 10, with a transport delay of 1.0 nanoseconds. Here, the LogicalPort is a port where a module is implemented, and the Resource is logic or the like which corresponds to a channel provided in the module etc.

B.3 Developer's Guide

Tester module and DUT models are created by the framework of the module emulation program illustrated in Fig. 5, e.g., by deriving C++ classes from some base classes. The derivation involves implementing a few virtual functions in the base class. In addition, the framework provides some classes that facilitate I/O between tester modules and DUT models. Finally, by implementing the framework, the obtained DLL can be connected to another component in the test emulator 190 to run the emulation.

B.3.1 Offline Framework Class Structure

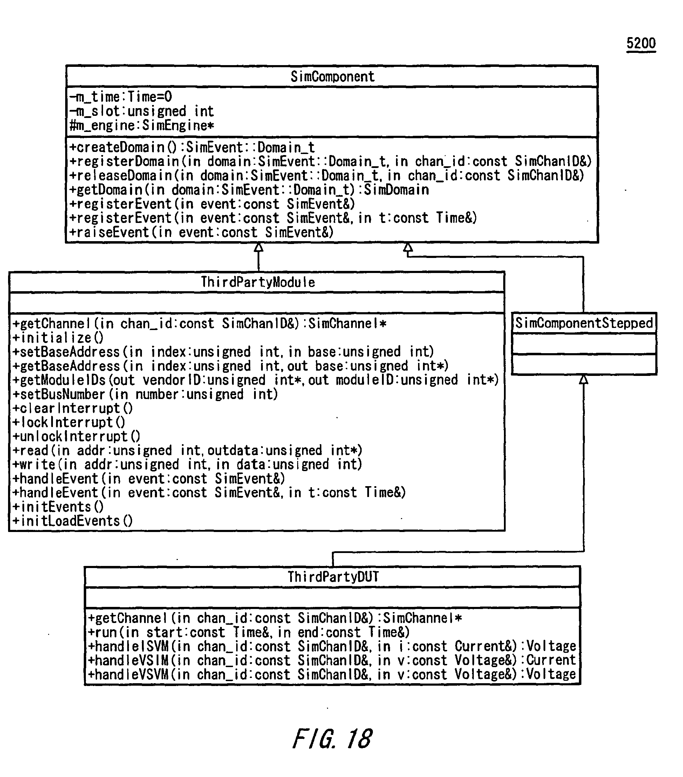

Fig. 18 is a class hierarchical structure 5200 illustrating the detail of the class hierarchical structure illustrated in Fig. 5. Each method in ThirdPartyModule class and ThirdPartyDUT classes are the virtual methods that must be implemented to define the behaviour of the model. The createDomain, registerDomain, releaseDomain, getDomain, registerEvent and raiseEvent methods in the SimComponent base class provides service for accessing the software simulation engine of the DUT 100 which causes the test emulator 190 to acts as the schedule control section 275 or the like.

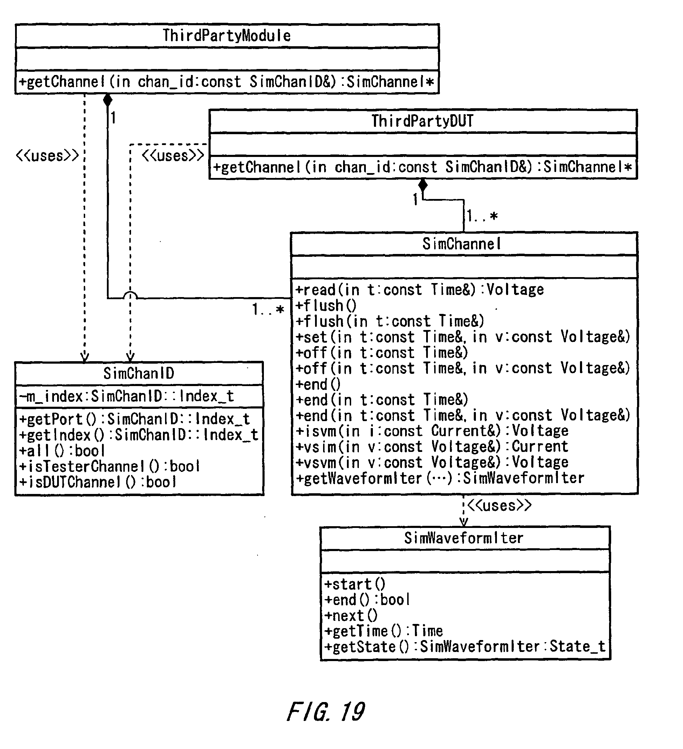

Fig. 19 illustrates a specification diagram of the channel object used as an interface in the framework. Tester modules and DUT models will contain an array of SimChannel objects. Each instance of SimChannel corresponds to an I/O channel for the model. Channels are identified using SimChanID objects. The SimChannel class allows the module or DUT model to write the voltage time history to the output channel, and to read voltages at specific times from input channels. If an input channel needs to be scanned for edges in a time window, then an instance of a Sim WaveformIter can be obtained from the SimChannel::getWaveformIter method. The SimWaveformIter object allows the calling routine to iterate through all the edge in a finite time window.

B.3.2 Implementation of a Tester Module

In this section, implementation of simple digital driver module and digital strobe module will be explained as examples of module implementing method.

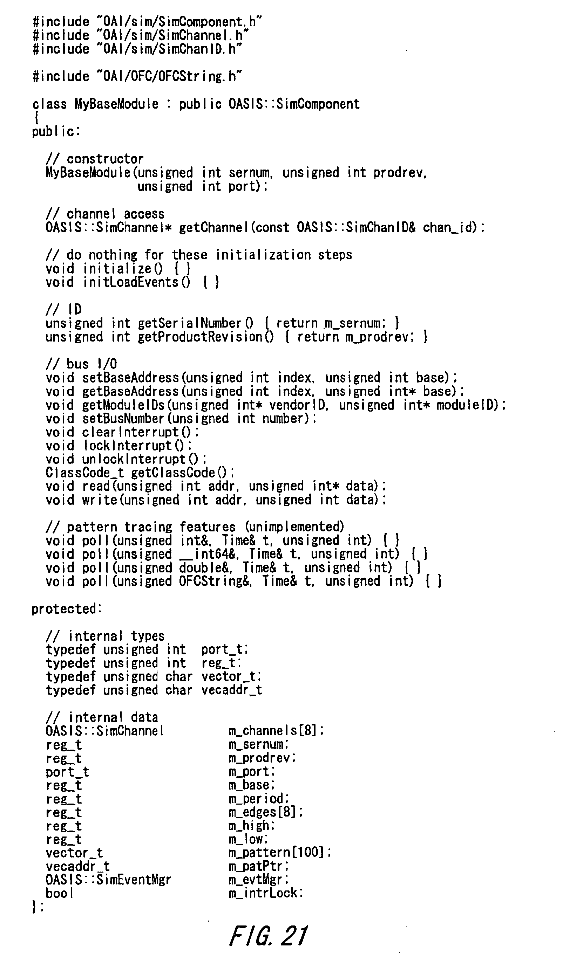

Fig. 21 shows base class of simple digital module as an example of the module of the test apparatus. The class of the digital driver module and the digital strobe module is generated as a derived class of the base class.

The developer implements constructor of the base class, getChannel method which returns the channel object, setBaseAddress which sets up memory address space of the module, setBusNumber method which sets up the slot number of the bus switch 140, lockInterrupt/unlockInterrupt method which sets up lock/unlock of interruption, the read/write method which accesses the memory address space in the modular based on the base class.

B.3.2.1 Local Events

Offline simulation is an event driven process. That is, each module registers events. Then, the handleEvent method of the module of which the event is registered is called.

The events are defined by the SimEvent class and classified into synchronous events and asynchronous events. Asynchronous events are further classified into system events and local asynchronous events. System events are for example, system interruption, end of pattern generation, etc.

B.3.2.1.1 Local Asynchronous Events

Local asynchronous events are used to handle inter-module communications. As the name applies there is no time associated with this event. To indicate that a module wishes to receive a particular asynchronous event, it should register for it through the overloaded registerEvent method that takes no time argument. If a module needs to raise an event, the raiseEvent method should be invoked. Note that the event object supports arguments to be added to an event. The receiving module should handle asynchronous events in the overloaded handleEvent method that has no time argument.

B.3.2.1.2 Local Synchronous Events

The most common type of event used is the local synchronous event (or simply synchronous event). These events are used by modules to schedule read or write (drive or strobe for digital modules) events. Synchronous events are only used by a module to receive notification at a specific time, and are never used for inter-module communications.

B.3.3 Simple Digital Driver Module

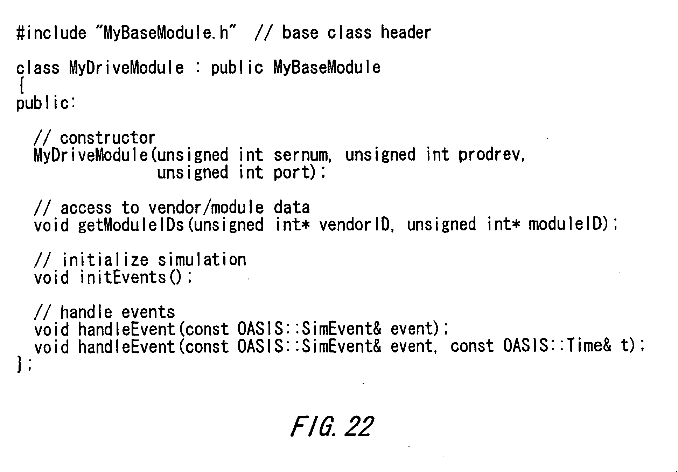

Fig. 22 illustrates class declaration of a simple digital driver module. The developer implements getModuleIDs method which returns information on the constructor and vendor/module of the class, and initEvents method which initializes the driver module.

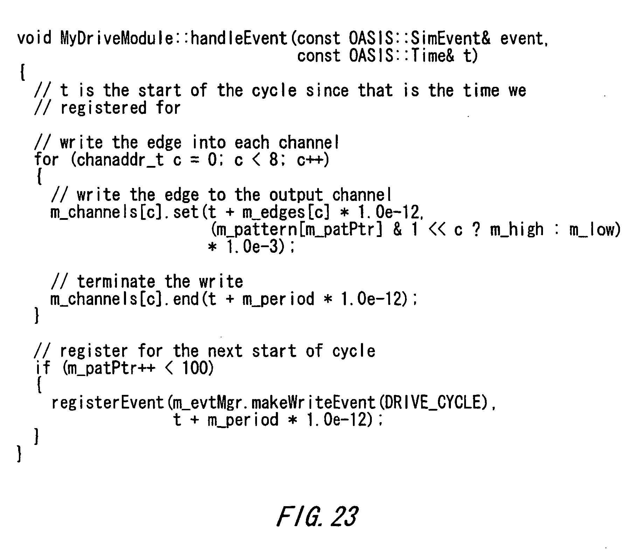

Fig. 23 is an example of the handleEvent method of the digital driver module. The drive module writes edges for all the channels in the current cycle. This writing is performed by the set method in each element of m_channels, which is an array of SimChannel objects. In addition to the set method, the SimChannel objects include off method and end method. The off method stops drive of the signal. The end method notifies the framework that the generation of the signal during a predetermined period, e.g., cycle period, is finished. On receiving the notification, a signal which instructs read-out of a channel is sent to a component opposite from the channel. e.g., to the DUT connection unit 280. Consequently, the generated signal is read by the component. Typically, in order to generate and transfer the signal during the predetermined period, the user will make several set-method calls to specify the voltage over a time range, and then call end method once at the end of the predetermined period. The relation between the set method and the end method will be described in detail in B.3.4.

B.3.4 Simple Digital Strobe Module

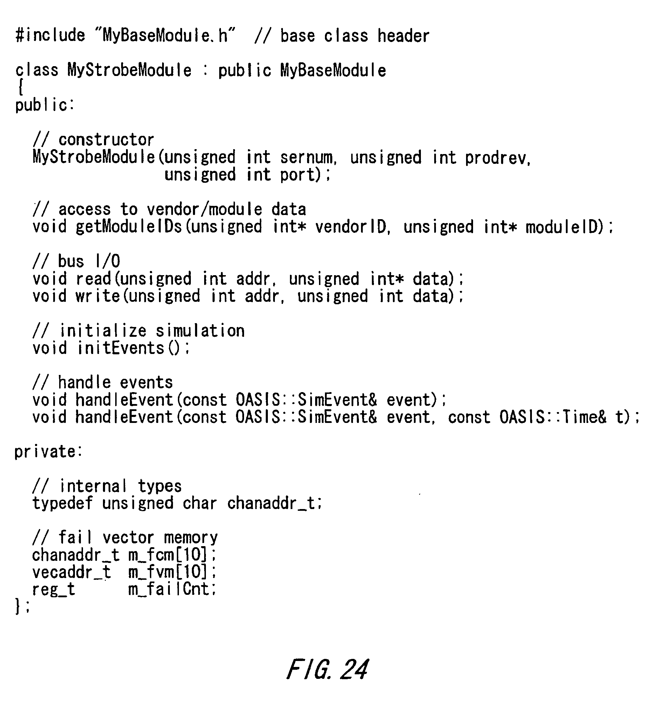

Fig. 24 shows class declaration of a simple digital strobe module. The developer implements constructor, getModuleID method, initEvents method, etc., in a similar manner to the digital driver module. As for the digital strobe module, since the comparison result of the output value of the DUT and an expected value is stored in fail memory, read and write methods are changed.

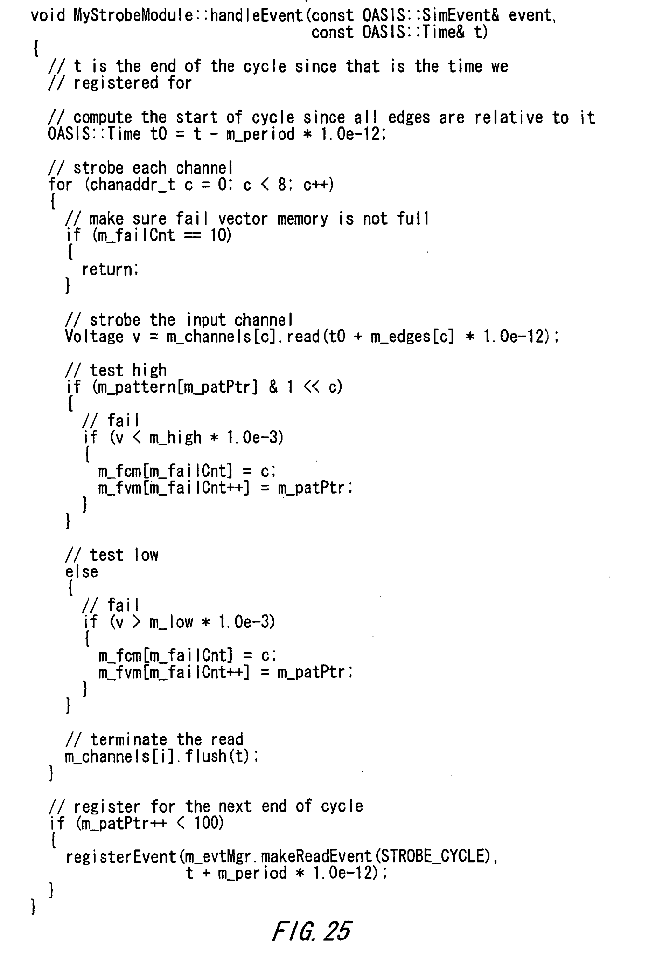

Fig. 25 is an example of the handleEvent method of the digital strobe module.

A digital strobe module reads the voltage of the channel in specific timing using the read method of the Sim-

Channel. Then, after finishing the processing during the cycle period, it request the SimEventMgr object to create an event by sending the end timing of the next cycle, then the event is registered by the registerEvent method.

B.3.4 Implementation of a DUT Model

DUT modelling uses the same approach as tester modules; however, the simulation of DUTs is not event driven. Hence, SimComponentStepped the base class for DUT models, supplies implementations for initEvents, handleEvent, and bus I/O methods. Instead the function run must be implemented to define the DUT model behaviour during pattern execution.

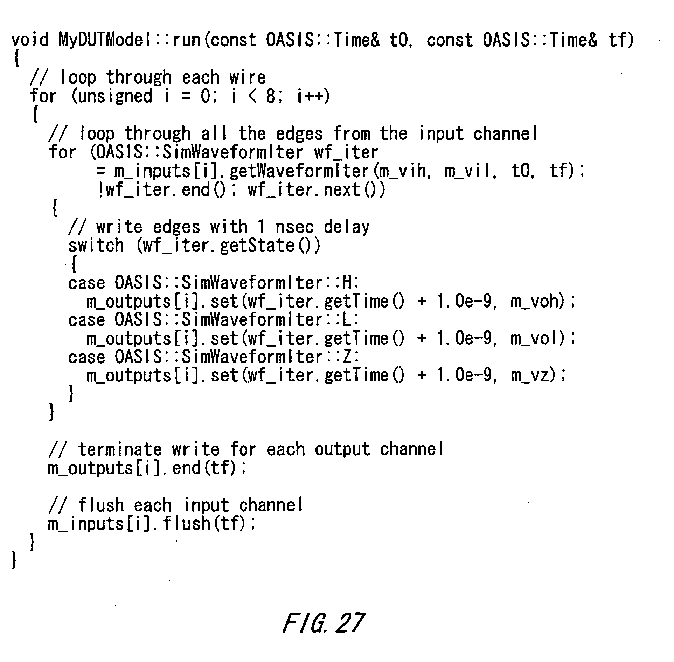

Fig. 27 shows an example of the run method in the DUT model. The run method takes two arguments, a start time and an end time. These arguments indicate that the DUT model should advance its internal states from the start time to the end time based upon stimulus from the input pins and output any data resulting from these changes to the DUT state. Inputs should be received from the SimChannel objects. In addition, outputs can occur after the end time.

The run method includes steps of scanning the input terminals, updating the internal states of the DUT, and outputting data to the output channels of the DUT.

Even if an output edge were to fall outside the execution time window, the fall edge has to be written to the output channel by the set method. Moreover, when calling end method, the output signal must be fallen.

Thereby, calling end indicates to the system that the object on the other side of the channel can safely read the channel up to the specified time because the signal will not change. The framework insures that this is true by blocking any writes to the channel for times earlier than the last end call. This can cause problems in subsequent run calls to the DUT model.

Offline DLL Interface

Next, a DLL of the module and the DUT model based on the framework is build and the functions that creates an instance of these models and perform any clean up after the end of the process is exported, so that the DLL which emulates the module of the test apparatus and the DLL which emulates the DUT may be created.

Supplementary information C: An example of specification of system bus access library

C.1 Introduction

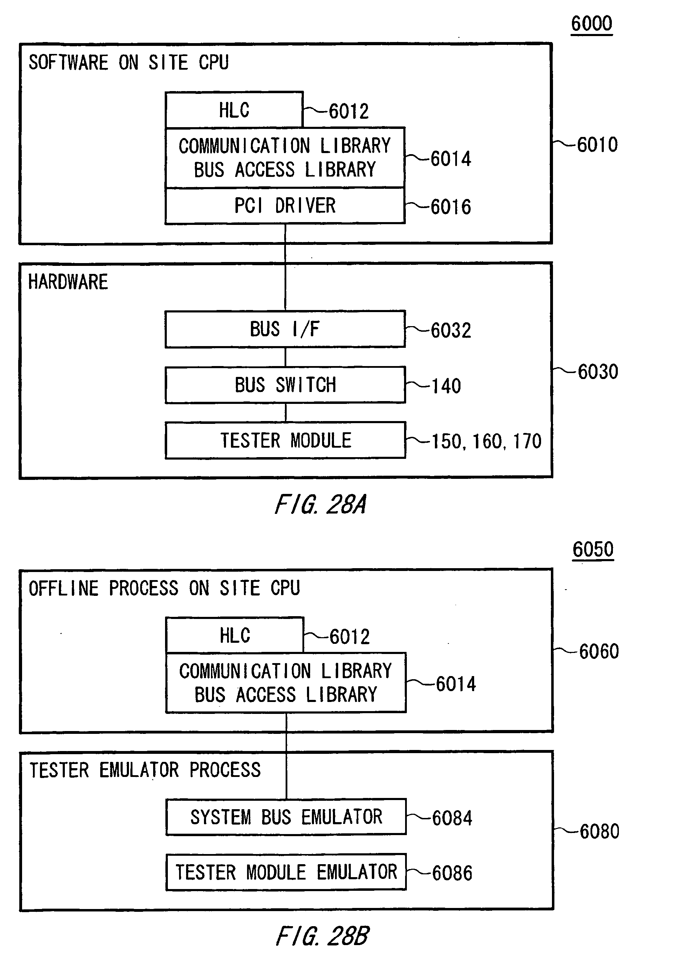

Fig. 28 shows positioning of the system bus access library 6014 in the real environment 6000 and the emulation environment 6050. It is used in common in the real environment 6000 of the DUT 100 and in the emulation environment 6050 by the test emulator 190.

Fig. 28A shows positioning of the system bus access library 6014 in the real environment 6000 (online environment). Software 6010 is software which runs on the site controller 130 illustrated in Fig. 1. The software 6010 includes: an HLC processing section 6012 which receives and interprets HLC (High Level Command) from the program which controls the test of the test apparatus 10 and generates the access command to hardware 6030; a system bus access library 6014 including a communication library which performs communication processing based on an access command, and a bus access library which accesses a system bus (PCI bus in the present embodiment) based on instructions of the communication library; and a PCI bus driver 6016 which controls a system bus based on instruction of the system bus access library 6014.

The hardware 6030 includes: a bus IF 6032 included in the site controller 130 illustrated in Fig. 1; the bus switch 140; and various modules such as the synchronous module 150, the synchronous connection module 160 and/or test module 170. The bus IF 6032 connected to the bus slot of the site controller 130 transmits access issued by the PCI bus driver 6016 to the modules such as the synchronous module 150 and/or test module 170, through the bus switch 140, so that the access is processed.

Fig. 28B illustrates positioning of the system bus access library 6014 in the emulation environment 6050 (offline environment). The offline process 6060 is software which runs on the site controller 130 or the test emulator 190 illustrated in Fig. 1, and causes the test emulator 190 to act as the site control emulation section 230. The offline process 6060 is a process to control the test apparatus emulation process 6080 instead of controlling the hardware 6030 by the software 6010. The offline process 6060 provides the user of software 6010 with a user level interface in common with the software 6010 by using the HLC processing section 6012 and the system bus access library 6014, which are substantially same as the software 6010. The test apparatus emulation process 6080 is a process which emulates the test apparatus 10, and includes a system bus emulator 6084 which emulates the bus switch 140, and the module emulator 6086 which emulates the synchronous module 150, the synchronous connection module 160, and/or the test module 170. The system bus emulator 6084 causes the test emulator 190 to act as the bus switch emulation section 240. The module emulator 6086 causes the test emulator 190 to act as the synchronous module emulation section 250, the synchronous connection module emulation section 260, and/or the test module emulation section 270. Hereinafter, unless otherwise specifically noted, it writes clearly, a word "module" means at least one of the synchronous module 150, the synchronous connection module 160 and the test module 170 in the online environment, and the synchronous module emulation section 250, the synchronous connection module emulation section 260 and the test module emulation section 270 in the offline environment.

C.2 General Functions for Controlling the Tester Module

This chapter describes general functions used in the module driver which runs on the site controller 130 and controls the synchronous module 150, the synchronous connection module 160, and/or the test module 170. In the module driver, this library is used to access registers and memories in the tester module and read and write the data necessary for device measurement. The main functions described in this chapter are as follows:

1. Bus access using program IO
2. Bus access using the DMA function
3. Interrupt handling
4. Control of library/System bus

C.2.1 Bus Access Using Program IO

There are two types of accesses to the system bus, one in which MW (Machine Word) is directly written on the register of the Tester Module connected to the bus and the other in which the HLC (High Level Command) is transferred to the Tester Module. In both cases, Address and Data flow on the system bus. If recognized as HLC by the Address on the Tester Module side, the processing corresponding to the HLC is performed on the Tester Module side. For writing data from the Site CPU (the site controller 130) to the Tester Module, the same data is sent to each Tester Module connected to the Site CPU and each Tester Module acquires the corresponding data.

FIFO is placed in the System bus and Tester Module and, therefore, if any data is transferred from the Site CPU to the Tester Module, the write action of the CPU is stopped without waiting for the completion of the write action of the Tester Module. The time until the data is actually stored in the register is influenced by the availability of FIFO existing between the CPU and the register of the target. For guaranteeing that the data has definitely reached all Tester Modules, use the flush waiting function of the FIFO. When FIFOs are flushed using the read of the register in the Tester Module, it can be guaranteed that only the FIFO of the Tester Module to be read has been flushed.

In the example shown in the following diagram, if read of the register is executed against the Tester Module 2, the read action is made to wait until the FIFO of the Tester Module 2 is flushed, but there is no guarantee that the FIFO of the Tester Module 1 has been flushed. If this guarantee is desired, execute reading of the Tester Module 2, using the flush waiting function of the FIFO in the Tester Module, after the FIFO of each Tester Module has been flushed.

<Offline>

No FIFO is placed in the offline System bus Emulator 6084. Therefore, if PIO write is executed against a Module Emulator 6086 that does not have FIFO, it returns from the function after storing data to the register of the Module Emulator 6086.

If any data is written in the Module Emulator 6086 having FIFO the same as in online, the write process is immediately ended after storing data in the FIFO of the Module Emulator 6086.

2.1.1 Write Using Program 10

Write the data to the register in the Tester Module. The Site CPU terminates write operation before the written data reaches the Tester Module (posted write).

[Name]

BCL_GBI_write

[Syntax]

int BCL_GBI_write(unsigned int address, unsigned int data);

[Argument]

| | |
|---|---|
| address | Machine word address |
| data | Data to be written |

[Return value]

| | |
|---|---|
| BCL_GBI_OK | Normal termination |
| BCL_GBI_ERROR | Error |

C.2.1.2 Read Using Program 10

Read the data in the register of the Tester Module. The Site CPU waits until the data is read. Read of the target register is made to wait until the data in the FIFO between the CPU and the target register is flushed.

[Name]

BCL_GBI_read

[Syntax]

int BCL_GBI_read(unsigned int address, unsigned int *data);

[Argument]

| | |
|---|---|
| address | Machine word address |
| data | Pointer to the variable to read the data |

[Return value]

| | |
|---|---|
| BCL_GBI_OK | Normal termination |
| BCL_GBI_ERROR | Error |

C.2.1.3 Block Write Using Program IO

Write the blocks of data to the register in the Tester Module. Specify the data format using the address and the data as a pair. The System bus executes the write cycles for the specified number of times.
When writing data in multiple addresses, it can be executed with higher speed than writing with the BCL_GBI_ write() function every time. This is because the calling of the function is needed only once and multiple exclusions are not executed.

[Name]

BCL_GBI_writeBlock

[Syntax]

int BCL_GBI_writeBlock(unsigned int *address, unsigned int *data, unsigned int number);

[Argument]

| | |
|---|---|
| address | Pointer to the array in which the address is stored |
| data | Pointer to the array in which the data is stored |

[Return value]

| | |
|---|---|
| BCL_GBI_OK | Normal termination |
| BCL_GBI_ERROR | Error |

C.2.1.4 Block Read Using Program 10

Read the data in the register of the Tester Module as blocks. The address of the register can be specified with discontinuous values. The System bus executes the read cycles for the specified number of times.

When reading data in multiple addresses, it can be executed with higher speed than reading with the BCL_GBI_read() function every time. This is because the calling of the function is needed only once and multiple exclusions are not executed.

[Name]

BCL_GBI_readBlock

[Syntax]

int BCL_GBI_readBlock(unsigned int *address, unsigned int *data, unsigned int number);

[Argument]

address    Pointer to the array in which the address is stored
data    Pointer to the array to read the data
number    The number of data to be read

[Return value]

BCL_GBI_OK    Normal termination

BCL_GBI_ERROR    Error

C.2.1.5 Continuous Block Write Using Program IO

The data array is written to the register placed in the evenly spaced addresses of the Tester Module. The data array is written from the specified starting address and the offset value is added to the address every time the data is written. The offset value can be specified as a value between 0 and 0x3fffff. The System bus executes the write cycles for the specified number of times.

When writing data to multiple fixed offset addresses, it can be executed with higher speed than that of the writing using the BCL_GBI_writeBlock(). This is because of the fact that the adding of addresses is conducted by hardware and, therefore, the number of packets flowing on the PCI bus becomes smaller.

[Name]

BCL_GBI_writeSeq

[Syntax]

int BCL GBI writeSeq(unsigned int address, unsigned int *data, unsigned int number, unsigned int offset);

[Argument]

address    Machine word address
data    Pointer to the array in which the data is stored
number    The number of data to be written
offset    The offset value to be added to the address for each data transfer.

[Return value]

BCL_GBI_OK    Normal termination
BCL_GBI_ERROR    Error

C.2.1.6 Continuous Block Read Using Program IO

The data array is read from the register placed in the evenly spaced addresses of the Tester Module. The data array is read from the specified starting address and the offset value is added to the address every time the data is read. The offset value can be specified as a value between 0 and 0x3ffffff. The System bus executes the read cycle the specified number of times.

When reading data from multiple fixed offset addresses, it can be executed with higher speed than reading with the BCL_GBI_readBlock() function every time. This is because of the fact that the adding of addresses is conducted by hardware and, therefore, the number of packets flowing on the PCI bus becomes smaller.

[Name]

BCL_GBI_readSeq

[Syntax]

int BCL_GBI_readSeq(unsigned int address, unsigned int *data, unsigned int number, unsigned int offset);

[Argument]

address     Machine word address
data        Pointer to the array to read the data
number      The number of data to be read
offset      The offset value to be added to the address for each data transfer.

[Return value]

BCL_GBI_OK        Normal termination
BCL_GBI_ERROR     Error

C.2.2 Bus Access Using DMA Function

The following four types of functions are available for data transfer using DMA.

No. functions

1 Synchronous DMA write with burst/single
2 Synchronous DMA read with burst/single
3 Asynchronous DMA write with burst/single
4 Asynchronous DMA read with burst/single

1. Synchronous/asynchronous DMA

In the case of synchronous DMA, the function waits for termination of the DMA and then terminates. Although the function terminates only after the termination of the DMA, the transferred data may remain in the FIFO in the System bus I/F or Tester Module in certain cases.

In the case of asynchronous DMA, the function terminates without waiting for the DMA termination. Therefore, it is required that the lifecycle of the data area be guaranteed by the user. Furthermore, if any function using the DMA is executed before the transfer of the asynchronous DMA has been completed, the function is forced to wait until the previous DMA transfer is completed.

The transfer ID is prepared as the identification information to wait for the completion of asynchronous DMA processing. This transfer ID is 32-bit data without a code and, if the number of DMA transfers exceeds 32 bits, it returns to 0 and is reused.

2. Burst/Single DMA

In burst DMA transfer, data is transferred with packets specific to burst on the System bus. In this transfer, one address and N (64 at the maximum) data are taken as a packet and the transfer of packets is repeated until the transfer of the specified number of data is completed. Therefore, high-speed transfer is possible.

In addition, in carrying out DMA transfer, the increasing value for the address on the Tester Module side can be specified. This increasing value is used to calculate the top address of the packet for transfer of the packet after the second group.

$$(\text{Address of the packet}) = (\text{Specified increasing value})$$

$$(\text{Number of data in the preceding packet})$$

$$+ (\text{Top address of the preceding packet})$$

In addition, because the register with which burst transfer is possible depends on the Tester Module, it is necessary to check if the register is a usable one.

In single DMA transfer, the address and data are transferred as a set on the System bus, the same as in program IO. Therefore, the transfer speed is lower than that for burst DMA, but transfer to any register is possible. When conducting DMA transfer, the increasing value for the address on the System bus side can be specified. This increasing value is added to the address every time an address is generated.

<Offline>

In the case of offline, even if burst transfer is specified, it is treated internally as a single transfer. Therefore, transfer to any register that does not support burst transfer is possible. Taking online use into consideration, however, avoid any use for registers in which burst transfer is not supported by hardware. In addition, offline synchronous and asynchronous DMAs are the same as those online.

C.2.2.1 Synchronous Write Using DMA Function

Transfers data placed in the memory of the Site CPU to the Tester Module using DMA. This function can specify burst or single for synchronous write.

[Name]

BCL_GBI_writeSyncDMA

[Syntax]

int BCL_GBI_writeSyncDMA(unsigned int address, unsigned int *data, unsigned int number, unsigned int offset, unsigned int mode);

[Argument]

address | Machine word address
data | Pointer to the array in which the data is stored
number | The number of data to be written
offset | The offset value to be added to the address for each data transfer
mode | Burst or single operation mode

[Return value]

BCL_GBI_OK. | Normal termination
BCL_GBI_ERROR | Error

30

C.2.2.2 Synchronous Read Using DMA Function

Data using the DMA from the register in the Tester Module is read to the memory of the Site CPU. This function can specify burst or single for synchronous read.

[Name]

   BCL_GBI_readSyncDMA

[Syntax]

   int BCL_GBI_readSyncDMA(unsigned int address, unsigned int *data, unsigned int number,
   unsigned int offset, unsigned int mode);

[Argument]

| | |
|---|---|
| address | Machine word address |
| data | Pointer to the array to read the data |
| number | The number of data to be read |
| offset | The offset value to be added to the address for each data transfer |
| mode | Burst or single operation mode |

[Return value]

| | |
|---|---|
| BCL_GBI_OK | Normal termination |
| BCL_GBI_ERROR | Error |

C.2.2.3 Asynchronous Write Using DMA Function

The data placed in the memory of the Site CPU is transferred to the Tester Module using DMA. This function can specify burst or single for asynchronous write.

[Name]

   BCL_GBI_writeAsyncDMA

[Syntax]

   int BCL_GBI_writeSyncDMA(unsigned int address, unsigned int *data, unsigned int number,
   unsigned int offset, unsigned int mode, unsigned int *transferID);

[Argument]

| | |
|---|---|
| address | Machine word address |
| data | Pointer to the array in which the data is stored |
| number | The number of data to be written |
| offset | The offset value to be added to the address for each data transfer |
| mode | Burst or single operation mode |
| transferID | Pointer for ID for waiting for completion of transfer |

[Return value]

| | |
|---|---|
| BCL_GBI_OK | Normal termination |
| BCL_GBI_ERROR | Error |

C.2.2.4 Asynchronous Read Using DMA Function

Data using the DMA from the register in the Tester Module is read to the memory of the Site CPU. This function can specify burst or single for asynchronous read.

[Name]

BCL_GBI_readAsyncDMA

[Syntax]

int BCL_GBI_readAsyncDMA(unsigned int address, unsigned int *data, unsigned int number, unsigned int offset, unsigned int mode, unsigned int *transferID);

[Argument]

address    Machine word address
data       Pointer to the array to read the data
number     The number of data to be read
offset     The offset value to be added to the address for each data transfer
mode       Burst or single operation mode
transferID Pointer for ID for waiting for completion of transfer

[Return value]

BCL_GBI_OK       Normal termination
BCL_GBI_ERROR    Error

C.2.2.5 Waiting for Completion of Asynchronous DMA Transfer

Waits for the completion of transfer in asynchronous transfer using the DMA. This function terminates when the DMA is completed or the specified time has elapsed. Because the resolution uses 1 ms 32-bit signed timer, the range for time specification is 0 - (INT_MAX/1000). If any specification is made outside this range, it is treated the same as when BCL_GBI_INFINITE is specified.
In transferID is specified with a wrong value, BCL_GBI_OK is returned immediately and this function is terminated.

[Name]

BCL_GBI_waitDMA

[Syntax]

int BCL_GBI_waitDMA(unsigined int transferID, double timeOut);

[Argument]

transferID    ID waiting for completion of transfer returned in asynchronous mode transfer

timeOut       Waiting time >= 0 : timeout period [s]
              BCL_GBI_INFINITE : waits until the DMA terminates.

[Return value]

BCL_GBI_OK          DMA terminates normally.
BCL_GBI_TIMEOUT     Timeout
BCL_GBI_ERROR       The DMA terminates abnormally.

C.2.2.6 Status of Asynchronous DMA Transfer

Gives notice of the current status of asynchronous DMA transfer. If a wrong transferID is specified, gives notice of the same status as the termination of the DMA.

[Name]

BCL_GBI_getConditionDMA

[Syntax]

int BCL_GBI_getConditionDMA(unsigned int transferID);

[Argument]

transferID     ID waiting for completion of transfer returned in asynchronous mode transfer

[Return value]

BCL_GBI_BUSY      DMA being executed
BCL_GBI_OK        DMA terminates normally.
BCL_GBI_ERROR     DMA terminates abnormally.

C.2.3 Interrupt Handling

In the System bus access library, functions for carrying out basic interrupt operation are provided. There are four types of interrupts operable using the System bus access library.

1. Bus error interrupt (only for online)
Up to 65 interrupt handlers can be registered.
2. Bus timeout interrupt
Up to 65 interrupt handlers can be registered.
3. Sync error interrupt (only for online)
Up to 65 interrupt handlers can be registered.
4. Interrupt generated from the Tester Module
Up to 2 interrupt handlers can be registered with each bus number.

It is executed with interrupt thread together with above-mentioned interrupt. Bus error, Bus timeout or Sync error interrupt generated by the System bus I/F disables the interrupt inside the interrupt thread and then executes the interrupt handlers of the registered target in turns. After execution of the target interrupt handlers is completed, the interrupt thread clears the factor of the interrupt and enables the interrupt internally.
For acceptance of interrupt, control of enable/disable can be controlled by the function of this library separately from enable/disable inside the interrupt thread. For the interrupt generated in the Tester Module, the interrupt thread disables the interrupt internally and executes the lock of the interrupt for the Tester Module. Then, interrupt handlers corresponding to the bus number causing the interrupt are executed by turns. After completing the execution of the target interrupt handlers, the interrupt thread clears the factor of the interrupt for the Tester Module. Then the lock of the interrupt is released and the interrupt is enabled internally.
For acceptance of interrupt, control of enable/disable can be controlled by the function of this library separately from enable/disable inside the interrupt thread. Inhibition/permission for interrupt can be controlled both on the System bus board and the Tester Module.
Inhibition/permission on the System bus I/F side simply enables/disables the interrupt from the Tester Module. Lock/unlock of interrupt on the Tester Module side controls generation of interrupt on the source of interrupt on the Tester Module side. During lock, generation of new interrupt in the Tester Module is inhibited and change in the status related to interrupt is also inhibited. After unlock, generation of interrupt on the Tester Module side becomes possible.

C.2.3.1 Registration of Module Interrupt Handler

The interrupt handler function at the time of occurrence of the interrupt from the Tester Module is registered.

When an interrupt has occurred, the registered function is executed with the exclusive thread for the interrupt handler. The interrupt handler is registered together with the bus number, and the interrupt handler that has the same registered bus number as that of the Tester Module that reported the interrupt is activated.

In addition, the value set at the time of registration is returned to the interrupt handler. Two interrupt handlers can be registered at the same time for each bus number. Bus numbers can be specified from 1 to 64. If successfully registered, the key number is returned as the return value. If registration is carried out using this key number, the re-registration and deletion of the interrupt handler with this key number becomes possible. If any registration is carried out by specifying 0 as the key number, the interrupt handler will be set to a vacant key number. If there is no vacant key number, an error occurs and (-1) will be returned as the return value. With respect to execution of interrupt handlers in the case in which two interrupt handlers have been registered, the execution is carried out from the younger key number.

Deletion of the interrupt handler is registered by setting the address of the callback function to BCL_GBI_IGNORE_MODULE_HANDLER. The interrupt thread does not execute the interrupt handler of BCL_GBI_IGNORE_MODULE_HANDLER. If both of two interrupt handlers for each bus number become BCL_GBI_IGNORE_MODULE_HANDLER, interrupt handlers of that bus number return to the default. (The standard interrupt handler in the access library will be set.)

[Name]

BCL_GBI_addInterruptHandler

[Syntax]

int BCL_GBI_addInterruptHandler(unsigned int BusNo, int KeyNo,
BCL_GBI_MODULE_HANDLER handler, unsigned int arg);

[call back function]

void InterruptRoutine(unsigned int BusNo, unsigned int Factor, unsigned int arg);

[Argument]

BusNo      Bus number
KeyNo      Key number
handler    Call back function address
arg        Value to be given to interrupt handler
Factor     interrupt factor (dependent on each module)

[Return value]

Key number to which interrupt handler is registered
If it is (-1), registration failed (invalid bus number or key number).

C.2.3.2 Registration of Bus Error Interrupt Handler

The error processing function for the case in which error occurred in the System bus is registered. If any error occurs in the System bus, the interrupt thread executes the registered function. In addition, if any error occurs in the System bus, the interrupt is cleared by the interrupt thread. It is not necessary to clear inside the interrupt handler.

Up to 65 interrupt handlers for Bus error can be registered. If successfully registered, the key number is returned as the return value. If registration is carried out using this key number, the re-registration and deletion of the interrupt handler with this key number becomes possible. If any registration is carried out by specifying 0 as the key number, the interrupt handler will be set to a vacant key number. If there is no vacant key number, an error occurs and (-1) will be returned as the return value. Deletion of the interrupt handler is registered by setting the address of the callback function to BCL_GB_IGNORE_BUSERROR_HANDLER.

The interrupt thread does not execute the interrupt handler of BCL_GBI_IGNORE_BUSERROR_HANDLER. If all 65 interrupt handlers become BCL_GBI_IGNORE_BUSERROR_HANDLER, they return to the default. (The standard interrupt handler in the access library will be set.) Bus error may occur due to an error in communication of the System bus or failed hardware.

<Offline>

Because there is no factor to cause any error in the Bus offline, the handler registered with this function does not function.

[Name]

BCL_GBI_addBusErrorInterruptHandler

[Syntax]

int BCL_GBI_addBusErrorInterruptHandler(int KeyNo,
BCL_GBI_MODULE_HANDLER handler, unsigned int arg);

[call back function]

void BusErrorInterruptRoutine(unsigned int arg);

[Argument]

KeyNo      Key number
handler    Call back function address
arg        Value to be given to interrupt handler

[Return value]

Key number to which interrupt handler is registered
If it is (-1), registration failed (invalid bus number or key number).

2.3.3 Registration of Bus Timeout Interrupt Handler

The error processing function for the case in which timeout occurs in the System bus is registered. If any timeout occurs in the System bus, the interrupt thread executes the registered function. In addition, if any timeout occurs in the System bus, the interrupt is cleared by the interrupt thread.
It is not necessary to clear inside the interrupt handler. Up to 65 interrupt handlers for Bus timeout can be registered. If successfully registered, the key number is returned as the return value. If registration is carried out using this key number, the re-registration and deletion of the interrupt handler with this key number becomes possible. If any registration is carried out by specifying 0 as the key number, the interrupt handler will be set to a vacant key number. If there is no vacant key number, an error occurs and (-1) will be returned as the return value. Deletion of the interrupt handler is registered by setting the address of the callback function to BCL_GBI_IGNORE_TIMEOUT_HANDLER.
The interrupt thread does not execute the interrupt handler of BCL_GBI_IGNORE_TIMEOUT_HANDLER. If all 65 interrupt handlers become BCL_GBI_IGNORE_TIMEOUT_HANDLER, they return to the default. (The standard interrupt handler in the access library will be set.) Bus timeout occurs at the time of read in the condition in which a cable is disconnected or the receiver does not exist. Failed hardware can also be the cause.

[Name]

BCL_GBI_addTimeoutInterruptHandler

[Syntax]

int BCL_GBI_addTimeoutInterruptHandler(int KeyNo,
BCL_GBI_TIMEOUT_HANDLER handler, unsigned int arg);

[call back function]

void TimeoutInterruptRoutine(unsigned int address, unsigned int Factor, unsigned int arg);

[Argument]

KeyNo    Key number
handler   Call back function address
address   Machine work address when a timeout has occurred
Factor    Factor that caused the timeout

BCL_GBI_FACTOR_MODULE        Read of Tester Module
BCL_GBI_FACTOR_CONFIG        Read of configuration data
BCL_GBI_FACTOR_WRITE        All write operations

arg    Value to be given to interrupt handler

[Return value]

Key number to which interrupt handler is registered
If it is (-1), registration failed (invalid bus number or key number).

G.2.3.4 Registration of Sync Error Interrupt Handler

The error processing function for the case in which Sync error occurred in the System bus is registered. If any Sync error occurs in the System bus, the interrupt thread executes the registered function. In addition, if any Sync error occurs in the System bus, the interrupt is cleared by the interrupt thread. It is not necessary to clear inside the interrupt handler.

Up to 65 Interrupt handlers for Sync error can be registered. If successfully registered, the key number is returned as the return value. If registration is carried out using this key number, the re-registration and deletion of the interrupt handler with this key number becomes possible. If any registration is carried out by specifying 0 as the key number, the interrupt handler will be set to a vacant key number. If there is no vacant key number, an error occurs and (-1) will be returned as the return value.

Deletion of the interrupt handler is registered by setting the address of the callback function to BCL_GBI_ IGNORE_SYNCERROR_HANDLER. The interrupt thread does not execute the interrupt handler of BCL_GBI_IGNORE_ SYNCERROR_HANDLER. If all 65 interrupt handlers become BCL_GBI_IGNORE_SYNCERROR_HANDLER, they return to the default. (The standard interrupt handler in the access library will be set.)

Sync error may be caused by improper setting of software or faulty design of hardware. Failed hardware can also be the cause.

<Offline>

Because there is no factor to cause any Sync error in the Bus offline, the handler registered with this function does not function.

[Name]

BCL_GBI_addSyncErrorInterruptHandler

[Syntax]

int BCL_GBI_addSyncErrorInterruptHandler(int KeyNo,
BCL_GBI_SYNCERROR_HANDLER handler, unsigned int arg);

[call back function]

void SyncErrorInterruptRoutine(unsigned int arg);

[Argument]

KeyNo    Key number
handler   Call back function address

arg        Value to be given to interrupt handler

[Return value]

      Key number to which interrupt handler is registered
      If it is (-1), registration failed (invalid bus number or key number).

C.2.4 Control of Library/System bus

C.2.4.1 FIFO Flush Wait

Flush of FIFO in all Tester Modules connected to the System bus that is connected to the Site CPU is waited for. FIFOs exist in the System bus I/F board and Tester Module. If this function is terminated, it means that all the data that existed in the FIFO immediately before executing this function are written to the Tester Module. Because the CPU issues a read cycle to the PCI bus during execution of this function, the bus is locked by hardware until the FIFO is flushed. Therefore, a delay may occur in DMA transfer, interrupt acceptance, etc. Furthermore, in certain cases, timeout may occur because of execution of this function. Furthermore, in certain cases, timeout may occur because of execution of this function.

<Offline>

Offline, FIFO of System bus I/F Emulator does not exist. In addition, the existence of FIFO in the Tester Module is vendor-dependent.

[Name]

      BCL_GBI_waitFlushFIFO

[Syntax]

      int BCL_GBI_waitFlushFIFO(void);

[Argument]

      None

[Return value]

BCL_GBI_OK      Flush completed
BCL_GBI_ERROR   Error

C.2.4.2 Resetting Module

Tester Modules connected to the Site CPU are reset. In this function, the following processing is conducted.

    1. Sending out the bus reset packet to the System bus
    2. Sending out the packet to clear the interrupt to the System bus
    3. Sending out the unlock packet for the interrupt to the System bus

The resetting action and the time needed depend on each Tester Module.

[Name]

      BCL_GBI__resetModule

[Syntax]

      int BCL_GBI_resetModule(void);

[Argument]

None

[Return value]

BCL_GBI_OK      Normal termination
BCL_GBI_ERROR   Error

C.2.4.3 Initializing the Library

The System bus access library is initialized. When using the System bus access library, it is necessary to carry out this initialization at first. In this function, the following processes are executed.

1. Initialization of the variable of the access library
2. Activation of the thread for executing the interrupt handler

The interrupt on the System bus I/F is in disabled status.

<Offline>

In the case of offline, inter-process communication with the System bus Emulator is prepared by this function. A timeout occurs if the connection with the System bus Emulator is not established within 30 seconds.

[Name]

BCL_GBI_init

[Syntax]

int BCL_GBI_init(unsigned int siteNo, int mode);

[Argument]

siteNo   Site number (1 to 8)
mode    Specifying Online/Offline

BCL_GBI_ONLINE     Online
BCL_GBI_OFFLINE    Offline
[Return value]

BCL_GBI_OK      Normal termination
BCL_GBI_ERROR   The site number is out of definition.

<Offline>

BCL_GBI_TIMEOUT Cannot connect with the System bus Emulator within 30 seconds

C.2.4.4 Releasing the Library

Process for ending the use of the System bus access library is carried out.

[Name]

BCL_GBI_finish

[Syntax]

int BCL_GBI_finish(unsigned int siteNo);130

[Argument]

siteNo    Site number (1 to 8)130

[Return value]

BCL_GBI_OK          Normal termination
BCL_GBI_ERROR    The site number is out of definition.

C.2.4.5 Determining Online/Offline

Determine whether the currently run System bus access library is operating online or offline.

[Name]

    BCL_GBI_isOnline

[Syntax]

    int BCL_GBI_isOnline(void);

[Argument]

    None

[Return value]

    BCL_GBI_ONLINE Online
    BCL_GBI_OFFLINE Offline

C.2.4.6 Verifying the Connection with the GBSC

Verifies whether or not the System bus I/F can be connected with the GBSC.
This can also verify whether or not the GBSC is turned on.

[Name]

    BCL_GBI_getConnected

[Syntax]

    int BCL_GBI_getConnected(unsigned int *connect);

[Argument]

    connect Pointer to the variable to store the result of whether or not the System bus I/F can be connected with the GBSC

Return value]

BCL_GBI_OK          Normal termination
BCL_GBI_ERROR    Error

C.2.4.7 Acquiring Detailed Error Information

Returns detailed information of the error which occurred when the System bus access library returned BCL_GBI_ERROR.

[Name]

BCL_GBI_getLastError

[Syntax]

unsigned int BCL_GBI_getLastError(void);

[Argument]

None

[Return value]

Returns unsigned 32-bit error information.

bit31        Value to identify the error code type.

            0: Windows error code (refer to System Error Codes)
            1: Access library unique error code

bit30-24     Value to identify where the error occurred in the function (internal information)

bit23-16     Value to identify the access library function where the error occurred

bit15-0      Error code

When bit31 is 0: Lower 16-bit value of GetLastError()
When bit31 is 1: Access library internal error value

C.2.4.8 Acquiring Detailed Error Information History

Returns detailed information of the last 16 errors (maximum) which occurred when the System bus access libraries returned BCL_GBI_ERROR.

[Name]

BCL_GBI_getPreviousErrors

[Syntax]

unsigned int BCL_GBI_getPreviousErrors(unsigned int *error, unsigned int size);

[Argument]

error    Pointer to the array variable to store error information
         The error information format is the same as BCL_GBI_getLastError().
size     Size of the array variable to store the error information

[Return value]

The number of stored error information units is returned.

C.3 TIMER FUNCTIONS

This chapter describes the functions which control the timer hardware on the System bus I/F board.

The resolution of the timer hardware on the System bus I/F board is 1 [us].

3.1 Reading the Elapsed Time
3.1.1 Reading the Time

The elapsed time after the System bus access library is initialized can be read in seconds [s].

<Restrictions>

The resolution is 1 [us]. However, if the read value is larger than the significant digits of double * 1 [us], a resolution of 1 [us] may not be obtained because data is converted to double type and then read. The significant digits of double are 15 digits in decimal, therefore, theoretically, a resolution of 1 [us] cannot be obtained for about 31 years from initialization.

The hardware counter operates in 64 bits, therefore, theoretically, it will return to 0 after about 580,000 years after the System bus access library is initialized. In the program, the difference (elapsed time) between readings at regular intervals may not be the same due to the load conditions of the CPU or PCI bus, or due to the FIFO conditions.

<Offline>

When offline, the elapsed time, from when the SiteCPU is started, is read in seconds [s].

[Name]

BCL_TMR_readTime

[Syntax]

int BCL_TMR_readTime(double *time);

[Argument]

time Elapsed time [s] after the initialization of the System bus access library

[Return value]

BCL_TMR_OK     Normal termination

C.3.1.2 Reading the Timer Counter

The elapsed time after initializing the System bus access library is initialized can be read in count value. The count value increases by 1 with an elapse of 1 [us].

<Restrictions>

The hardware counter operates in 64 bits, therefore, theoretically, it will return to 0 after about 580,000 years after the System bus access library is initialized. In the program, the difference (elapsed time) between readings at regular intervals may not be the same due to the load conditions of the CPU or PCI bus, or due to the FIFO conditions.

<Offline>

When offline, the elapsed time, from when the SiteCPU is started, is read as the count value.

[Name]

BCL_TMR_readCount

[Syntax]

int BCL_TMR_readCount(unsigned _int64 *count);

[Argument]

count The count value after initialization of the System bus access library (1 [us]/1 count)

[Return value]

BCL_TMR_OK    Normal termination

C.3.2 Wait Functions

C.3.2.1 Wait Time

This function causes the next function to wait until the specified time elapses. If a value smaller than 1 [us] is specified as the wait time, the next function will start immediately.

<Restrictions>

The wait time may be longer than the specified time, depending on the load conditions of the CPU.

<Offline>

When offline, the wait time is based on the value in which less than 1 [ms] is rounded off. For example, if a value smaller than 1 [ms] is specified as the wait time (time), the function will be returned immediately. The maximum wait time is 4294967.296 [s] (approximately 49 days).

[Name]

BCL_TMR_wait

[Syntax]

int BCL_TMR_wait(double time);

[Argument]

time Wait time specified in seconds [s]

[Return value]

BCL_TMR_OK        Normal termination
BCL_TMR_ERROR     Wait cancelled

C.3.2.2 Cancelling the Wait Function

All processes of the currently run BCL_TMR_wait function can be cancelled. When the function is executed in multiple threads, all the processes of BCL_TMR_wait function are cancelled.

[Name]

BCL_TMR_cancel

[Syntax]

int BCL_TMR_cancel(void);

[Argument]

**42**

None

[Return value]

BCL_TMR_OK     Normal termination

C.4 FUNCTIONS SPECIFICALLY FOR CONFIGURATION/DIAGNOSTICS

This chapter describes the functions used for hardware configuration and hardware diagnostics. If used for any purpose other than hardware configuration and hardware diagnosis, data transfer to the tester module or interruption operation cannot be performed properly. Use these functions for hardware configuration and hardware diagnosis after learning the hardware structures of System bus I/F board, bus switch and tester module, etc.

No runtime error occurs in this library during operation, but, if used in any function other than bus configuration and hardware diagnosis, functions of this library and the System bus I/F board with respect to interruption of the device driver are not guaranteed.

C.4.1 Configuration Control (Special Function)

The function described in this chapter is a function used for configuration of System bus I/F and the tester module. Because data transfer to the tester module becomes impossible if carelessly operated, use it after becoming thoroughly familiar with the structure of the hardware and software.

C.4.1.1 Bus Configuration Write

Data is written to the System bus I/F and Tester Module configuration register. This function is terminated after the configuration data is stored in the System bus I/F and the Tester Module.

[Name]

BCL_GBI_writeBusConfig

[Syntax]

int BCL_GBI_writeBusConfig(unsigned int address, unsigned int config);

[Argument]

address     Configuration data address
config        Configuration data to be written

[Return value]

BCL_GBI_OK            Normal termination
BCL_GBI_ERROR     Error

C.4.1.2 Bus Configuration Read

Data are read from the System bus I/F and Tester Module configuration register.

[Name]

BCL_GBI_rcadBusConfig

[Syntax]

int BCL_GBI_readBusConfig(unsigned int address, unsigned int *config);

[Argument]

**43**

address    Configuration data address
config     Pointer to the variable to store configuration data

[Return value]

BCL_GBI_OK          Normal termination
BCL_GBI_ERROR    Error

C.4.1.3 Completing the Bus Switch Configuration Setting

When online, nothing is executed.

<Offline>

Offline bus connection can be switched by executing this function when bus switch configuration write is complete.

[Name]

        BCL_GBI_decideBusMatrix

[Syntax]

        int BCL_GBI_decideBusMatrix (void);

[Argument]

        None

[Return value]

BCL_GBI_OK          Normal termination
BCL_GBI_ERROR    Error

C.4.2 Interrupt control (Special function)

The function described in this chapter is a function used for bus configuration and hardware diagnostics. Because interruption of the System bus I/F board is directly controlled, if operated carelessly, the device driver of the System bus I/F board and this library cannot execute interrupt processing.

C.4.2.1 Bus I/F Board Interrupt Enable

Various interrupt signals are enabled on the System bus I/F board. There are four types of interrupt signals: interrupt from the Tester Module, Bus error, Bus timeout and Sync error. Those signals can be set as the bit information defined as follows. In specifying multiple interrupt signals, set them as logical OR. This function terminates after making sure that the interrupt has been enabled on the System bus I/F.

[Name]

        BCL_GBI_interruptEnable

[Syntax]

        int BCL_GBI_interruptEnable(unsigned int status);

[Argument]

        status Interrupt signal specification

**44**

BCL_GBI_INT_MODULE   Interrupt from the Tester Module
BCL_GBI_INT_BUSERROR  Bus error
BCL_GBI_INT_TIMEOUT   Bus timeout
BCL_GBC_INT_SYNCERROR  Sync error

[Return value]

BCL_GBI_OK   Normal termination
BCL_GBI_ERROR  Error

C.4.2.2 Bus I/F Board Interrupt Disable

Various interrupt signals are disabled on the System bus I/F board. There are four types of interrupt signals: interrupt from the Tester Module, Bus error, Bus timeout and Sync error. Those signals can be set as the bit information defined as follows. In specifying multiple interrupt signals, set them as logical OR. This function terminates after making sure that the interrupt has been disabled on the System bus I/F.

[Name]

  BCL_GBI_interruptDisable

[Syntax]

  int BCL_GBI_interruptDtsable(unsigned int status);

[Argument]

  status Interrupt signal specification

BCL_GBI_INT_MODULE   Interrupt from the Tester Module
BCL_GBI_WT_BUSERROR  Bus error
BCL_GBI_INT_TIMEOUT   Bus timeout
BCL_GBI_INT_SYNCERROR  Sync error

[Return value]

BCL_GBI_OK   Normal termination
BCL_GBI_ERROR  Error

C.4.2.3 Bus I/F Board Interrupt Read

Various interrupt signals are read on the System bus I/F board. There are four types of interrupt signals: interrupt from the Tester Module, Bus error, Bus timeout and Sync error. Those signals can be read as the bit information defined as follows:

[Name]

  BCL_GBI_interruptRead

[Syntax]

  int BCL_GBI_interruptRead(unsigned int *status);

[Argument]

  status Pointer to the variable to read the interrupt signal

  BCL_GBI_INT_MODULE   Interrupt from the Tester Module

45

| BCL_GBI_INT_BUSERROR | Bus error |
| BCL_GBI_INT_TIMEOUT | Bus timeout |
| BCL_GBI_INT_SYNCERROR | Sync error |

[Return value]

| BCL_GBI_OK | Normal termination |
| BCL_GBI_ERROR | Error |

C.4.2.4 Bus I/F Board Interrupt Clear

Various interrupt signals are cleared on the System bus I/F board. There are four types of interrupt signals: interrupt from the Tester Module, Bus error, Bus timeout and Sync error. Those signals can be set as the bit information defined as follows. In specifying multiple interrupt signals, set them as logical OR. This function clears the interrupt on the System bus I/F after the FIFO of each Tester Module immediately before this function was executed has been flushed. This function terminates after making sure that the interrupt has been cleared on the System bus I/F.

When only the interrupt from Tester Module (BCL_GBI_INT_MODULE) is specified, flush the FIFO of each of the Tester Modules just before executing this function, clear the interrupt on the System bus I/F, confirm that the interrupt on the System bus I/F is cleared, and end the process.

[Name]

BCL_GBI_interruptClear

[Syntax]

int BCL_GBI_interruptClear(unsigned int status);

[Argument]

status Interrupt signal specification

| BCL_GBI_INT_MODULE | Interrupt from the Tester Module |
| BCL_GBI_INT_BUSERROR | Bus error |
| BCL_GBI_INT_TIMEOUT | Bus timeout |
| BCL_GBI_INT_SYNCERROR | Sync error |

[Return value]

| BCL_GBI_OK | Normal termination |
| BCL_GBI_ERROR | Error |

C.4.2.5 Setting Number of Modules to Be Synchronized

The number of all Tester Modules connected to the System bus that is connected to the Site CPU is set on the System bus I/F board. With this setting, the number of modules to synchronize FIFO is determined.

<Offline>

Offline, FIFO of System bus I/F Emulator does not exist.In addition, the existence of FIFO in the Tester Module is vendor-dependent.

[Name]

BCL_GBI_setSyncCount

[Syntax]

int BCL_GBI_setSyncCount(unsigned int number);

[Argument]

number    Number of modules to be synchronized

[Return value]

BCL_GBI_OK          Normal termination

BCL_GBI_ERROR    Error

C.4.2.6 Saving Interrupt Settings

The interrupt signal setting (enable or disable) on the System bus I/F board and the interrupt occurrence setting (lock or unlock) from the Tester Module are saved. This function is used to save the current settings before interrupt is executed in diagnosis or other operations. The saved settings are restored by using the BCL_GBI_restoreInterruptCondition() function. If this function is executed more than once, the previously saved settings are deleted and only the most recently saved settings take effect.

<Offline>

When offline, this feature is invalid and nothing happens in this function.

[Name]

BCL_GBI_saveInterruptCondition

[Syntax]

int BCL_GBI_saveInterruptcondition(void);

[Argument]

None

[Return value]

BCL_GBI_OK          Normal termination
BCL_GBI_ERROR    Error

C.4.2.7 Restoring Interrupt Settings

The interrupt signal setting (enable or disable) on the System bus I/F board and the interrupt occurrence setting (lock or unlock) from the Tester Module saved by using the BCL_GBI_saveInterruptCondition() function are restored. After the interrupt is executed in diagnosis or other operations, this function is used to restore the settings before the operation. If this function is executed without using the BCL_GBI_saveInterruptCondition() function to save the settings, the function returns an error. If this function is executed more than once, no error occurs and the most recently saved settings are restored.

<Offline>

When offline, this feature is invalid and nothing happens in this function.

[Name]

BCL_GBI_restoreInterruptCondition

[Syntax]

int BCL_GBI_restoreInterruptCondition(void);

[Argument]

None

[Return value]

BCL_GBI_OK          Normal termination
BCL_GBI_ERROR     Error

C.4.2.8 Reading Module Interrupt Factors

The factors and the number of factors, when the interrupt from the Tester Module occurs, are read. A maximum of 256 (4 bytes per factor) interrupt factors exist. Among these, only factors where interrupts occurred are returned. Consider the maximum number of factors where interrupts can occur (256 unsigned int type) and allocate sufficient number of buffers to read the factors.

<Offline>

When offline, this feature is invalid and nothing happens in this function.

[Name]

BCL_GBI_readInterruptFactor

[Syntax]

int BCL_GBI_readInterruptFactor(unsigned int *Factor, int *number);

[Argument]

Factor      Pointer to the array to read the interrupt factors
number     Pointer to the array to store the number of interrupt factors

[Return value]

BCL_GBI_OK          Normal termination
BCL_GBI_ERROR     Error

C.5 PENDING FUNCTIONS

Pending functions

5.1.1 Cancellation of Asynchronous DMA Transfer (Non-disclosure)

Cancels the asynchronous DMA transfer being executed. Synchronous DMA cannot be cancelled. If a wrong transferID is specified, cancellation of the DMA is not executed and the status of normal termination returns.

[Name]

BCL_GBI_cancelDMA

[Syntax]

int BCL_GBI_cancelDMA(unsigned int transferID);

[Argument]

transferID    ID waiting for completion of transfer returned in asynchronous mode transfer

[Return value]

BCL_GBI_OK        Normal termination
BCL_GBI_ERROR    Error

C.5.1.2 Acquisition of PCI Base Address (Non-disclosure)

The base address of the PCI bus, which is used in the System bus I/F board, can be acquired. This function is used in the diagnostic process for the System bus I/F board, etc. This address can be used only for a process from which the address has been acquired. If the acquired address is NULL, the library has not been initialized. Initialize the library by using the BCL_GBI_init function and then use this function.

<Note>

This function is used only in the debugging process and cannot be used for any products in any way.

<Offline>

When offline, this feature is invalid and nothing happens in this function.

[Name]

BCL_GBI_exportPciBaseAddress

[Syntax]

PULONG BCL_GBI_exportPciBaseAddress(void);

[Argument]

None

[Return value]

NULL        Error
Not NULL    PCI base address of System bus I/F

C.5.1.3 Tester Module Interrupt Lock (Non-disclosure)

Occurrences of interrupts from the Tester Module can be disabled at the source of the interrupts. After setting the interrupt lock, no interrupt is issued from the Tester Module. This function ends after the lock command is completely stored in each of the Tester Modules.

[Name]

BCL_GBI_interruptLock

[Syntax]

int BCL_GBI_interruptLock(void);

[Argument]

None

[Return value]

BCL_GBI_OK          Normal termination

BCL_GBI_ERROR     Error

C.5.1.4 Tester Module Interrupt Unlock (Non-disclosure)

Occurrences of interrupts from the Tester Module can be enabled at the source of the interrupts. Executing this function allows the Tester Module to issue interrupts that have been suspended by the interrupt lock function or interrupts which are generated after unlocking.
This function ends after the unlock command is completely stored in each of the Tester Modules.

[Name]

　　　BCL_GBI_interruptUnlock

[Syntax]

　　　int BCL_CBI_interruptUnlock(void);

[Argument]

　　　None

[Return value]

BCL_GBI_OK          Normal termination

BCL_GBI_ERROR     Error

C.5.1.5 Outputting Detailed Error Information (Non-disclosure)

Outputs the detailed information of the error, which occurred when the System bus access library returned BCL_GBI_ERROR, to the standard output stream.

[Name]

　　　BCL_GBI_printLastError

[Syntax]

　　　void BCL_GBI_printLastError(void);

[Argument]

　　　None

[Return value]

　　　None

C.5.1.6 Outputting the Detailed Error Information History (Non-disclosure)

Outputs the detailed information of the last 16 errors (maximum), which occurred when the System bus access libraries returned BCL GBI ERROR, to the standard output stream.

[Name]

BCL_GBI_printPreviousErrors

[Syntax]

void BCL_GBI_printPreviousErrors(void);

[Argument]

None

[Return value]

None

C.5.1.7 Debug Mode Control (Non-disclosure)

Controls the debug mode implemented for the access library.

[Name]

BCL_GBI_verbose

[Syntax]

void BCL_GBI_verbose(int val);

[Argument]

val    Debug mode specification

[Return value]

None

C.5.1.8 Trace Function Enable (Non-disclosure)

Enables the trace function of the access library. When the trace function is enabled, it becomes possible to trace the bus access and the functions. The bus access tracing allows the accessed address and data and read/write identification to be indicated in the standard output stream. The function tracing allows the executed function names to be indicated in the standard output stream. Any function can be registered as a function that executes tracing and replaced for a previously registered function.

The access library contains the following functions that execute bus access tracing:

```
BCL_GBI_write
BCL_GBI_read
BCL_GBI_writeBlock
BCL_GBI_readBlock
BCL_GBI_writeSeq
BCL_GBI_readSeq
BCL_GBI_writeSyncDMA
BCL_GBI_readSyncDMA
BCL_GBI_writeAsyncDMA
BCL_GBI_readAsyncDMA
BCL_GBI_writeConfig
BCL_GBI_readConfig
```

The access library contains the following functions that execute function tracing:

```
BCL_GBI_waitFlushFIFO
BCL_GBI_waitDMA
BCL_GBI_cancelDMA
BCL_GBI_conditionDMA
BCL_GBI_syncCount
BCL_GBI_resetModule
```

[Name]

    BCL_GBI_ioTraceEnable

[Syntax]

    int BCL_GBI_ioTraceEnable(void);

[Argument]

    None

[Return value]

| | |
|---|---|
| BCL_GBI_OK | Normal termination |
| BCL_GBI_ERROR | Error |

C.5.1.9 Trace Function Disable (Non-disclosure)

Disables the trace function of the access library. When the trace function is disabled, it becomes impossible to trace the bus access and the functions.

[Name]

    BCL_GBI_ioTraceDisable

[Syntax]

    int BCL_GBI_ioTraceDisable(void);

[Argument]

    None

[Return value]

| | |
|---|---|
| BCL_GBI_OK | Normal termination |
| BCL_GBI_ERROR | Error |

C.5.1.10 Address Filter Specification for the Trace Function (Non-disclosure)

Specifies the address filter for bus access tracing. A single address or continuous addresses can be specified for filtering, depending on the filter mode. Up to 16 address specifications are allowed. When the trace function is enabled, only the addresses that match any of the address specifications are traced.

[Name]

    BCL_GBI_ioTraceAddress

[Syntax]

```
int BCL_GBI_ioTraceAddress(int mode, ...);
int BCL_GBI_ioTraceAddress(0);
int BCL_GBI_ioTraceAddress(1, addr);
int BCL_GBI_ioTraceAddress(2, start_addr, stop_addr);
```

[Argument]

mode Specifies any of the following filter modes:

0: Filter specification is cancelled.
1: Single address specification
2: Continuous address specification

addr        Target address at the time of single address specification
start_addr  Start address at the time of continuous address specification
stop_addr   End address at the time of continuous address specification

[Return value]

BCL_GBI_OK        Normal termination
BCL_GBI_ERROR     Error

C.5.1.11 Output of Information Set for the Trace Function (Non-disclosure)

Outputs the information currently set for the trace function to the standard output stream. Use this function to check whether the trace function is enabled or disabled or to check the settings of the address filter.

[Name]

BCL_GBI_ioTraceShow

[Syntax]

```
int BCL_GBI_ioTraceShow(void);
```

[Argument]

None

[Return value]

None

C.5.1.12 Simplified Help Information Output for the Trace Function (Non-disclosure)

Outputs the simplified help information of the trace function to the standard output stream.

[Name]

BCL_GBI_ioTraceHelp

[Syntax]

```
int BCL_GBI_ioTraceHelp(void);
```

[Argument]

None

[Return value]

> None

C.5.1.13 Trace Function Registration (Non-disclosure)

Replaces a default trace function that executes the tracing with another trace function. When the trace function is enabled, the registered trace function is executed from the access library function to be traced immediately after registration. Only one function can be registered. If an attempt is made to register a function when one is already registered, the previously registered function is overwritten. Execute the BCL_GBI_ioTraceResetHandler function to reset the trace function to the default.
The access library contains the following functions that execute tracing:

    BCL_GBI_write
    BCL_GBI_read
    BCL GBI_writeBlock
    BCL_GBI_readBlock
    BCL_GBI_writeSeq
    BCL_GBI_readSeq
    BCL_GBI_writeSyncDMA
    BCL_GBI_readSyncDMA
    BCL_GBI_writeAsyncDMA
    BCL_GBI_readAsyncDMA
    BCL_GBI_writeConfig
    BCL_GBI_readConfig
    BCL_GBI_waitFlushFIFO
    BCL_GBI_waitDMA
    BCL_GBI_cancelDMA
    BCL_GBI_conditionDMA
    BCL_GBI_syncCount
    BCL_GBI_resetModule
    [Name]

> BCL_GBI_ioTraceHandler

[Syntax]

> void BCL_GBI_ioTraceHandler(BCL_GBI_TRACE_HANDLER handler, void *arg);

[Argument]

    handler    Call back function address
    arg        Value to be given to trace handler

[Return value]

> None

C.S.1.14 Default Trace Function Registration (Non-disclosure)

Resets a trace function replaced by the BCL_GBI_ioTraceHandler function to the default.

[Name]

> BCL_GBI_ioTraceResetHandler

[Syntax]

void BCL_GBI_ioTraceResetHandler(void);

[Argument]

None

[Return value]

None

C.5.1.15 Default Trace Function Execution (Non-disclosure)

Executes the default trace function from a trace function registered by the BCL_GBI_ioTraceHandler function.

[Name]

BCL_GBI_ioTraceExecuteDefaultHandler

[Syntax]

void BCL_GBI_ioTraceExecuteDefaultHandler(int cmd, unsigned int address, int data, void *arg);

[Argument]

cmd         Function to be traced
address     Address to be traced
data        Data to be traced
arg         Argument that was given to trace handler

[Return value]

None

Industrial applicability

As described above, according to the present invention, there is provided the test emulator, the test module emulator, and the record medium storing the programs for emulating appropriately the test apparatus which is used with various modules.

**Claims**

1. A test emulator (190) for emulating a test apparatus (10) comprising a plurality of test modules (170) for supplying a test signal to devices under test (180) respectively, comprising:

   a plurality of test module emulation sections (270) for emulating the plurality of test module (170) generating the test signal based on different cycles;
   a control emulation section (230) for emulating a control apparatus (130) for controlling the test of the devices under test (100); and
   a synchronous emulation section (250) for generating test signal generating timings, at which each of said plurality of test module emulation sections (270) is to generate the test signal in simulation corresponding to cycle time of said test module emulation section (270), based on instructions from said control emulation section (230);

   **characterized by**
   a timing alignment section (276) for aligning the plurality of test signal generating timings generated by said synchronous emulation section (250) in order of time, and outputting them one by one; and
   a schedule section (277) for causing said test module emulation section (270) corresponding to one of the test signal generating timings output by said timing alignment section (276) to generate the test signal in simulation in the cycle time corresponding to the test signal generating timing.

2. The test emulator as claimed in-claim 1, further comprising a device under test simulating section (200) for simulating operation of a device under test (100) based on the test signal generated in simulation.

3. The test emulator as claimed in claim 1, wherein
said synchronous emulation section (250) further generates interruption collection timings for collecting interruption to the control apparatus (130) generated in simulation by each of said plurality of test module emulation sections (270) during the generation of the test signal in the cycle time corresponding to the test signal generating timings,
said timing alignment section (276) aligns the plurality of test signal generating timings and the plurality of interruption collection timings in order of time, and outputs them one by one, and
said schedule section (277) causes said test module emulation section (270) corresponding to the interruption collection timing to notify said control emulation section (230) of the interruption generated in simulation in the cycle time at which said test module emulation section (270) generates the test signal just before the interruption collection timing, in case that said timing alignment section (276) outputs one of the interruption collection timings.

4. The test emulator as claimed in claim 1, wherein
each of said plurality of test module emulation sections (270) generates change timing of the test signal in the cycle time at the generation of the test signal in the cycle time corresponding to the test signal generating timing, and
the test emulator (190) further comprises a DUT connection section (280) for acquiring the plurality of change timings generated by said plurality of test module emulation section (270), and for changing the test signal in simulation one by one in order of time based on the plurality of change timings.

5. The test emulator as claimed in claim 4, wherein
said DUT connection section (280) supplies the plurality of change timings acquired from said plurality of test module emulation sections (270) to said timing alignment section (276),
said timing alignment section (276) aligns the plurality of change timings, the plurality of test signal generating timings, and the plurality of interruption collection timings in order of time, and outputs them one by one, and
said schedule section (277) causes said DUT connection section (280) to change the test signal in simulation at the change timing, in case that said timing alignment section (276) outputs one of the change timings.

6. The test emulator as claimed in claim 1, wherein
each of said plurality of said test module emulation sections (270) notifies said synchronous emulation section (250) of the cycle end timing at which the cycle time ends during the generation of the test signal in the cycle time corresponding to the test signal generating timing, and
said synchronous emulation section (250) generates the test signal generating timings at which said test module emulation section (270) generates the test signal in simulation corresponding to next cycle time based on the cycle end timing notified from each of said plurality of test module emulation section (270).

7. The test emulator as claimed in claim 6, wherein said schedule section (277) causes the interruption generated in simulation by said test module emulation section (270) corresponding to the test signal generating timing to be notified to said control emulation section (230) during the generation of the test signal in the cycle time just before the test signal generating timing, in case that said timing alignment section (276) outputs the test signal generating timing corresponding to the next cycle time.

8. The test emulator as claimed in claim 1, wherein
each of said plurality of test module emulation sections (270) is realized by operating test module emulation program corresponding to said test module emulation section (270) by a computer, and the test module emulation program comprises:

a plurality of hardware emulation functions, being provided corresponding to a plurality of commands received by the test module (170) from said control apparatus (130) respectively, for emulating operation of the test module (170) corresponding to the command; and
a control function used in order for said schedule section (277) to cause the test emulator (190) to generate the test signal in the cycle time corresponding to the test signal generating timing.

9. A recording medium storing therein a program for causing a computer to function as a test emulator as claimed in

EP 1 610 136 B1

claim 1.

**Patentansprüche**

1. Prüfemulator (190) zum Emulieren einer Prüfvorrichtung (10), die mehrere Prüfmodul (170) zum jeweiligen Zuführen eines Prüfsignals zu geprüften Vorrichtungen (100) aufweist, welcher aufweist:

mehrere Prüfmodul-Emulationsschaltungen (270) zum Emulieren der mehreren Prüfmodule (170), die das Prüfsignal auf der Grundlage verschiedener Zyklen erzeugen;
eine Steueremulationsschaltung (230) zum Emulieren einer Steuervorrichtung (130) zum Steuern der Prüfung der geprüften Vorrichtungen (100); und
eine synchrone Emulationsschaltung (250) zum Erzeugen von Prüfsignal-Erzeugungszeitpunkten, zu denen jede der mehreren Prüfmodul-Emulationsschaltungen (270) das Prüfsignal in einer Simulation entsprechend der Zykluszeit der Prüfmodul-Emulationsschaltung (270) erzeugen soll auf der Grundlage von Befehlen von der Steueremulationsschaltung (230);

**gekennzeichnet durch**
eine Zeitausrichtungsschaltung (276) zum Ausrichten der mehreren Prüfsignal-Erzeugungszeitpunkte, die von der synchronen Emulationsschaltung (250) erzeugt wurden, in zeitlicher Reihenfolge, und Ausgeben von diesen nacheinander; und
eine Ablaufschaltung (277) zum Bewirken, dass die Prüfmodul-Emulationsschaltung (270) entsprechend einem der von der Zeitausrichtungsschaltung (276) ausgegebenen Prüfsignal-Erzeugungszeitpunkte das Prüfsignal in Simulation in der Zykluszeit entsprechend dem Prüfsignal-Erzeugungszeitpunkt erzeugt.

2. Prüfemulator nach Anspruch 1, weiterhin aufweisend eine Simulationsschaltung (200) für eine geprüfte Vorrichtung zum Simulieren der Operation einer geprüften Vorrichtung (100) auf der Grundlage des simuliert erzeugten Prüfsignals.

3. Prüfemulator nach Anspruch 1, bei dem
die synchrone Emulationsschaltung (250) weiterhin Unterbrechungssammlungs-Zeitpunkte zum Sammeln von Unterbrechungen zu der simuliert durch jede der mehreren Prüfmodul-Emulationsschaltungen (270) erzeugten Steuervorrichtung (130) erzeugt während der Erzeugung des Prüfsignals in der Zykluszeit entsprechend den Prüfsignal-Erzeugungszeitpunkten,
welche Zeitausrichtungsschaltung (276) die mehreren Prüfsignal-Erzeugungszeitpunkte und die mehreren Unterbrechungssammlungs-Zeitpunkte in zeitlicher Reihenfolge ausrichtet und sie nacheinander ausgibt, und
die Ablaufschaltung (277) bewirkt, dass die Prüfmodul-Emulationsschaltung (270) entsprechend dem Unterbrechungssammlungs-Zeitpunkt der Steueremulationsschaltung (230) von der in der Zykluszeit, in der die Prüfmodul-Emulationsschaltung (270) das Prüfsignal direkt vor dem Unterbrechungssammlungs-Zeitpunkt erzeugt, simuliert erzeugten Unterbrechung unterrichtet, für den Fall, dass die Zeitausrichtungsschaltung (276) einen der Unterbrechungssammlungs-Zeitpunkte ausgibt.

4. Prüfemulator nach Anspruch 1, bei dem
jede der mehreren Prüfmodul-Emulationsschaltungen (270) Änderungszeitpunkte des Prüfsignals in der Zykluszeit bei der Erzeugung des Prüfsignals in der Zykluszeit entsprechend dem Prüfsignal-Erzeugungszeitpunkt erzeugt, und
der Prüfemulator (190) weiterhin eine DUT-Verbindungsschaltung 280) zum Erwerben der mehreren Änderungszeitpunkte, die von den mehreren Prüfmodul-Emulationsschaltungen (270) erzeugt wurden, und zum simulierten Ändern des Prüfsignals nacheinander in zeitlicher Reihenfolge auf der Grundlage der mehreren Änderungszeitpunkte aufweist.

5. Prüfemulator nach Anspruch 4, bei dem
die DUT-Verbindungsschaltung (280) die mehreren Änderungszeitpunkte, die von den mehreren Prüfmodul-Emulationsschaltungen (270) erworben wurden, zu der Zeitausrichtungsschaltung (276) liefert,
die Zeitausrichtungsschaltung (276) die mehreren Änderungszeitpunkte, die mehreren Prüfsignal-Erzeugungszeiten und die mehreren Unterbrechungssammlungs-Zeitpunkte in zeitlicher Reihenfolge ausrichtet und sie nacheinander ausgibt, und
die Ablaufschaltung (277) bewirkt, dass die DUT-Verbindungsschaltung (280) das Prüfsignal zu dem Änderungszeitpunkt simuliert ändert, für den Fall, dass die Zeitausrichtungsschaltung (276) einen der Änderungszeitpunkte ausgibt.

6. Prüfemulator nach Anspruch 1, bei dem
jede der mehreren Prüfmodul-Emulationsschaltungen (270) die synchrone Emulationsschaltung (250) von der Zyklusendzeit unterrichtet, zu der die Zykluszeit während der Erzeugung des Prüfsignals in der Zykluszeit entsprechend dem Prüfsignal-Erzeugungszeitpunkt endet, und
die synchrone Emulationsschaltung (250) die Prüfsignal-Erzeugungszeitpunkte erzeugt, zu denen die Prüfmodul-Emulationsschaltung (270) das Prüfsignal entsprechend der nächsten Zykluszeit simuliert erzeugt auf der Grundlage der von jeder der mehreren Prüfmodul-Emulationsschaltungen (270) mitgeteilten Zyklusendzeit.

7. Prüfemulator nach Anspruch 6, bei dem die Ablaufschaltung (277) bewirkt, dass die von der Prüfmodul-Emulationsschaltung (270) entsprechend dem Prüfsignal-Erzeugungszeitpunkt simuliert erzeugte Unterbrechung der Steueremulationsschaltung (230) während der Erzeugung des Prüfsignals in der Zykluszeit direkt vor dem Prüfsignal-Erzeugungszeitpunkt mitgeteilt wird für den Fall, dass die Zeitausrichtungsschaltung (276) den Prüfsignal-Erzeugungszeitpunkt entsprechend der nächsten Zykluszeit ausgibt.

8. Prüfemulator nach Anspruch 1, bei dem
jede der mehreren Prüfmodul-Emulationsschaltungen (270) realisiert ist durch Betätigen eines Prüfmodul-Emulationsprogramms entsprechend der Prüfmodul-Emulationsschaltung (270) mittels eines Computers, wobei das Prüfmodul-Emulationsprogramm aufweist:

mehrere Hardware-Emulationsfunktionen, die entsprechend mehreren Befehlen vorgesehen sind, die jeweils durch das Prüfmodul (170) von der Steuervorrichtung (130) empfangen sind, zum Emulieren der Operation des Prüfmoduls (170) entsprechend dem Befehl, und
eine Steuerfunktion, die verwendet wird, damit die Ablaufschaltung (277) bewirkt, dass der Prüfemulator (190) das Prüfsignal in der Zykluszeit entsprechend dem Prüfsignal-Erzeugungszeitpunkt erzeugt.

9. Aufzeichnungsmedium, das ein Programm speichert, das bewirkt, dass ein Computer als ein Prüfemulator nach Anspruch 1 funktioniert.

## Revendications

1. Emulateur d'essai (190) pour émuler un appareil d'essai (10) comprenant une pluralité de modules d'essai (170) pour délivrer un signal d'essai à des dispositifs en essai (100), respectivement, comprenant :

une pluralité de sections d'émulation de module d'essai (270) pour émuler la pluralité de modules d'essai (170) générant le signal d'essai basé sur différents cycles;
une section d'émulation de commande (230) pour émuler un appareil de commande (130) pour commander l'essai de dispositifs en essai (100) ; et
une section d'émulation synchrone (250) pour générer des instants de génération de signal d'essai, auxquels chacune de ladite pluralité des sections d'émulation de module d'essai (270) doit générer le signal d'essai en simulation correspondant au temps de cycle de ladite section d'émulation de module d'essai (270), en se basant sur des instructions provenant de ladite section d'émulation de commande (230) ;

caractérisé par
une section d'alignement des temps (276) pour aligner la pluralité d'instants de génération de signal d'essai générés par ladite section d'émulation synchrone (250), par ordre de temps, et les délivrer en sortie un par un ; et
une section de planification (277) pour entraîner que ladite section d'émulation de module d'essai (270) correspondant à un des instants de génération de signal d'essai délivré en sortie par ladite section d'alignement des temps (276) génère le signal d'essai en simulation dans le temps de cycle correspondant à l'instant de génération de signal d'essai.

2. Emulateur d'essai tel que revendiqué dans la revendication 1, comprenant en outre une section de simulation de dispositif en essai (200) pour simuler le fonctionnement du dispositif en essai (100) en se basant sur le signal d'essai généré en simulation.

3. Emulateur d'essai tel que revendiqué dans la revendication 1, dans lequel :

ladite section d'émulation synchrone (250) génère en outre des instants de collecte d'interruption pour collecter des interruptions au niveau de l'appareil de commande (130), générés en simulation par chacune de ladite pluralité de sections d'émulation de module d'essai (270) au cours de la génération du signal d'essai dans le temps de cycle correspondant aux instants de génération de signal d'essai,

ladite section d'alignement des temps (276) aligne la pluralité d'instants de génération de signal d'essai et la pluralité d'instants de collecte d'interruption par ordre de temps, et les délivre en sortie un par un, et

ladite section de planification (277) entraîne que ladite section d'émulation de module d'essai (270) correspondant à l'instant de collecte d'interruption notifie ladite section (230) d'émulation de commande de l'interruption générée en simulation dans le temps de cycle auquel ladite section d'émulation de module d'essai (270) génère le signal d'essai juste avant l'instant de collecte d'interruption, dans le cas où ladite section d'alignement des temps (276) délivre en sortie un des instants de collecte d'interruption.

4.  Emulateur d'essai tel que revendiqué dans la revendication 1, dans lequel :

chacune de ladite pluralité de sections d'émulation de module d'essai (270) génère un instant de changement du signal d'essai dans le temps de cycle à la génération du signal d'essai dans le temps de cycle correspondant à l'instant de génération de signal d'essai, et l'émulateur d'essai (190) comprend en outre une section de connexion DUT (280) pour acquérir la pluralité des instants de changement générés par ladite pluralité de sections d'émulation de module d'essai (270), et pour changer le signal d'essai en simulation un par un, par ordre de temps, en se basant sur la pluralité d'instants de changement.

5.  Emulateur d'essai tel que revendiqué dans la revendication 4, dans lequel :

ladite section de connexion DUT (280) délivre la pluralité d'instants de changement, acquis depuis la pluralité de sections d'émulation de module d'essai (270), à ladite section d'alignement des temps (276),

ladite section d'alignement des temps (276) aligne la pluralité d'instants de changement, la pluralité d'instants de génération de signal d'essai, et la pluralité d'instants de collecte d'interruption, par ordre de temps, et les délivre en sortie un par un, et

ladite section de planification (277) entraîne que ladite section de connexion DUT (280) change le signal d'essai en simulation à l'instant de changement, dans le cas où ladite section d'alignement des temps (276) délivre en sortie un des instants de changement.

6.  Emulateur d'essai tel que revendiqué dans la revendication 1, dans lequel :

chacune de la pluralité desdites sections d'émulation de module d'essai (270) notifie à ladite section d'émulation de synchronisation (250) l'instant de fin de cycle auquel le temps de cycle s'achève au cours de la génération du signal d'essai dans le temps de cycle correspondant à l'instant de génération du signal d'essai, et

ladite section d'émulation synchrone (250) génère les instants de génération de signal d'essai auxquels ladite section d'émulation de module d'essai (270) génère le signal d'essai en simulation correspondant au temps de cycle suivant en se basant sur l'instant de fin de cycle notifié depuis chacune de ladite pluralité de sections d'émulation de module d'essai (270).

7.  Emulateur d'essai tel que revendiqué dans la revendication 6, dans lequel ladite section de planification (277) entraîne que l'interruption générée en simulation par ladite section d'émulation de module d'essai (270) correspondant à l'instant de génération de signal d'essai, notifie ladite section d'émulation de commande (230) au cours de la génération du signal d'essai dans le temps de cycle juste avant l'instant de génération de signal d'essai, dans le cas où ladite section d'alignement des temps (276) délivre en sortie l'instant de génération de signal d'essai correspondant au temps de cycle suivant.

8.  Emulateur d'essai tel que revendiqué dans la revendication 1, dans lequel :

chacune de ladite pluralité de sections d'émulation de module d'essai (270) est réalisée en exécutant un programme d'émulation de module d'essai correspondant à ladite section d'émulation de module d'essai (270) à l'aide d'un ordinateur, et le programme d'émulation de module d'essai comprend :

une pluralité de fonctions d'émulation matérielle qui sont proposées et qui correspondent à une pluralité de commandes reçues par le module d'essai (170) à partir dudit appareil de commande (130), respectivement, pour émuler le fonctionnement du module d'essai (170) correspondant à la commande ; et

une fonction de commande utilisée de manière à ce que ladite section de programmation (277) entraîne que l'émulateur d'essai (190) génère le signal d'essai dans le temps de cycle correspondant à l'instant de génération de signal d'essai.

9. Support d'enregistrement stockant un programme pour entraîner qu'un ordinateur fonctionne comme un émulateur d'essai, tel que revendiqué dans la revendication 1.

*FIG. 1*

EP 1 610 136 B1

FIG. 2

EP 1 610 136 B1

*FIG. 3*

FIG. 4

500

FIG. 5

```
                        ( START )
                            │
                            ▼
┌──────────────────────────────────────────────────────┐
│ SCHED→SYNC: TEST SIGNAL GENERATING TIMING NOTIFICATION │──S600
└──────────────────────────────────────────────────────┘
                            │
                            ▼
┌──────────────────────────────────────────────────────┐
│ SYNC→SCHED→TM: CYCLE START NOTIFICATION                │──S605
└──────────────────────────────────────────────────────┘
                            │
                            ▼
┌──────────────────────────────────────────────────────┐
│ TM→LB: GENERATION OF TEST SIGNAL OF CYCLE TIME         │──S610
└──────────────────────────────────────────────────────┘
                            │
                            ▼
┌──────────────────────────────────────────────────────┐
│ LB→SCHED: REGISTRATION OF CHANGE TIMING OF TEST SIGNAL │──S615
└──────────────────────────────────────────────────────┘
                            │
                            ▼
┌──────────────────────────────────────────────────────┐
│ TM→SYNC: NOTIFICATION OF CYCLE END TIMING              │──S620
└──────────────────────────────────────────────────────┘
                            │
                            ▼
┌──────────────────────────────────────────────────────┐
│ SYNC→SCHED: REGISTRATION OF                            │
│             NEXT TEST SIGNAL GENERATING TIMING         │
│             TEST RESULT COLLECTION TIMING              │──S625
│             CYCLE TERMINATION TIMING                   │
│             INTERRUPTION COLLECTION TIMING             │
└──────────────────────────────────────────────────────┘
                            │
                            ▼
┌──────────────────────────────────────────────────────┐
│ SCHED→LB: CHANGE TIMING NOTIFICATION                   │──S630
└──────────────────────────────────────────────────────┘
                            │
                            ▼
┌──────────────────────────────────────────────────────┐
│ LB→DUT→LB→TM: TEST SIGNAL GENERATION,                  │──S635
│               RESULT SIGNAL ACQUISITION               │
└──────────────────────────────────────────────────────┘
                            │
                            ▼
┌──────────────────────────────────────────────────────┐
│ SCHED→TM: NOTIFICATION OF TEST RESULT COLLECTION TIMING│──S640
└──────────────────────────────────────────────────────┘
                            │
                            ▼
┌──────────────────────────────────────────────────────┐
│ TM↔SYNC: TEST RESULT COLLECTION & DISTRIBUTION         │──S645
└──────────────────────────────────────────────────────┘
                            │
                            ▼
┌──────────────────────────────────────────────────────┐
│ SCHED→TM: NOTIFICATION OF CYCLE END TIMING             │──S650
└──────────────────────────────────────────────────────┘
                            │
                            ▼
┌──────────────────────────────────────────────────────┐
│ SCHED→TM: NOTIFICATION OF INTERRUPTION COLLECTION TIMING│──S655
└──────────────────────────────────────────────────────┘
                            │
                            ▼
                     ╱ FINISHED? ╲───── No
                     ╲           ╱   ╲─S660
                          │ Yes
                          ▼
                      ( END )
```

## FIG. 6

*FIG. 7*

200

2226    2225    2224

2222
2230

| TOOLS | TOOLS | FRAMEWORK CLASSES |

STANDARD INTERFACES

SYSC ← → SITEC COMMUNICATION LIBRARY

USER TEST PLAN

2243
2244
2245

USER TEST CLASSES

STANDARD TEST CLASSES    FRAMEWORK CLASSES

STANDARD INTERFACES    MODULE LEVEL INTERFACES

MODULE COMMANDS IMPLEMENTATION

BACKPLANE COMMUNICATIONS LIBRARY

PCI BACKPLANE DRIVER

SYSTEM CONTROLLER — 2220

SITE CONTROLLER — 2240

2242
2246

2247
2248
2249
2250

2282
2283
2284
2285

2280

2286

2287
2288
2293
2281

MODULE EMULATION IN SW

SIMULATION FRAMEWORK

| BACKPLANE EMULATION | HW BACKPLANE |
| BACKPLANE SIMULATION IF | CHASSIS SLOT IF |
| MODULE EMULATION | MODULE HARDWARE |
| LOADBOARD SIMULATION IF | LOADBOARD HARDWARE IF |
| LOADBOARD SIMULATION | HARDWARE LOADBOARD |
| DUT SIMULATION IF | |
| VERILOG PLI | C/C++ | DUT |
| DUT VERILOG MODEL | DUT C/C++ MODEL | |

MODULES — 2260

2261
2262
2263
2264

2265
2266
2289

2291

KEY

2290 — INTERFACE    2296 — MODULE DEVELOPMENT

2292 — USER    2298 — EXTERNAL

2294 — SYSTEM

*FIG. 8*

Instance1

Data for
Instance 1

TestTypeX

Instance2

Data for
Instance 2

Instance3

Data for
Instance 3

*FIG. 9*

FIG. 10

EP 1 610 136 B1

2608

<<interface>>
IMsgHandler
+handleMessage()

*

2610

<<interface>>
ITest
+preExec()
+execute()
+postExec()
+getStatus()
+getName()

2604

FunctionalTestMsgHandler
−m_id:unsigned long long(idl)
+handleMessage()
#handleGetNameMsg()
#handleGetStatusMsg()
#handleRunTestMsg()
#handleNameMsg()
#handleTestStatusMsg()
#handleTestCompleteMsg()

2602

CmdDispatcher

1

2606

FunctionalTest

+preExec()
+execute()
+postExec()
+getStatus()
+getName()

1

1

1

1

FIG. 11

FIG. 12

*FIG. 13*

5000

```
Global
{
    InitVoltage 0.5 V;         # Required. Initial voltage on all
                               # wires.
    RecoveryRate 2.5 V/nS;     # Optional. For drive conflict in
                               # analog signals.
}
```

5010

```
# Module Emulator.
EMUModule "module1"           # Module DLL.
{

    Waveform                   # Optional. Resource declaration.
    {
        Step 1-32, 35;         # Step type waveforms on channels 1 thru 32
                               # channel 35.
        Analog 33, 34;         # Analog waveform on channels 33 and 34.
    }
    Port 1                     # Declares the GBUS Port for this module.
    {
        SerialNumber 1;        # Required. Should match setting in
                               # Module Configuration File.
        ProductRevision 1;     # Required. Should match setting in
                               # Module Configuration File.
        Params                 # To be passed to DLL.
        {
            test  "param1";
            key   "abc";
        }
    }
    Port 8
    {
        LogicalPort 3;         # Optional. Designate Logical Port to use
                               # in offline configuration file.
                               # Default is the GBUS port.

        SerialNumber 2;
        ProductRevision 1;
        Params                 # To be passed to DLL.
        {
            test  "param1";
            key   "abc";
        }
    }
}
```

5020

## FIG. 14

5000

```
# Module Emulator
EMUModule "module2"
{
  Waveform
  {
    Step 1-32;
  }
  Port 2
  {
    SerialNumber 1;
    ProductRevision 1;
  }
}
```

5020

```
# Module Emulator
EMUModule "dps"
{
  Waveform
  {
    Slew 1-32 @ 2.0 V / nS;  # The slew rate is required
                             # for all slewing waveforms.
  }
  Port 4
  {
    SerialNumber 1;
    ProductRevision 1;
  }
}
```

5010

*FIG. 15*

5100

```
Global
{
  RegSelect "PatTraceSel";   # Pattern Tracing - Name of OASIS
                             # Simulated Register Selection File.
}
```

5110

```
DUTModel "DUT1Sim"
{
  Waveform
  {
    Step 1-32;
  }
  DUT 1
  {
    Params
    {
      param1Name   "param1Value";
      param2Name   "param2Value";
    }
    PinConnections
    {
      L3.1     1     1.0 nS;
      L3.2     8     1.0 nS;
      L3.3     2     1.0 nS;
      L3.4     7     1.0 nS;
      L3.5     3     1.0 nS;
      L3.6     6     1.0 nS;
      L3.7     4     1.0 nS;
      L3.8     5     1.0 nS;
      L3.9     9     1.0 nS;
      L3.10    16    1.0 nS;
      L3.11    10    1.0 nS;
      L3.12    15    1.0 nS;
      L3.13    11    1.0 nS;
      L3.14    14    1.0 nS;
      L3.15    12    1.0 nS;
      L3.16    13    1.0 nS;
    }
  }
}
```

5120

*FIG. 16*

```
DUTModel "DUT2Sim"
{
  Waveform
  {
    Slew 1-16 @ 2.0 V/nS;
  }
  DUT 2
  {
    Params
    {
      param1Name  "param1Value";
      param2Name  "param2Value";
    }
    PinConnections
    {
      L2.1    1;    # no delay specified means a delay of 0
      L2.2    2;
      L2.3    3;
      L2.4    4;
      L2.12   5;
      L2.13   6;
      L2.14   7;
      L2.15   8;
    }
  }
}
```

*FIG. 17*

5200

```
                        SimComponent
-m_time:Time=0
-m_slot:unsigned int
#m_engine:SimEngine*
+createDomain():SimEvent::Domain_t
+registerDomain(in domain:SimEvent::Domain_t, in chan_id:const SimChanID&)
+releaseDomain(in domain:SimEvent::Domain_t, in chan_id:const SimChanID&)
+getDomain(in domain:SimEvent::Domain_t):SimDomain
+registerEvent(in event:const SimEvent&)
+registerEvent(in event:const SimEvent&, in t:const Time&)
+raiseEvent(in event:const SimEvent&)
```

```
                        ThirdPartyModule

+getChannel(in chan_id:const SimChanID&):SimChannel*
+initialize()
+setBaseAddress(in index:unsigned int, in base:unsigned int)
+getBaseAddress(in index:unsigned int, out base:unsigned int*)
+getModuleIDs(out vendorID:unsigned int*, out moduleID:unsigned int*)
+setBusNumber(in number:unsigned int)
+clearInterrupt()
+lockInterrupt()
+unlockInterrupt()
+read(in addr:unsigned int, outdata:unsigned int*)
+write(in addr:unsigned int, in data:unsigned int)
+handleEvent(in event:const SimEvent&)
+handleEvent(in event:const SimEvent&, in t:const Time&)
+initEvents()
+initLoadEvents()
```

```
SimComponentStepped


```

```
                        ThirdPartyDUT

+getChannel(in chan_id:const SimChanID&):SimChannel*
+run(in start:const Time&, in end:const Time&)
+handleISVM(in chan_id:const SimChanID&, in i:const Current&):Voltage
+handleVSIM(in chan_id:const SimChanID&, in v:const Voltage&):Current
+handleVSVM(in chan_id:const SimChanID&, in v:const Voltage&):Voltage
```

*FIG. 18*

ThirdPartyModule

+getChannel(in chan_id:const SimChanID&):SimChannel*

<<uses>>

1

<<uses>>

ThirdPartyDUT

+getChannel(in chan_id:const SimChanID&):SimChannel*

1

1..*

SimChannel

+read(in t:const Time&):Voltage
+flush()
+flush(in t:const Time&)
+set(in t:const Time&, in v:const Voltage&)
+off(in t:const Time&)
+off(in t:const Time&, in v:const Voltage&)
+end()
+end(in t:const Time&)
+end(in t:const Time&, in v:const Voltage&)
+isvm(in i:const Current&):Voltage
+vsim(in v:const Voltage&):Current
+vsvm(in v:const Voltage&):Voltage
+getWaveformIter(···):SimWaveformIter

1..*

SimChanID

-m_index:SimChanID::Index_t

+getPort():SimChanID::Index_t
+getIndex():SimChanID::Index_t
+all():bool
+isTesterChannel():bool
+isDUTChannel():bool

<<uses>>

SimWaveformIter

+start()
+end():bool
+next()
+getTime():Time
+getState():SimWaveformIter:State_t

*FIG. 19*

```
                    ┌─────────────────────────────────────────────────┐
                    │                ThirdPartyModule                 │
                    ├─────────────────────────────────────────────────┤
                    ├─────────────────────────────────────────────────┤
                    │ +handleEvent(in event:const SimEvent&)          │
                    │ +handleEvent(in event:const SimEvent&, in t:const Time&) │
                    └─────────────────────────────────────────────────┘
                                          ◆
                                          1
```

```
┌─────────────────────────────────────────────────────────────────────────────────────────────┐
│                                        SimEventMgr                                             │
│                                          1..*                                                  │
├───────────────────────────────────────────────────────────────────────────────────────────────┤
│ -m_domain:unsigned char                                                                       │
│ -m_cspace:SimChanID::ChannelSpace_t                                                            │
│ -m_unitLogicalID:signed long                                                                   │
├───────────────────────────────────────────────────────────────────────────────────────────────┤
│ +SimEventMgr(in domainID::const OFCString&, in unitLogicalID:unsigned long, in cspace:SimChanID::ChannelSpace_t) │
│ +makeReadEvent(in event:SimEvent::LocalCode_t):SimEvent                                        │
│ +makeReadEvent(in chan:SimChanID, in event:SimEvent::LocalCode_t):SimEvent                     │
│ +makeReadDomainEvent(in dmain:DomainID_t, in code:SimEvent::LocalCode_t):SimEvent              │
│ +makeWriteEvent(in event:SimEvent::LocalCode_t):SimEvent                                       │
│ +makeWriteEvent(in chan:SimChanID, in event:SimEvent::LocalCode_t):SimEvent                    │
│ +makeWriteDomainEvent(in domain:DomainID_t, in code:SimEvent::LocalCode_t):SimEvent            │
│ +makeSysEvent(in event:SimEvent::SysCode_t):SimEvent                                           │
│ +makeAsyncEvent(in Sernum:SerialNum_t, in event:SimEvent::LocalCode_t):SimEvent                │
│ +makeDomainEvent(in domain:DomainID_t, in code:SimEvent::LocalCode_t):SimEvent                 │
│ +isMyEvent():bool                                                                              │
└───────────────────────────────────────────────────────────────────────────────────────────────┘
                                          ¦<<uses>>
                                          ∨
```

```
                    ┌─────────────────────────────────────────┐
                    │                SimEvent                 │
                    ├─────────────────────────────────────────┤
                    ├─────────────────────────────────────────┤
                    │ +isSysEvent():bool                      │
                    │ +isAsyncEvent():bool                    │
                    │ +isReadEvent():bool                     │
                    │ +isWriteEvent():bool                    │
                    │ +isDomainEvent():bool                   │
                    │ +isChannelEvent():bool                  │
                    │ +getSerialNumber():SimEvent::SerialNumber_t │
                    │ +getDomain():SimEvent::Domain_t         │
                    │ +getChan():SimChanID                    │
                    │ +getCode():SimEvent::LocalCode_t        │
                    │ +getSysCode():SimEvent::SysCode_t       │
                    │ +numArgs():unsigned int                 │
                    │ +pushArg(in arg:int)                    │
                    │ +popArg():int                           │
                    └─────────────────────────────────────────┘
```

*FIG. 20*

```
#include "OAI/sim/SimComponent.h"
#include "OAI/sim/SimChannel.h"
#include "OAI/sim/SimChanID.h"

#include "OAI/OFC/OFCString.h"

class MyBaseModule : public OASIS::SimComponent
{
public:

  // constructor
  MyBaseModule(unsigned int sernum, unsigned int prodrev,
               unsigned int port);

  // channel access
  OASIS::SimChannel* getChannel(const OASIS::SimChanID& chan_id);

  // do nothing for these initialization steps
  void initialize() { }
  void initLoadEvents() { }

  // ID
  unsigned int getSerialNumber() { return m_sernum; }
  unsigned int getProductRevision() { return m_prodrev; }

  // bus I/0
  void setBaseAddress(unsigned int index, unsigned int base);
  void getBaseAddress(unsigned int index, unsigned int* base);
  void getModuleIDs(unsigned int* vendorID, unsigned int* moduleID);
  void setBusNumber(unsigned int number);
  void clearInterrupt();
  void lockInterrupt();
  void unlockInterrupt();
  ClassCode_t getClassCode();
  void read(unsigned int addr, unsigned int* data);
  void write(unsigned int addr, unsigned int data);

  // pattern tracing features (unimplemented)
  void poll(unsigned int&, Time& t, unsigned int) { }
  void poll(unsigned __int64&, Time& t, unsigned int) { }
  void poll(unsigned double&, Time& t, unsigned int) { }
  void poll(unsigned OFCString&, Time& t, unsigned int) { }

protected:

  // internal types
  typedef unsigned int  port_t;
  typedef unsigned int  reg_t;
  typedef unsigned char vector_t;
  typedef unsigned char vecaddr_t

  // internal data
  OASIS::SimChannel        m_channels[8];
  reg_t                    m_sernum;
  reg_t                    m_prodrev;
  port_t                   m_port;
  reg_t                    m_base;
  reg_t                    m_period;
  reg_t                    m_edges[8];
  reg_t                    m_high;
  reg_t                    m_low;
  vector_t                 m_pattern[100];
  vecaddr_t                m_patPtr;
  OASIS::SimEventMgr       m_evtMgr;
  bool                     m_intrLock;
};
```

## FIG. 21

```
#include "MyBaseModule.h"  // base class header

class MyDriveModule : public MyBaseModule
{
public:

    // constructor
    MyDriveModule(unsigned int sernum, unsigned int prodrev,
                  unsigned int port);

    // access to vendor/module data
    void getModuleIDs(unsigned int* vendorID, unsigned int* moduleID);

    // initialize simulation
    void initEvents();

    // handle events
    void handleEvent(const OASIS::SimEvent& event);
    void handleEvent(const OASIS::SimEvent& event, const OASIS::Time& t);
};
```

*FIG. 22*

```
void MyDriveModule::handleEvent(const OASIS::SimEvent& event,
                                const OASIS::Time& t)
{
  // t is the start of the cycle since that is the time we
  // registered for

  // write the edge into each channel
  for (chanaddr_t c = 0; c < 8; c++)
  {
    // write the edge to the output channel
    m_channels[c].set(t + m_edges[c] * 1.0e-12,
                      (m_pattern[m_patPtr] & 1 << c ? m_high : m_low)
                      * 1.0e-3);

    // terminate the write
    m_channels[c].end(t + m_period * 1.0e-12);
  }

  // register for the next start of cycle
  if (m_patPtr++ < 100)
  {
    registerEvent(m_evtMgr.makeWriteEvent(DRIVE_CYCLE),
                  t + m_period * 1.0e-12);
  }
}
```

## FIG. 23

83

```
#include "MyBaseModule.h"  // base class header

class MyStrobeModule : public MyBaseModule
{
public:

    // constructor
    MyStrobeModule(unsigned int sernum, unsigned int prodrev,
                   unsigned int port);

    // access to vendor/module data
    void getModuleIDs(unsigned int* vendorID, unsigned int* moduleID);

    // bus I/O
    void read(unsigned int addr, unsigned int* data);
    void write(unsigned int addr, unsigned int data);

    // initialize simulation
    void initEvents();

    // handle events
    void handleEvent(const OASIS::SimEvent& event);
    void handleEvent(const OASIS::SimEvent& event, const OASIS::Time& t);

private:

    // internal types
    typedef unsigned char chanaddr_t;

    // fail vector memory
    chanaddr_t m_fcm[10];
    vecaddr_t  m_fvm[10];
    reg_t      m_failCnt;
};
```

## FIG. 24

```
void MyStrobeModule::handleEvent(const OASIS::SimEvent& event,
                                 const OASIS::Time& t)
{
  // t is the end of the cycle since that is the time we
  // registered for

  // compute the start of cycle since all edges are relative to it
  OASIS::Time t0 = t - m_period * 1.0e-12;

  // strobe each channel
  for (chanaddr_t c = 0; c < 8; c++)
  {
    // make sure fail vector memory is not full
    if (m_failCnt == 10)
    {
      return;
    }

    // strobe the input channel
    Voltage v = m_channels[c].read(t0 + m_edges[c] * 1.0e-12);

    // test high
    if (m_pattern[m_patPtr] & 1 << c)
    {
      // fail
      if (v < m_high * 1.0e-3)
      {
        m_fcm[m_failCnt] = c;
        m_fvm[m_failCnt++] = m_patPtr;
      }
    }

    // test low
    else
    {
      // fail
      if (v > m_low * 1.0e-3)
      {
        m_fcm[m_failCnt] = c;
        m_fvm[m_failCnt++] = m_patPtr;
      }
    }

    // terminate the read
    m_channels[i].flush(t);
  }

  // register for the next end of cycle
  if (m_patPtr++ < 100)
  {
    registerEvent(m_evtMgr.makeReadEvent(STROBE_CYCLE),
                  t + m_period * 1.0e-12);
  }
}
```

FIG. 25

```
#include "SimComponentStepped.h"
#include "SimChannel.h"
#include "SimChanID.h"
#include "OASISEngTypes.h" // for Time and Voltage

class MyDUTModel : public OASIS::SimComponentStepped
{
public:

    // constructor
    MyDUTModel(const OASIS::Voltage& vih, const OASIS::Voltage& vil,
              const OASIS::Voltage& voh, const OASIS::Voltage& vol);

    // get channels
    SimChannel* getChannel(const OASIS::SimChanID& chan_id);

    // run method
    void run(const OASIS::Time& t0, const OASIS::Time& tf);

private:

    // channels
    OASIS::SimChannel m_inputs[8];
    OASIS::SimChannel m_outputs[8];

    // levels
    OASIS::Voltage m_vih;
    OASIS::Voltage m_vil;
    OASIS::Voltage m_voh;
    OASIS::Voltage m_vol;
    OASIS::Voltage m_vz;
};
```

*FIG. 26*

```
void MyDUTModel::run(const OASIS::Time& t0, const OASIS::Time& tf)
{
  // loop through each wire
  for (unsigned i = 0; i < 8; i++)
  {
    // loop through all the edges from the input channel
    for (OASIS::SimWaveformIter wf_iter
         = m_inputs[i].getWaveformIter(m_vih, m_vil, t0, tf);
         !wf_iter.end(); wf_iter.next())
    {
      // write edges with 1 nsec delay
      switch (wf_iter.getState())
      {
      case OASIS::SimWaveformIter::H:
        m_outputs[i].set(wf_iter.getTime() + 1.0e-9, m_voh);
      case OASIS::SimWaveformIter::L:
        m_outputs[i].set(wf_iter.getTime() + 1.0e-9, m_vol);
      case OASIS::SimWaveformIter::Z:
        m_outputs[i].set(wf_iter.getTime() + 1.0e-9, m_vz);
      }
    }

    // terminate write for each output channel
    m_outputs[i].end(tf);

    // flush each input channel
    m_inputs[i].flush(tf);
  }
}
```

*FIG. 27*

6000

```
┌─────────────────────────────────────────────────────┐
│ SOFTWARE ON SITE CPU                                 │
│                                                      │
│        ┌──────────────────┐                          │
│        │      HLC         ├─6012                      │
│        ├──────────────────┴────┐                    │ ~6010
│        │ COMMUNICATION LIBRARY  ├─6014                │
│        │  BUS ACCESS LIBRARY    │                     │
│        ├───────────────────────┤                     │
│        │     PCI  DRIVER        ├─6016                │
│        └───────────┬───────────┘                     │
└────────────────────┼─────────────────────────────────┘
┌────────────────────┼─────────────────────────────────┐
│ HARDWARE           │                                  │
│          ┌─────────┴─────────┐                        │
│          │     BUS  I/F       ├─6032                   │
│          └─────────┬─────────┘                         │ ~6030
│          ┌─────────┴─────────┐                        │
│          │    BUS  SWITCH     ├─140                    │
│          └─────────┬─────────┘                         │
│          ┌─────────┴─────────┐                        │
│          │   TESTER MODULE    ├─150, 160, 170          │
│          └───────────────────┘                         │
└────────────────────────────────────────────────────────┘
```

*FIG. 28A*

6050

```
┌─────────────────────────────────────────────────────┐
│ OFFLINE PROCESS ON SITE CPU                          │
│                                                      │
│        ┌──────────────────┐                          │
│        │      HLC         ├─6012                      │ ~6060
│        ├──────────────────┴────┐                    │
│        │ COMMUNICATION LIBRARY  ├─6014                │
│        │  BUS ACCESS LIBRARY    │                     │
│        └───────────┬───────────┘                     │
└────────────────────┼─────────────────────────────────┘
┌────────────────────┼─────────────────────────────────┐
│ TESTER EMULATOR PROCESS                              │
│          ┌─────────┴─────────┐                        │
│          │ SYSTEM BUS EMULATOR├─6084                   │
│          └───────────────────┘                         │ ~6080
│          ┌───────────────────┐                        │
│          │ TESTER MODULE EMULATOR ├─6086               │
│          └───────────────────┘                         │
└────────────────────────────────────────────────────────┘
```

*FIG. 28B*

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 10320229 A
- JP 2000267881 A
- JP 2001051025 A
- JP 2001134457 A
- JP 2002333469 A
- US 449622 P
- US 403817 A

**Non-patent literature cited in the description**

- DYNAMIC TEST EMULATION FOR EDA-BASED MIXED-SIGNAL TEST DEVELOPMENT AUTOMA-TION. **XIA J Q et al.** PROCEEDINGS OF THE IN-TERNATIONAL TEST CONFERENCE (ITC). IEEE, 21 October 1995, 761-770